# EUROPEAN PATENT APPLICATION

(11) **EP 1 553 642 A1**
(43) Date of publication of application: **13.07.2005**
(21) Application number: 03741242.6
(22) Date of filing: 07.07.2003
(51) Int. Cl.: H01L 51/00, H01L 29/786, H01L 45/00, H01L 27/10

(54) **SWITCHING ELEMENT**

(30) Priority: 05.07.2002 JP 2002196734; 05.07.2002 JP 2002196728; 13.09.2002 JP 2002267689; 13.09.2002 JP 2002267688; 18.09.2002 JP 2002271911; 18.09.2002 JP 2002271912; 18.09.2002 JP 2002271910; 18.09.2002 JP 2002271909; 06.11.2002 JP 2002322055; 14.02.2003 JP 2003036684; 14.02.2003 JP 2003036683
(71) Applicant: FUJI ELECTRIC HOLDINGS CO., LTD., Kawasaki-shi, Kanagawa 210-0856 (JP)
(72) Inventor: KAWAKAMI, Haruo c/o FUJI ELECTRIC CO., LTD., Kawasaki-shi, Kanagawa 210-0856 (JP); KURODA, Masami c/o FUJI ELECTRIC CO., LTD., Kawasaki-shi, Kanagawa 210-0856 (JP); KATO, Hisato c/o FUJI ELECTRIC CO., LTD., Kawasaki-shi, Kanagawa 210-0856 (JP); SEKINE, Nobuyuki c/o FUJI ELECTRIC CO., LTD., Kawasaki-shi, Kanagawa 210-0856 (JP); YAMASHIRO, Keisuke, Yokosuka-shi, Kanagawa 240-0194 (JP); IWAMOTO, Takuji, Yokosuka-shi, Kanagawa 240-0194 (JP); KOTANI, Noriko, Yokosuka-shi, Kanagawa 240-0194 (JP)
(74) Representative: Goddar, Heinz J., Dr.
(86) International application number: PCT/JP2003/008599
(87) International publication number: WO 2004/006351

(57) **Abstract**

The present invention provides a switching element in which the compositional deviation of material is suppressed and that attains uniform bistability performance and is suitable for mass production.

In a switching element comprising an organic bistable material, which exhibits two stable states in resistance under applied voltage, arranged between at least two electrodes, the organic bistable material comprises at least a compound having an electron-donating functional group and an electron-accepting functional group in each molecule. It is preferred that, for example, an aminoimidazole type compound, a pyridone type compound, a stilbene type compound or a butadiene type compound be used as the above compound.

## Description

### TECHNICAL FIELD

The present invention relates to a switching element comprising an organic bistable material, the organic bistable material being arranged between two electrodes, which is utilized for a switching element driving of an organic EL display panel, a high-density memory, and the like.

### BACKGROUND ART

In recent years, remarkable progress in characteristics of organic electronic materials has been made. Particularly, since some of low-dimensional conductors, such as charge-transfer complexes, have distinctive properties of being a material such as that with metal-insulator transition, attempts for the applications of them to a switching element driving of an organic EL display panel, a high-density memory, and the like, have been in progress.

As a material applicable to a switching element, an organic bistable material is being paid attention to. The organic bistable material is an organic material that shows a so-called nonlinear response. Namely, when a voltage is applied to the material, at a certain voltage or higher during the application of voltage, a switching phenomenon is observed where the current in a circuit is rapidly increased.

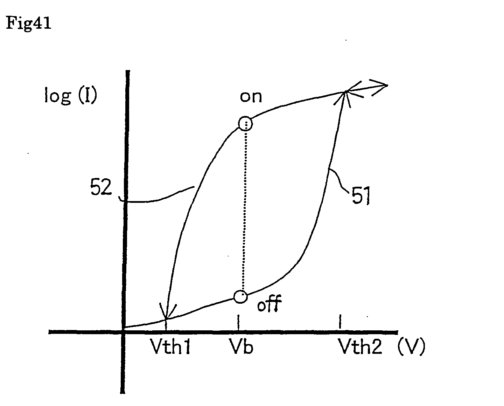

Fig.41 shows an example of the voltage-current characteristics of an organic bistable material showing the above switching behavior.

As shown in Fig.41, the organic bistable material possesses two states in the voltage-current characteristic, where one is a high resistance state 51 (off-state) and the other is a low resistance state 52 (on-state), namely a nonlinear response. In such nonlinear response, when a voltage is made Vth2 or higher while preliminarily applying a bias Vb, transition from off-state to on-state occurs, and when a voltage is made Vth1 or lower, transition from on-state to off-state occurs, where the change of resistance value is given. In other words, by application of a voltage of Vth2 or higher to the organic bistable material, or of a voltage of Vth1 or lower, a so-called switching behavior can be conducted. Here, Vth1 and Vth2 can be applied as a pulse of voltage.

As such organic bistable material showing the nonlinear response, various types of organic complexes are known. For example, R. S. Potember et al. manufactured as a trial experiment a switching element having two stable states in resistance against voltage, using a Cu-TCNQ (copper-tetracyanoquinodimethane) complex (R.S.Potember et al., Appl. Phys. Lett. 34, (1979) 405).

Further, Kumai et al. observed a switching behavior by a nonlinear response, using a single crystal of a K-TCNQ (potassium-tetracyanoquinodimethane) complex (Kumai et al., Solid-state Physics, 35 (2000) 35).

Further, Adachi et al prepared a thin film of Cu-TCNQ complex by a use of a vapor deposition method and confirmed its switching properties, further evaluating the possibility of its application to an organic EL matrix (Adachi et al, preparatory text of Japan Society of Applied Physics, spring of 2002, the third volume, 1236).

Furthermore, L. Ma et al studied that the above organic bistability can be performed even with a one-component material, using an organic material such as an aminoimidazole dicarbonitrile (AIDCN) material or an imine type material (L. Ma et al, Appl. Phys. Lett. 80 (2002) 2997; L. Ma et al, Appl. Phys. Lett. 73 (1998) 850; pamphlet of International Publication No. 02/37500).

However, switching elements using the above organic charge-transfer complexes have the following problems.

Namely, the above-mentioned organic bistable material using a charge-transfer complex is a material with two-component system, being made of a combination of an electron-donating molecule or an electron-donating metal element and an electron-accepting molecule such as TCQN.

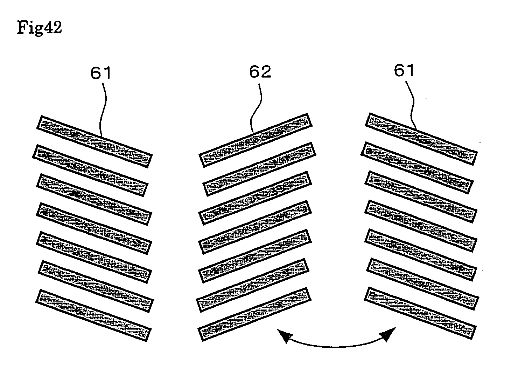

Accordingly, for preparation of the switching element, it was required to strictly control the compositional ratio of two components. Namely, in a charge-transfer complex of such two-component system, for example, as shown in Fig.42, a donating molecule and an accepting molecule are laminated in a column shape, respectively, to form a column 61 of donating molecular and an column 62 of accepting molecular, and respective column composed of molecules (or metal atoms) undergo partial charge-transfer, where characteristic of bistability develops. Accordingly, when the compositional ratio of the two components is excessive or deficient, the characteristic of bistability of whole body is thereby influenced remarkably.

Accordingly, for example, in the above Cu-TCNQ complex, the difference in the compositional ratio of Cu and TCNQ results in the difference in crystallinity and electric properties of the material and causes varying quality of the characteristic of bistability. Particularly, when film formation is carried out by a vapor deposition method or the like, due to the difference in the vapor pressure between both components, it is difficult to form a uniform film of a large area. It is also the case due to the geometrical arrangement or the like, when independent sources for deposition are used in a co-deposition method.

Accordingly, it has been a problem that the above conventional organic bistable materials with two-component system is not straightforwardly applicable to mass-production of switching elements that exhibit unvarying characteristic of bistability and consistent quality.

Further, L. Ma et al. describes that, in order to attain the bistability in an organic material with one-component system, it is an essential to disperse electrically conductive fine particles in an organic film, therefore such organic material with one-component system also has a problem in the insufficient properties of being bistable material.

The present invention has been accomplished in view of the above problems of the conventional techniques, and it is an object of the present invention to provide a switching element suitable for mass production, where the compositional deviation of materials can be suppressed, uniform properties in the characteristic of bistability can be attained, and an organic bistable material by itself can exhibit sufficient bistability.

### DISCLOSURE OF THE INVENTION

Namely, the present invention provides a switching element which comprises: an organic bistable material, the organic bistable material having two stable states in resistance under applied voltage; at least two electrodes, the electrodes being placed such that the organic bistable material is arranged between two of the electrodes, the switching element being characterized in that the organic bistable material comprises at least a compound having an electron-donating functional group and an electron-accepting functional group in a molecule of said compound.

In the switching element of the present invention, since the organic bistable material is of a one-component system having an electron donating functional group and an electron-accepting functional group in one molecule, fluctuation of the compositional ratio at the time of production hardly occurs unlike the conventional two-component system organic bistable material, whereby it is possible to always obtain a constant bistable performance.

Further, when a thin film is formed by particularly a vacuum deposition method, etc., since no complicated techniques such as a co-deposition method are not used, uniform thin films of a large area can be produced with low costs.

In the present invention, the compound is preferably an aminoimidazole type compound of the following formula (A): 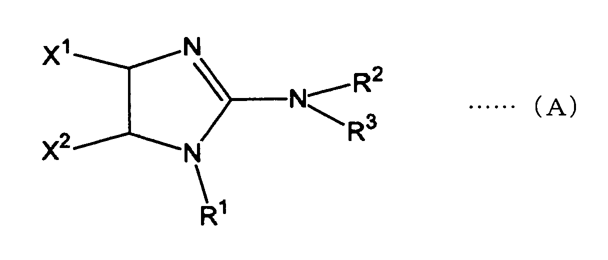 wherein each of X¹ and X² is CN or NO₂, and each of R¹, R² and R³ is a hydrogen atom or a C₁₋₆ alkyl group which may have a substituent.

In the present invention, the compound is preferably a γ-pyridone type compound of the following formula (B): 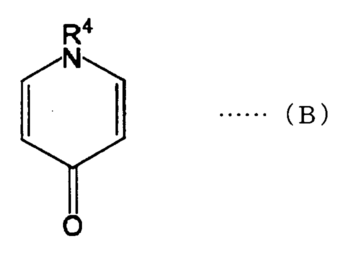 wherein R⁴ is a hydrogen atom or a C₁₋₆ alkyl group which may have a substituent.

In the present invention, the compound is preferably an imine type compound of the following formula (C): 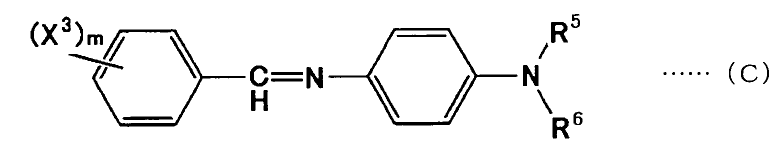 wherein X³ is CN or NO₂, each of R⁵ and R⁶ is a hydrogen atom or a C₁₋₆ alkyl group which may have a substituent, and m is an integer of 1 to 5.

In the present invention, the compound is preferably an imine type compound of the following formula (D): 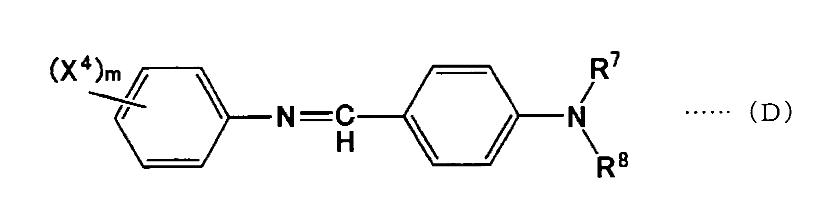 wherein X⁴ is CN or NO₂, each of R⁷ and R⁸ is a hydrogen atom or a C₁₋₆ alkyl group which may have a substituent, and m is an integer of 1 to 5.

In the present invention, the compound is preferably a compound of the following formula (E): 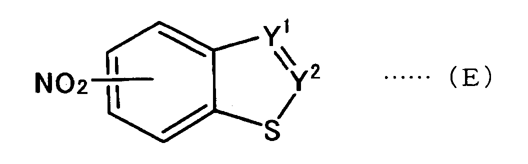 wherein either one of Y¹ and Y² is a nitrogen atom, and another one thereof is a carbon atom which has as a substituent an amino group or a C₁₋₆ alkylamino group.

In the present invention, the compound is preferably a compound of the following formula (F): 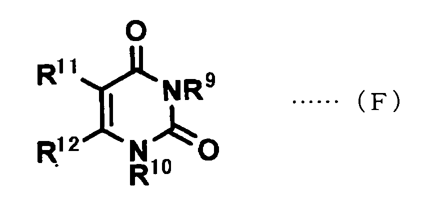 wherein each of R⁹ and R¹⁰ is a hydrogen atom or an alkyl group having at most 2 carbon atoms, and each of R¹¹ and R¹² is a hydrogen atom or an amino group.

In the present invention, the compound is preferably a compound of the following formula (G): 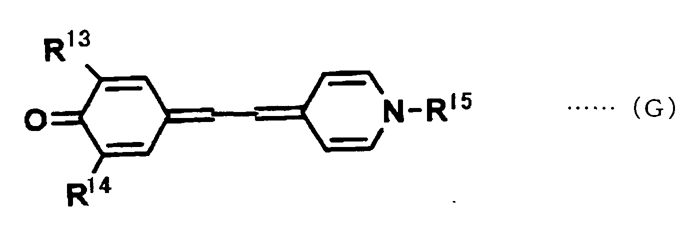 wherein each of R¹³, R¹⁴ and R¹⁵ is a hydrogen atom or a C₁₋₆ alkyl group which may have a substituent.

In the present invention, the compound is preferably an iminequinone type compound of the following formula (H): 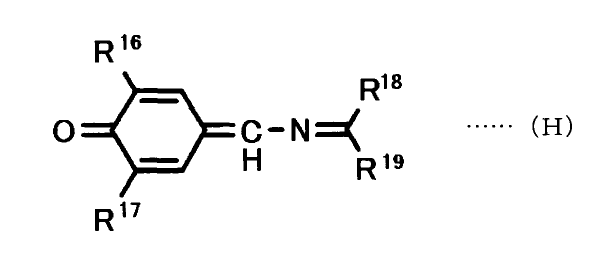 wherein each of R¹⁶ and R¹⁷ is a hydrogen atom or a C₁₋₆ alkyl group which may have a substituent, and each of R¹⁸ and R¹⁹ is an aryl group which may have a substituent, a C₁₋₆ alkyl group which may have a substituent, or a hydrogen atom, provided that at least one of R¹⁸ and R¹⁹ is an aryl group which may have a substituent.

In the present invention, the compound is preferably a quinoneimine compound of the following formula (I): 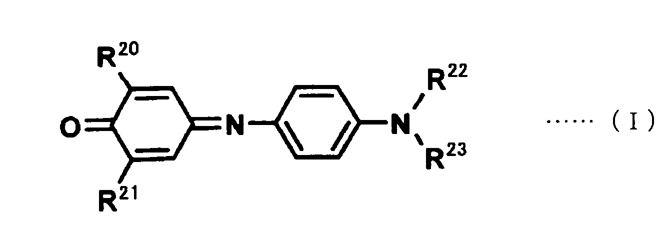 wherein each of R²⁰ to R²³ is a hydrogen atom or a C₁₋₆ alkyl group which may have a substituent.

In the present invention, the compound is preferably a dicyano type compound of the following formula (J): 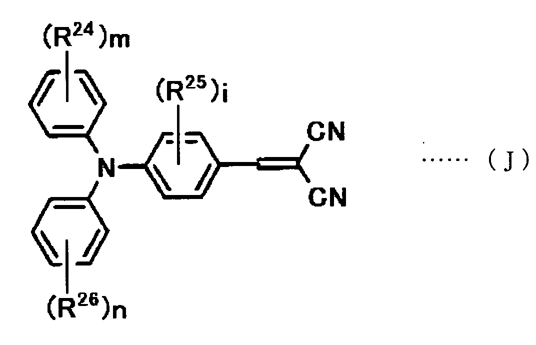 wherein each of R²⁴, R²⁵ and R²⁶ is a hydrogen atom, a C₁₋₆ alkyl group which may have a substituent, an aryl group which may have a substituent, a C₁₋₆ alkoxyl group which may have a substituent, each of m and n is an integer of 1 to 5, and i is an integer of 1 to 4.

In the present invention, the compound is preferably a pyridone type compound of the following formula (K): 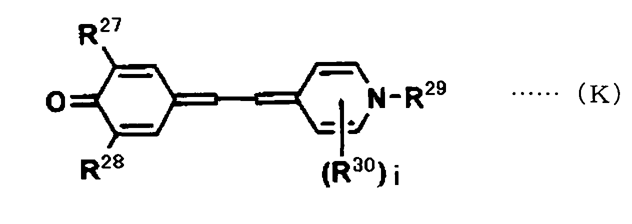 wherein each of R²⁷, R²⁸ and R²⁹ is a hydrogen atom, a C₁₋₆ alkyl group which may have a substituent, or an aryl group which may have a substituent, R³⁰ is a C₁₋₆ alkyl group which may have a substituent, or a residual group which is capable of forming a ring, and i is an integer of 1 to 4.

In the present invention, the compound is preferably a pyridone type compound of the following formula (L): 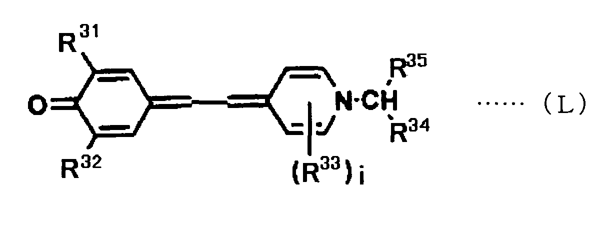 wherein each of R³¹ and R³² is a hydrogen atom or a C₁₋₆ alkyl group which may have a substituent, R³³ is a C₁₋₆ alkyl group which may have a substituent, or a residual group which is capable of forming a ring, each of R³⁴ and R³⁵ is an aryl group which may have a substituent, or a hydrogen atom, provided that at least one of R³⁴ and R³⁵ is an aryl group which may have a substituent, and i is an integer of 1 to 4.

In the present invention, the compound is preferably a quinoneimine type compound of the following formula (M): 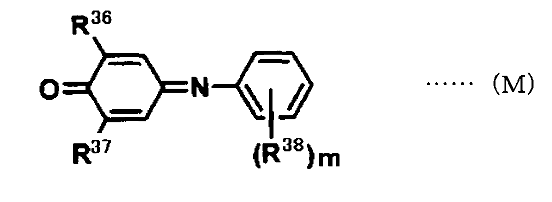 wherein each of R³⁶ and R³⁷ is a hydrogen atom, a C₁₋₆ alkyl group which may have a substituent, or an aryl group which may have a substituent, R³⁸ is a C₁₋₆ alkyl group which may have a substituent, an aryl group which may have a substituent, or a residual group which is capable of forming a ring, and m is an integer of 1 to 5.

In the present invention, the compound is preferably a quinoneimine type compound of the following formula (N): 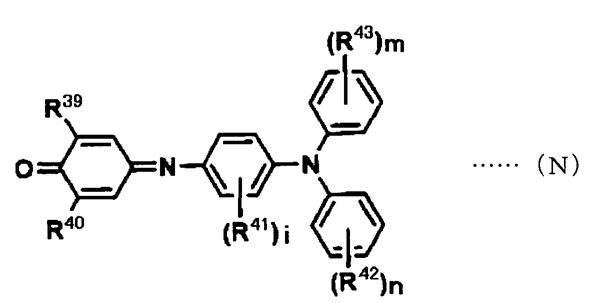 wherein each of R³⁹ and R⁴⁰ is a hydrogen atom or a C₁₋₆ alkyl group which may have a substituent; each of R⁴¹, R⁴² and R⁴³ is a hydrogen atom, a C₁₋₆ alkyl group which may have a substituent, an aryl group, or a residual group which is capable of forming a ring; i is an integer of 1 to 4; and each of m and n is an integer of 1 to 5.

In the present invention, the compound is preferably a stilbene type compound of the following formula (O): 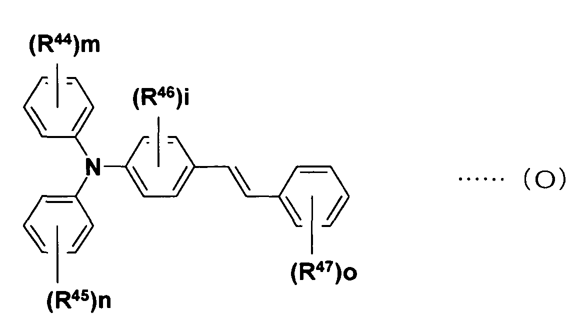 wherein each of R⁴⁴ , R⁴⁵ and R⁴⁶ is a hydrogen atom, a C₁₋₆ alkyl group which may have a substituent, a C₁₋₆ alkoxyl group which may have a substituent, an amino group which may have a substituent, or an aryl group which may have a substituent; R⁴⁷ is a hydrogen atom, a halogen atom, a nitro group, a cyano group or an aryl group which may have a substituent; each of m, n and o is an integer of 1 to 5; and i is an integer of 1 to 4.

In the present invention, the compound is preferably a butadiene type compound of the following formula (P): 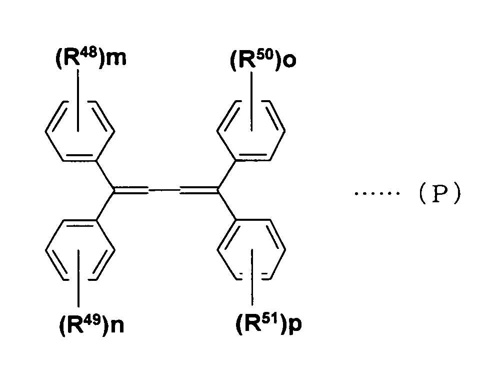 wherein each of R⁴⁸ and R⁴⁹ is a hydrogen atom, a halogen atom, a nitro group, a cyano group or an aryl group which may have a substituent; each of R⁵⁰ and R⁵¹ is a hydrogen atom, a C₁₋₆ alkyl group which may have a substituent, a C₁₋₆ alkoxyl group which may have a substituent, an amino group which may have a substituent, or an aryl group which may have a substituent; and each of m, n, o and p is an integer of 1 to 5.

In the present invention, the compound is preferably a stilbene·type compound of the following formula (Q): 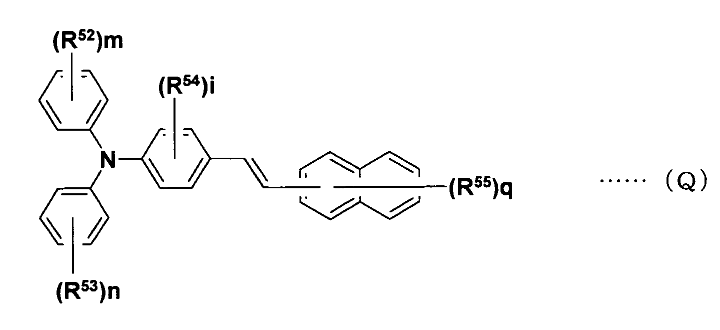 wherein each of R⁵², R⁵³, R⁵⁴ and R⁵⁵ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group forming a ring which may have a substituent; each of m and n is an integer of 1 to 5; i is an integer of 1 to 4; and q is an integer of 1 to 9.

In the present invention, the compound is preferably a triphenylamine type compound of the following formula (R): 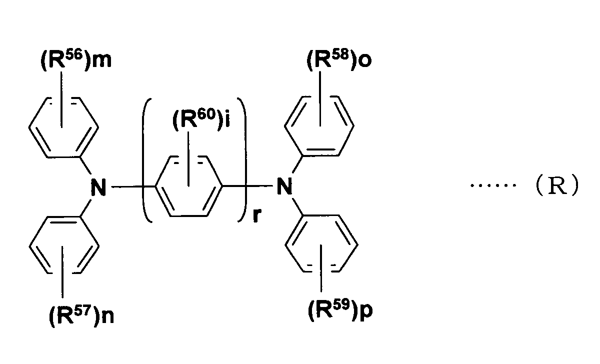 wherein each of R⁵⁶, R⁵⁷, R⁵⁸, R⁵⁹ and R⁶⁰ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group which is capable of forming a ring; each of m, n, o and p is an integer of 1 to 5; i is an integer of 1 to 4; and r is an integer of 1 to 2.

The above compounds of the formulas (A) to (R) are one-component system aromatic molecules having an electron donating functional group and an electron-accepting functional group in one molecule, and thus no fluctuation of the compositional ratio at the time of production cannot occur unlike the two-component system organic bistable materials.

Further, the above compounds of the formulas (A) to (R) are excellent in the bistability and can be easily formed into a thin film by a vapor deposition method, etc., whereby these are particularly preferably used as the organic bistable material.

### BRIEF DESCRIPTION OF THE DRAWINGS

Fig.1 is a schematic structural view showing one embodiment of a switching element of the present invention.
Fig.2 is a schematic structural view showing another embodiment of a switching element of the present invention.
Fig.3 is a schematic structural view showing still another embodiment of a switching element of the present invention.
Fig. 4 is a graph showing a current-voltage characteristic of a switching element in Example 1.
Fig. 5 is a graph showing a current-voltage characteristic of a switching element in Example 2.
Fig. 6 is a graph showing a current-voltage characteristic of a switching element in Example 6.
Fig.7 is a graph showing a current-voltage characteristic of a switching element in Example 7.
Fig.8 is a graph showing a current-voltage characteristic of a switching element in Example 8.
Fig. 9 is a graph showing a current-voltage characteristic of a switching element in Example 9.
Fig.10 is a graph showing a current-voltage characteristic of a switching element in Example 10.
Fig.11 is a graph showing a current-voltage characteristic of a switching element in Example 11.
Fig.12 is a graph showing a current-voltage characteristic of a switching element in Example 12.
Fig.13 is a graph showing a current-voltage characteristic of a switching element in Example 13.
Fig.14 is a graph showing a current-voltage characteristic of a switching element in Example 14.
Fig.15 is a graph showing a current-voltage characteristic of a switching element in Example 15.
Fig.16 is a graph showing a current-voltage characteristic of a switching element in Example 16.
Fig.17 is a graph showing a current-voltage characteristic of a switching element in Example 17.
Fig.18 is a graph showing a current-voltage characteristic of a switching element in Example 18.
Fig.19 is a graph showing a current-voltage characteristic of a switching element in Example 19.
Fig.20 is a graph showing a current-voltage characteristic of a switching element in Example 20.
Fig.21 is a graph showing a current-voltage characteristic of a switching element in Example 21.
Fig.22 is a graph showing a current-voltage characteristic of a switching element in Example 22.
Fig.23 is a graph showing a current-voltage characteristic of a switching element in Example 26.
Fig.24 is a graph showing a current-voltage characteristic of a switching element in Example 27.
Fig.25 is a graph showing a current-voltage characteristic of a switching element in Example 29.
Fig.26 is a graph showing a current-voltage characteristic of a switching element in Example 30.
Fig.27 is a graph showing a current-voltage characteristic of a switching element in Example 33.
Fig.28 is a graph showing a current-voltage characteristic of a switching element in Example 34.
Fig.29 is a graph showing a current-voltage characteristic of a switching element in Example 38.
Fig.30 is a graph showing a current-voltage characteristic of a switching element in Example 39.
Fig.31 is a graph showing a current-voltage characteristic of a switching element in Example 43.
Fig.32 is a graph showing a current-voltage characteristic of a switching element in Example 44.
Fig.33 is a graph showing a current-voltage characteristic of a switching element in Example 47.
Fig.34 is a graph showing a current-voltage characteristic of a switching element in Example 48.
Fig.35 is a graph showing a current-voltage characteristic of a switching element in Example 51.
Fig.36 is a graph showing a current-voltage characteristic of a switching element in Example 52.
Fig.37 is a graph showing a current-voltage characteristic of a switching element in Example 54.
Fig.38 is a graph showing a current-voltage characteristic of a switching element in Example 55.
Fig.39 is a graph showing a current-voltage characteristic of a switching element in Example 58.
Fig.40 is a graph showing a current-voltage characteristic of a switching element in Example 59.
Fig.41 is a conceptual graph showing the voltage-current characteristics of a conventional switching element.
Fig.42 is a schematic view showing the structure of a conventional organic bistable material with two-component system.

### BEST MODE FOR CARRYING OUT THE INVENTION

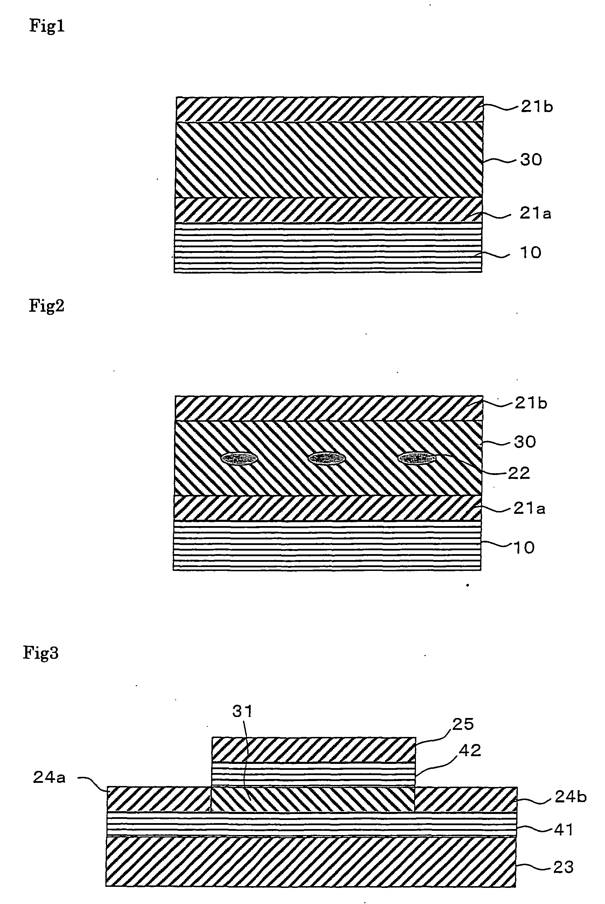

Hereinbelow, the present invention will be described with reference to drawings. Fig.1 is a schematic structural view showing an embodiment of a switching element of the present invention.

As shown in Fig.1, this switching element has a structure wherein on a substrate 10, an electrode layer 21a, a bistable material layer 30 and an electrode layer 21b are successively laminated.

Although the substrate 10 is not particularly limited, conventionally known glass substrates or the like are preferably used.

As the electrode layers 21a and 21b, metal materials such as aluminum, gold, silver, nickel and iron, inorganic materials such as ITO and carbon, conjugate organic materials, organic materials such as liquid crystals, semiconductor materials such as silicon, etc. may appropriately be selected, and the electrode layers are not limited thereto.

Next, the present invention is characterized in that the organic bistable material to be used for the bistable material layer 30 comprises at least a compound having an electron-donating functional group and an electron-accepting functional group in each molecule of the compound.

As the electron-donating functional group, -SCH₃, -OCH₃, -NH₂, -NHCH₃, -N(CH₃)₂, etc. may be mentioned. As the electron-accepting functional group, -CN, -NO₂, -CHO, -COCH₃, -COOC₂H₅, -COOH, -Br, -Cl, -I, -OH, -F, =O, etc. may be mentioned.

Further, as the compound having an electron-donating functional group and an electron-accepting functional group in each molecule of the compound, an aminoimidazole type compound, a pyridone type compound, a styryl type compound, a stilbene type compound, a butadiene type compound, etc. may be mentioned.

Among the above compounds, in the present invention, it is preferred to use an aminoimidazole type compound of the following formula (A): 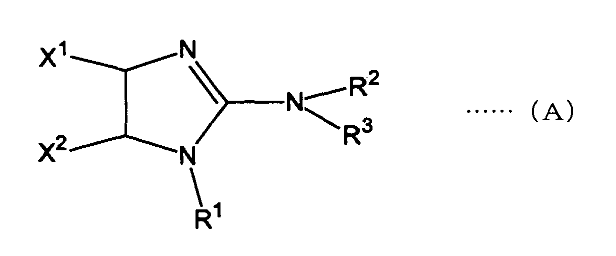 wherein each of X¹ and X² is CN or NO₂, and each of R¹, R² and R³ is a hydrogen atom or a C₁₋₆ alkyl group which may have a substituent.

In the above compound, the CN group or the NO₂ group acts as the electron-accepting functional group and the NH₂ group, NHCH₃ group or the like acts as the electron-donating functional group, thereby providing the characteristic of bistablity.

Here, when the above R¹, R² or R³ is an alkyl group, it is preferably an alkyl group having at most 6 carbon atoms, more preferably an alkyl group having at most 2 carbon atoms. When it is an alkyl group having more than 7 carbon atoms, molecular alignment necessary for conductivity is likely to be restricted and sufficient bistability is hardly obtainable, such being undesirable.

As such aminoimidazole type compound, specifically, compounds of the following formulas (A-1) to (A-4) may, for example, be mentioned.

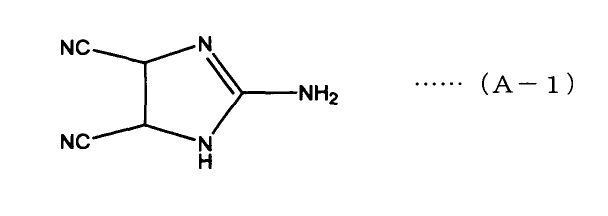

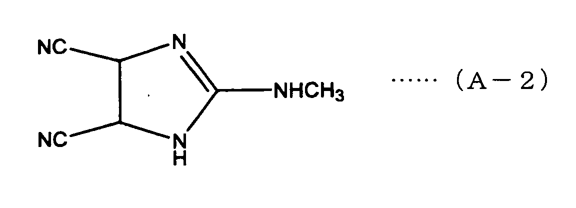

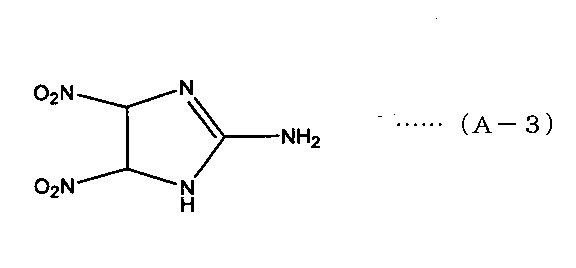

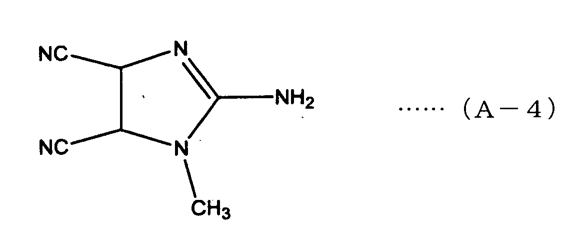

Further, it is also preferred to use a γ-pyridone type compound of the following formula (B): 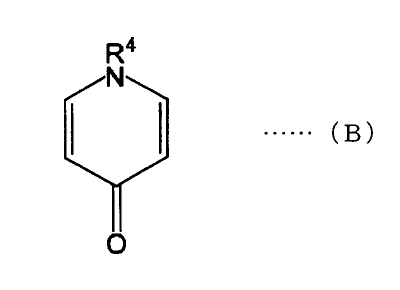 wherein R⁴ is a hydrogen atom or a C₁₋₆ alkyl group which may have a substituent.

In the γ-pyridone type compound, the C=O group acts as the electron-accepting functional group and the N-R group or the like acts as the electron-donating functional group, thereby providing the characteristic of bistablity.

Here, when R⁴ is an alkyl group, it is preferably an alkyl group having at most 6 carbon atoms, more preferably an alkyl group having at most 2 carbon atoms. When it is an alkyl group having more than 7 carbon atoms, molecular alignment necessary for conductivity is likely to be restricted and sufficient bistability is hardly obtainable, such being undesirable.

As such γ-pyridone type compound, specifically, compounds of the following formulas (B-1) and (B-2) may, for example, be mentioned.

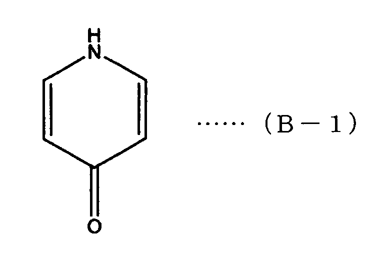

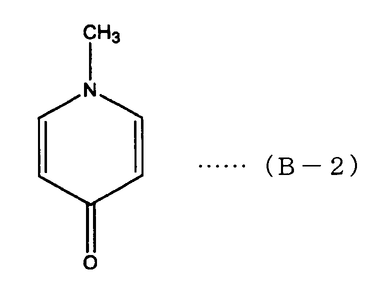

Further, it is also preferred to use an imine type compound of the following formula (C): 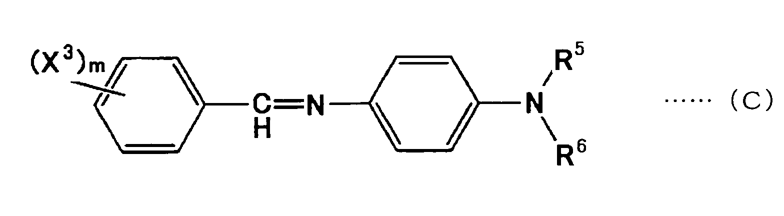 wherein X³ is CN or NO₂, each of R⁵ and R⁶ is a hydrogen atom or a C₁₋₆ alkyl group which may have a substituent, and m is an integer of 1 to 5.

Further, it is also preferred to use an imine type compound of the following formula (D): 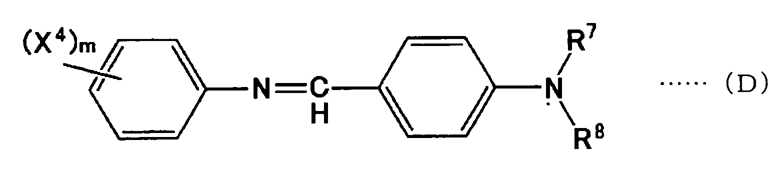 wherein X⁴ is CN or NO₂, each of R⁷ and R⁸ is a hydrogen atom or a C₁₋₆ alkyl group which may have a substituent, and m is an integer of 1 to 5.

In the above imine compounds, the CN group or the NO₂ group acts as the electron-accepting functional group and the NR⁵R⁶ group or the NR⁷R⁸ group acts as the electron-donating functional group, thereby providing the characteristic of bistablity.

Here, when the above R⁵, R⁶, R⁷ or R⁸ is an alkyl groups, it is preferably an alkyl group having at most 6 carbon atoms, more preferably an alkyl group having at most 2 carbon atoms.

As such imine type compound, specifically, compounds of the following formulas (C-1) to (C-3) and (D-1) to (D-3) may, for example, be mentioned.

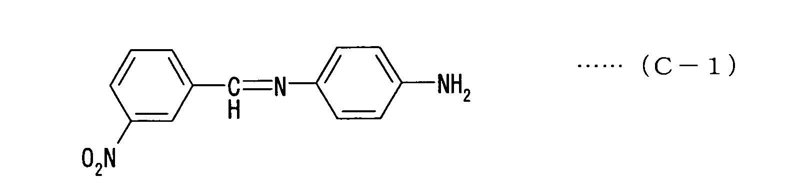

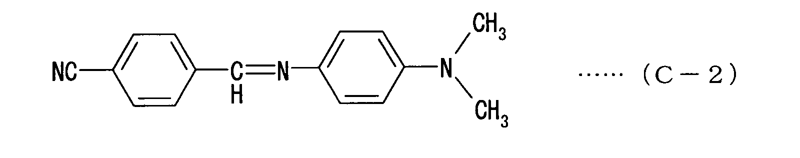

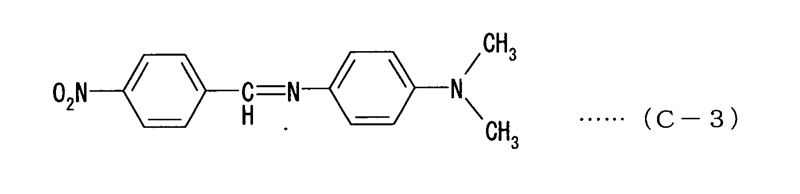

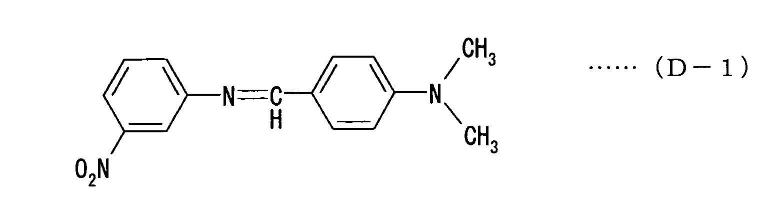

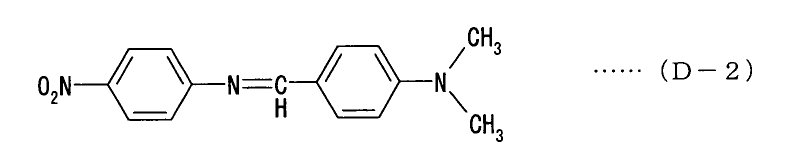

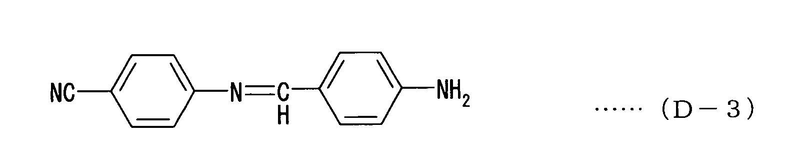

Further, it is also preferred to use a compound of the following formula (E): 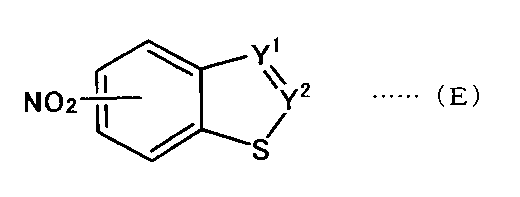 wherein either one of Y¹ and Y² is a nitrogen atom, and another one thereof is a carbon atom having an amino group or a C₁₋₆ alkylamino group as a substituent.

In the above compound, the nitro group acts as the electron-accepting functional group and the amino group or the alkylamino group acts as the electron-donating functional group, thereby providing the characteristic of bistablity.

As such compound, specifically, compounds of the following formulas (E-1) and (E-2) may, for example, be mentioned.

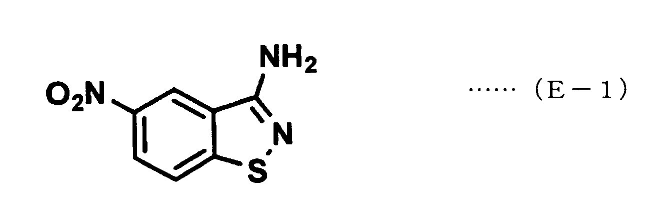

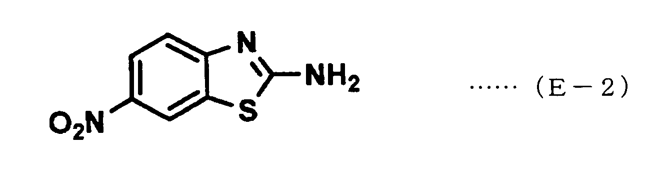

Further, it is also preferred to use a compound of the following formula (F): 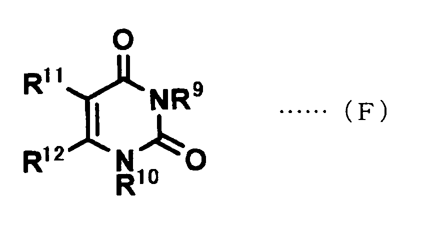 wherein each of R⁹ and R¹⁰ is a hydrogen atom or an alkyl group having at most 2 carbon atoms, and each of R¹¹ and R¹² is a hydrogen atom or an amino group.

In the above compound, the C=O group acts as the electron-accepting functional group and the N-R⁹ group and the N-R¹⁰ group act as the electron-donating functional groups, thereby providing the characteristic of bistablity.

As such compound, specifically, compounds of the following formulas (F-1), (F-2) and (F-3) may, for example, be mentioned.

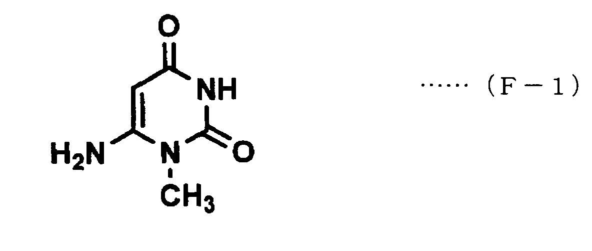

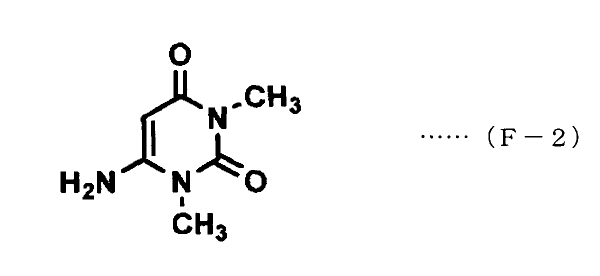

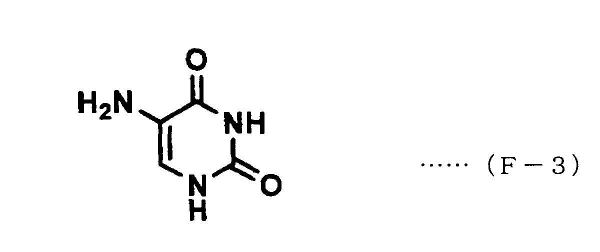

Further, it is also preferred to use a compound of the following formula (G): 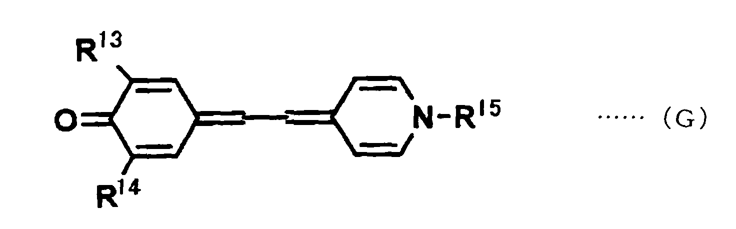 wherein each of R¹³, R¹⁴ and R¹⁵ is a hydrogen atom or a C₁₋₆ alkyl group which may have a substituent.

In this compound, the C=O group acts as the electron-accepting functional group and the N-R¹⁵ group acts as the electron-donating functional group, thereby providing the characteristic of bistablity.

Here, when R¹³, R¹⁴ or R¹⁵ is an alkyl groups, it is an alkyl group having at most 6 carbon atoms, more preferably an alkyl group having at most 4 carbon atoms.

As such compound, specifically, compounds of the following formulas (G-1) and (G-2) may, for example, be mentioned.

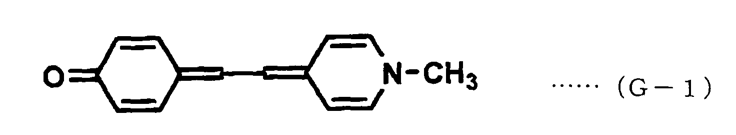

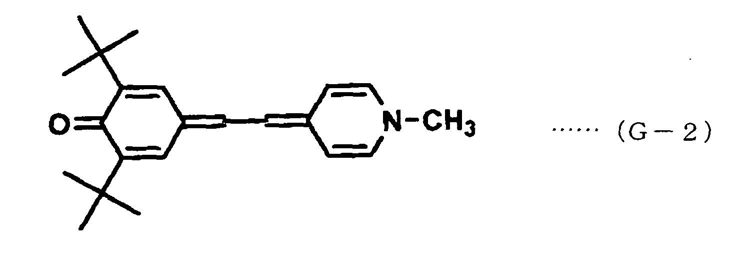

Further, it is also preferred to use an iminequinone type compound of the following formula (H): 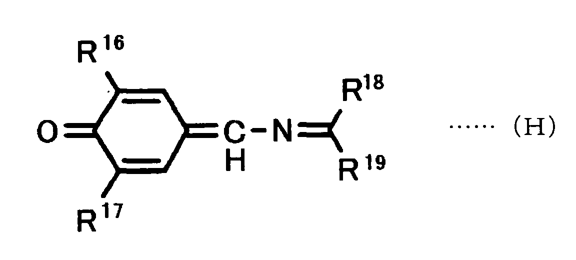 wherein each of R¹⁶ and R¹⁷ is a hydrogen atom or a C₁₋₆ alkyl group which may have a substituent, and each of R¹⁸ and R¹⁹ is an aryl group which may have a substituent, a C₁₋₆ alkyl group which may have a substituent, or a hydrogen atom, provided that at least one of R¹⁸ and R¹⁹ is an aryl group which may have a substituent.

In the iminequinone type compound, the C=O group acts as the electron-accepting functional group and the C₆H₅ group or the like acts as the electron-donating functional group, thereby providing the characteristic of bistablity.

Here, R¹⁶ or R¹⁷ is preferably an alkyl group having at most 6 carbon atoms, and when R¹⁸ or R¹⁹ is an alkyl groups, it is preferably an alkyl group having at most 6 carbon atoms, more preferably an alkyl group having at most 2 carbon atoms. When it is an alkyl group having more than 7 carbon atoms, molecular alignment necessary for conductivity is likely to be restricted and sufficient bistability is hardly obtainable, such being undesirable.

As such iminequinone type compound, specifically, compounds of the following formulas (H-1) to (H-4) may, for example, be mentioned.

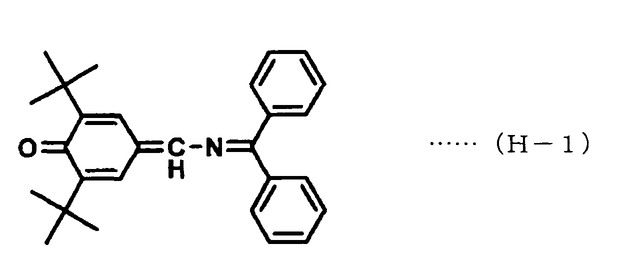

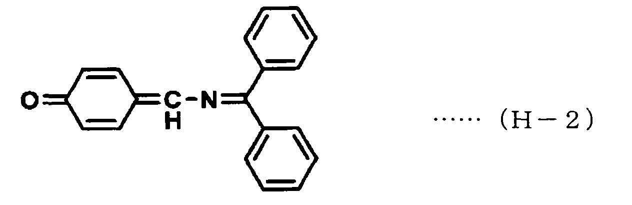

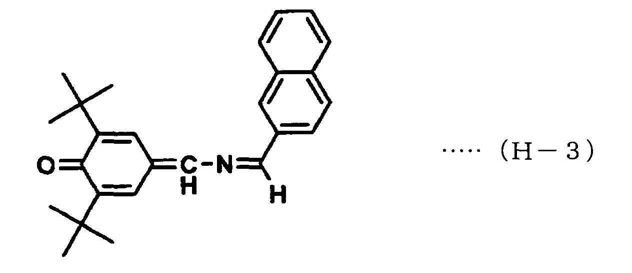

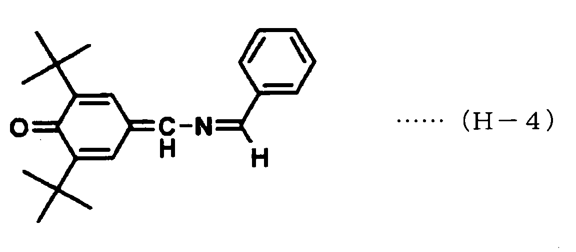

Further, it is also preferred to use an iminequinone type compound of the following formula (H'): 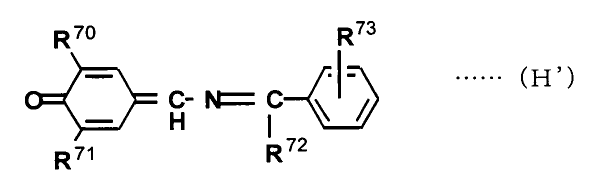 wherein each of R⁷⁰ and R⁷¹ is a hydrogen atom, a C₁₋₆ alkyl group which may have a substituent, or an aryl group which may have a substituent; R⁷² is a hydrogen atom, a C₁₋₆ alkyl group which may have a substituent, or an aryl group which may have a substituent; R⁷³ is a hydrogen atom, a C₁₋₆ alkyl group which may have a substituent, an amino group which may have a substituent, or a residual group which may form a ring; or R⁷² and R⁷³ may form a ring.

As such iminequinone type compound, specifically, compounds of the following formulas (H'-1) to (H'-9) may, for example, be mentioned.

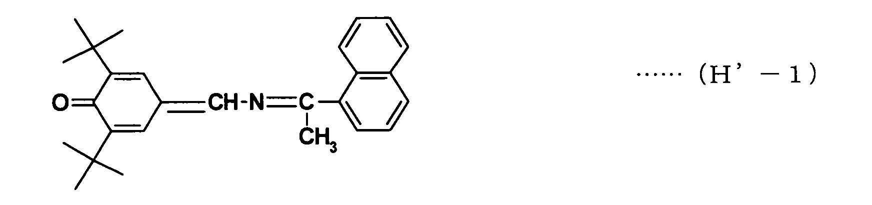

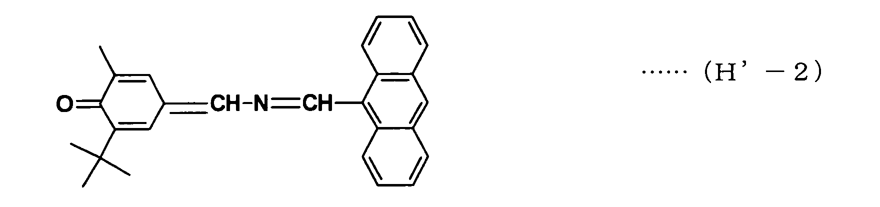

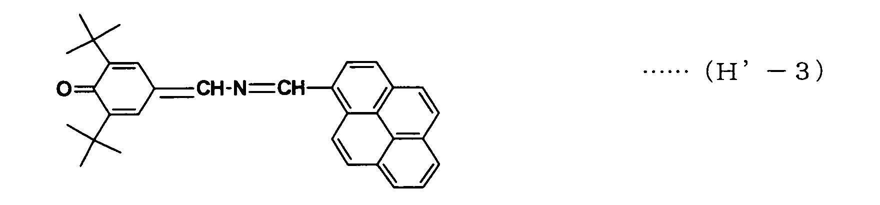

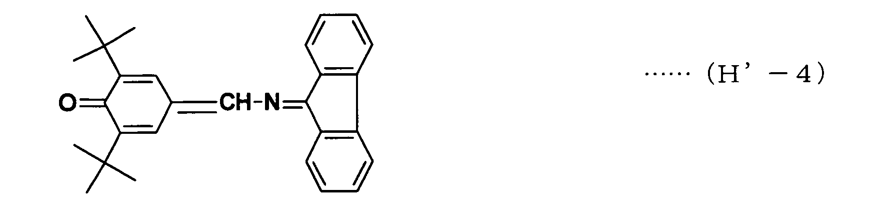

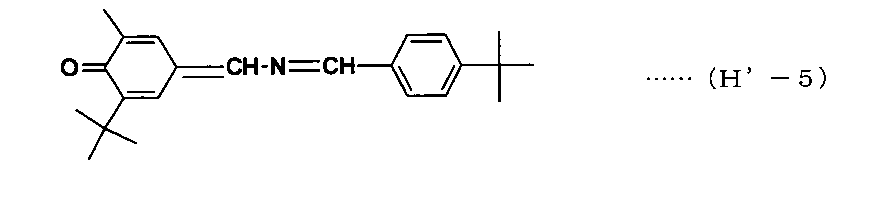

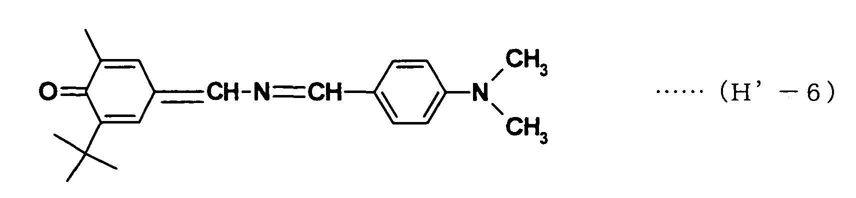

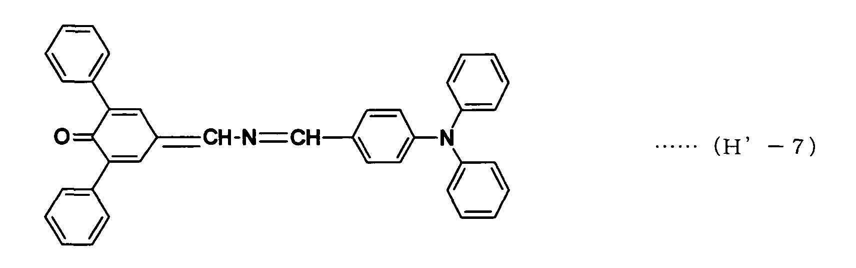

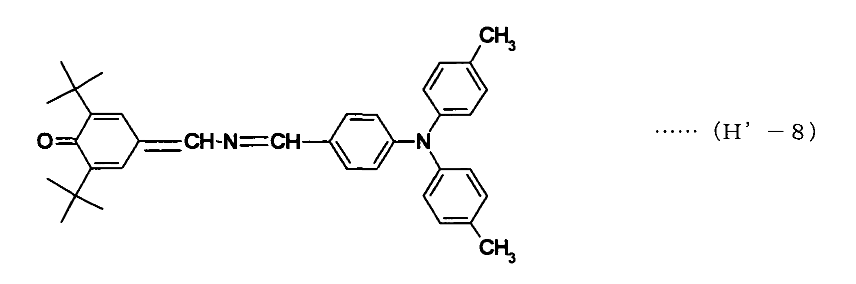

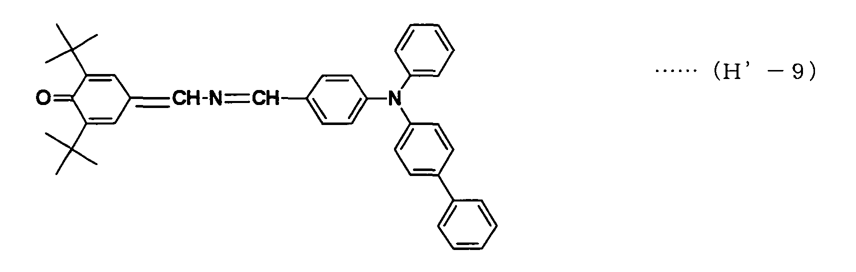

Further, it is also preferred to use a quinoneimine compound of the following formula (I): 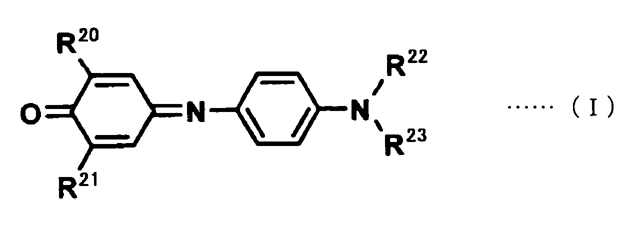 wherein each of R²⁰ to R²³ is a hydrogen atom or a C₁₋₆ alkyl group which may have a substituent.

In the quinoneimine type compound, the C=O group acts as the electron-accepting functional group and the NH₂ group, N(CH₃)₂ group or the like acts as the electron-donating functional group, thereby providing the characteristic of bistablity.

Here, R²⁰ or R²¹ is preferably an alkyl group having at most 6 carbon atoms. Further, when R²² or R²³ is an alkyl group, it is preferably an alkyl group having at most 6 carbon atoms, more preferably an alkyl group having at most 2 carbon atoms. When it is an alkyl group having more than 7 carbon atoms, molecular alignment necessary for conductivity is likely to be restricted and sufficient bistability is hardly obtainable, such being undesirable.

As such quinoneimine type compound, specifically, compounds of the following formulas (I-1) to (I-3) may, for example, be mentioned.

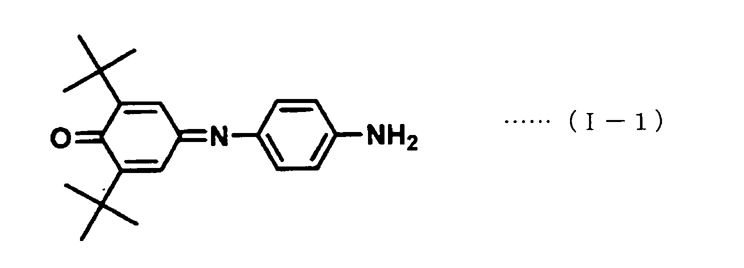

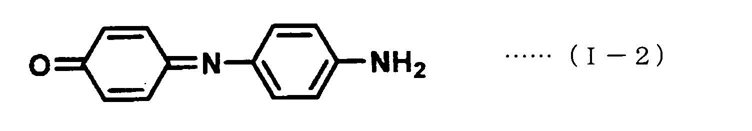

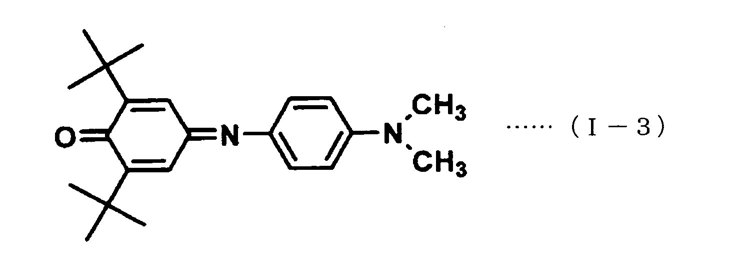

Further, it is also preferred to use a dicyano type compound of the following formula (J): 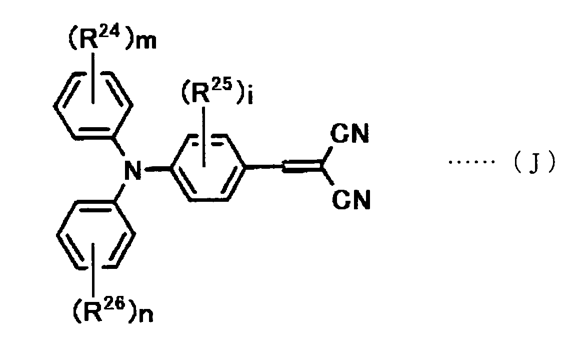 wherein each of R²⁴, R²⁵ and R²⁶ is a hydrogen atom, a C₁₋₆ alkyl group which may have a substituent, an aryl group which may have a substituent, a C₁₋₆ alkoxyl group which may have a substituent, each of m and n is an integer of 1 to 5, and i is an integer of 1 to 4.

In the dicyano type compound, the CN group acts as the electron-accepting functional group and the N(C₆H₆)₃ group or the like acts as the electron-donating functional group, thereby providing the characteristic of bistablity.

Here, when R²⁴, R²⁵ or R²⁶ is an alkyl group, it is preferably an alkyl group having at most 2 carbon atoms. When it is an alkyl group having more than 9 carbon atoms, molecular alignment necessary for conductivity is likely to be restricted and sufficient bistability is hardly obtainable, such being undesirable.

As such dicyano type compound, specifically, compounds of the following formulas (J-1) to (J-9) may, for example, be mentioned.

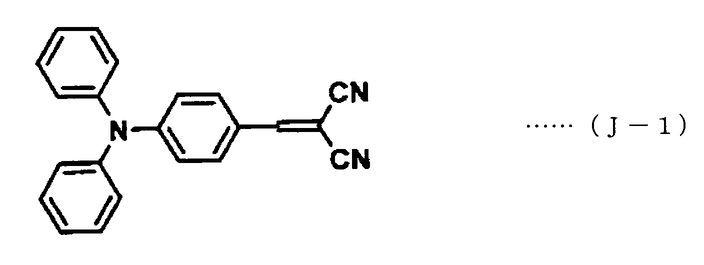

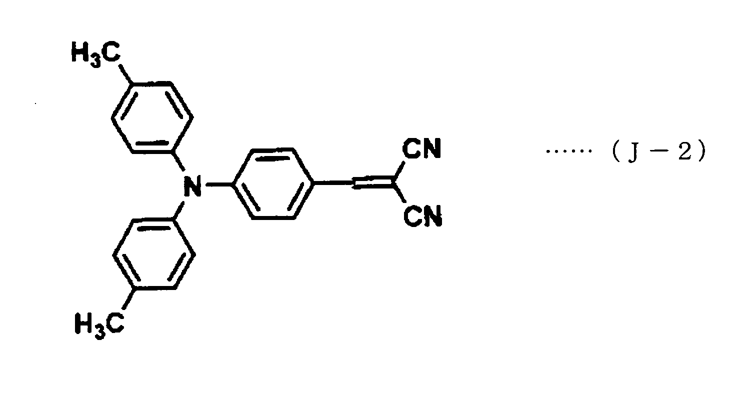

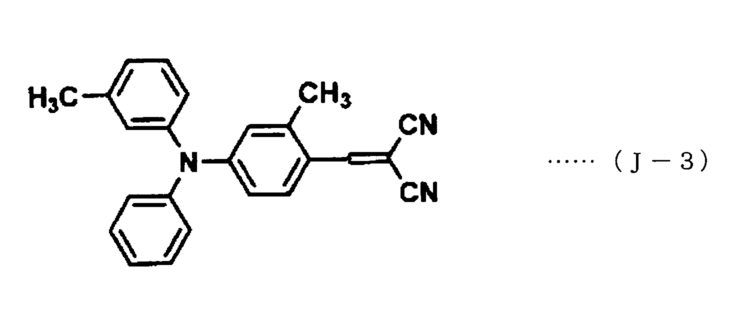

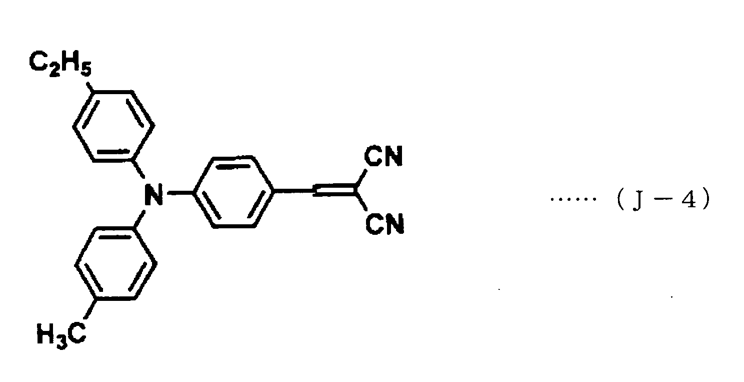

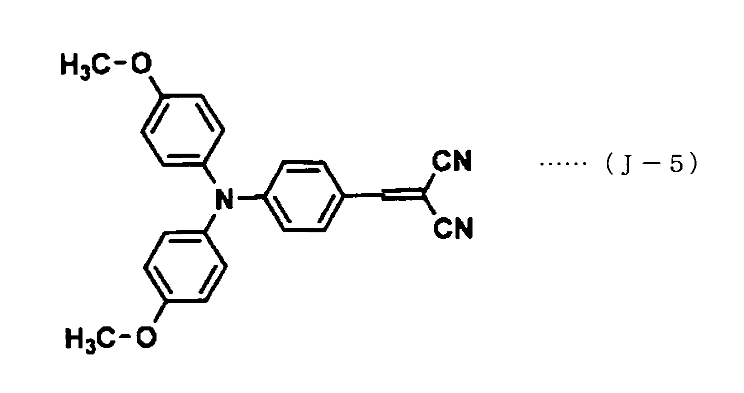

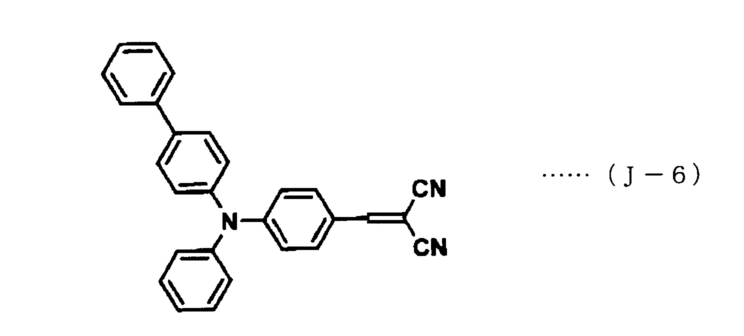

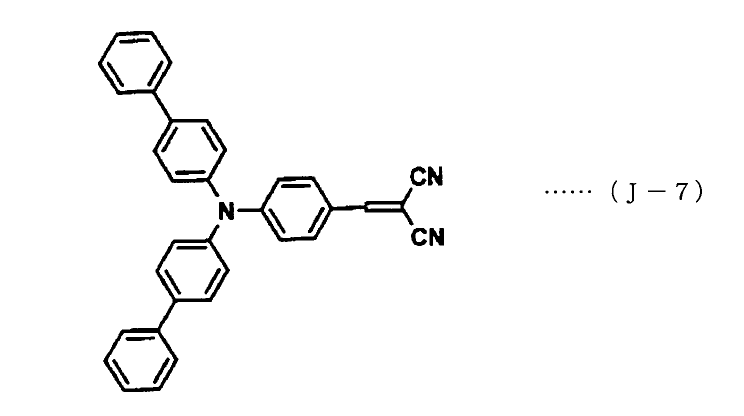

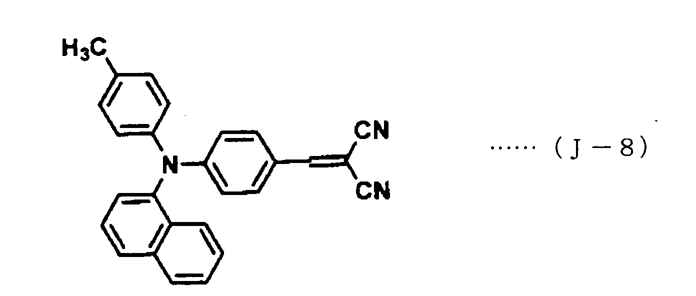

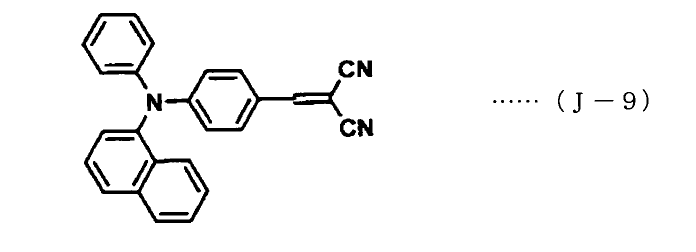

Further, it is also preferred to use a pyridone type compound of the following formula (K): 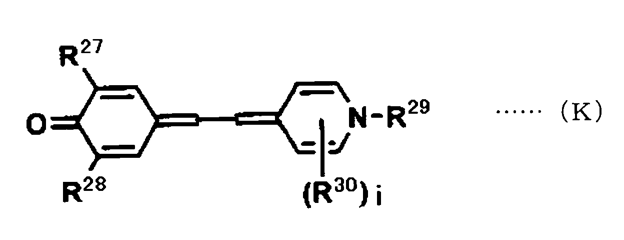 wherein each of R²⁷, R²⁸ and R²⁹ is a hydrogen atom, a C₁₋₆ alkyl group which may have a substituent, or an aryl group which may have a substituent, R³⁰ is a C₁₋₆ alkyl group which may have a substituent, or a residual group which is capable of forming a ring, and i is an integer of 1 to 4.

Further, it is also preferred to use a pyridone type compound of the following formula (L): 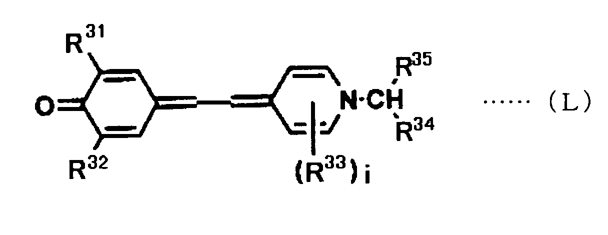 wherein each of R³¹ and R³² is a hydrogen atom or a C₁₋₆ alkyl group which may have a substituent, R³³ is a C₁₋₆ alkyl group which may have a substituent, or a residual group which is capable of forming a ring, each of R³⁴ and R³⁵ is an aryl group which may have a substituent, or a hydrogen atom, provided that at least one of R³⁴ and R³⁵ is an aryl group which may have a substituent, and i is an integer of 1 to 4.

In the pyridone type compound, the C=O group acts as the electron-accepting functional group and the C-N-(C₅H₄) group or the like acts as the electron-donating functional group, thereby providing the characteristic of bistablity.

As such pyridone type compounds, specifically, compounds of the following formulas (K-1) to (K-9) and (L-1) to (L-8) may, for example, be mentioned.

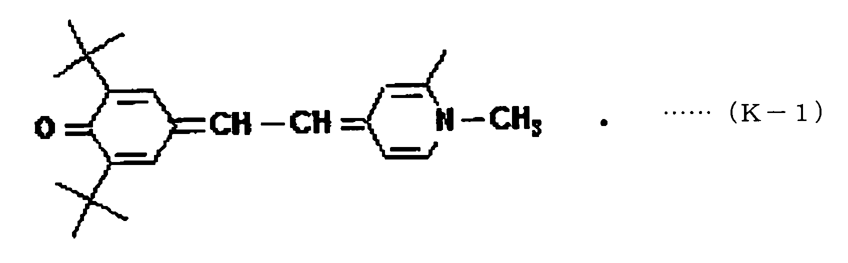

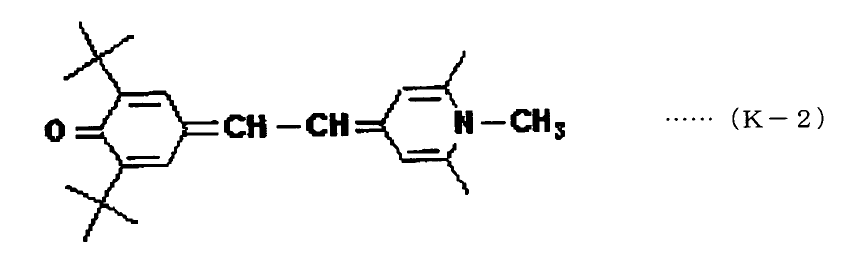

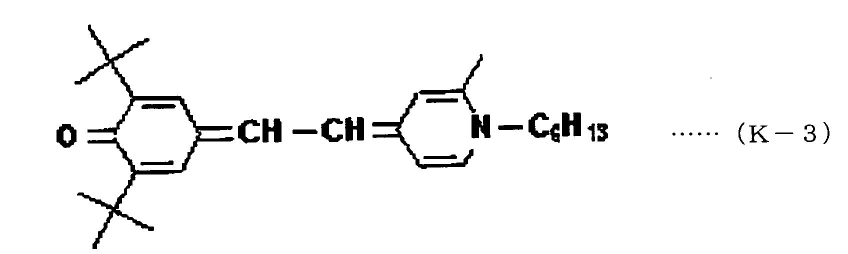

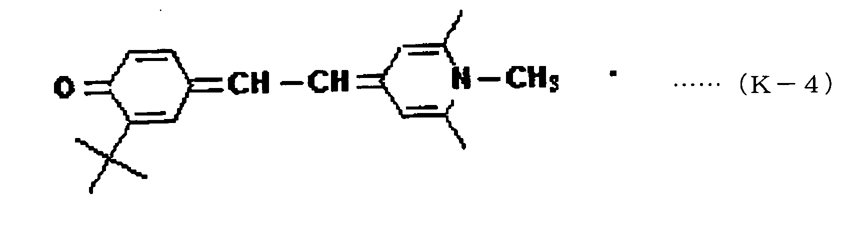

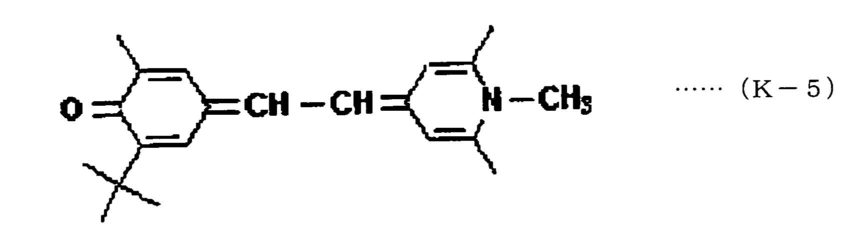

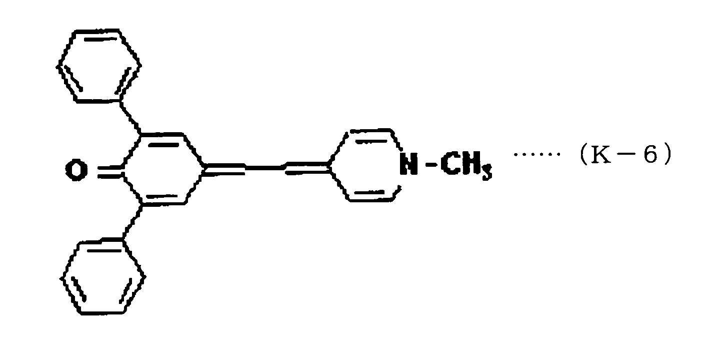

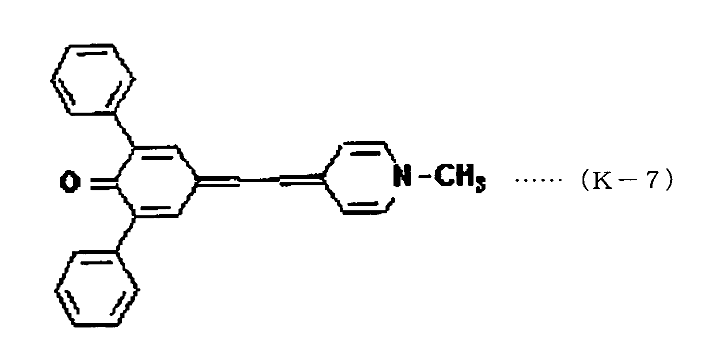

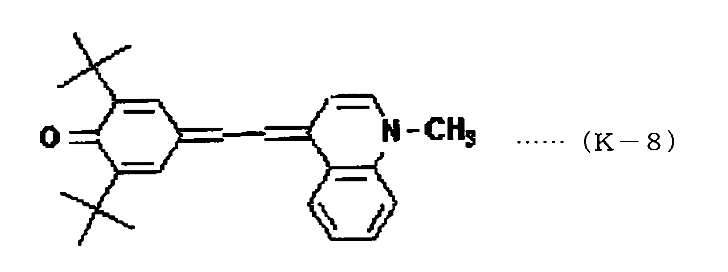

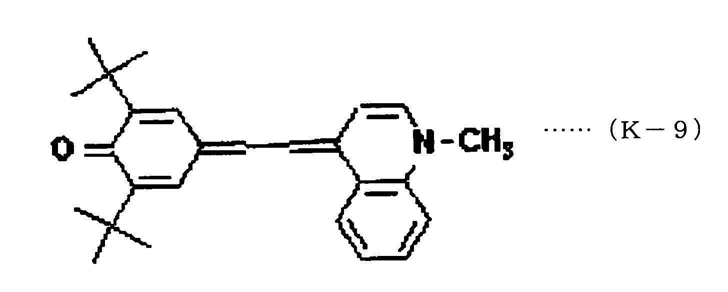

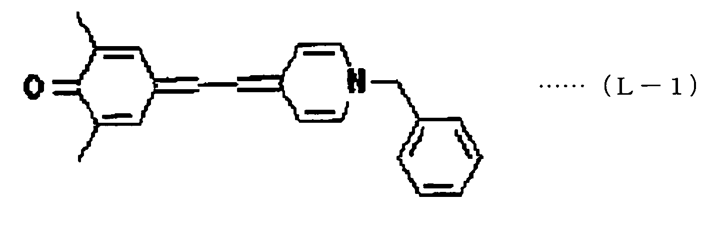

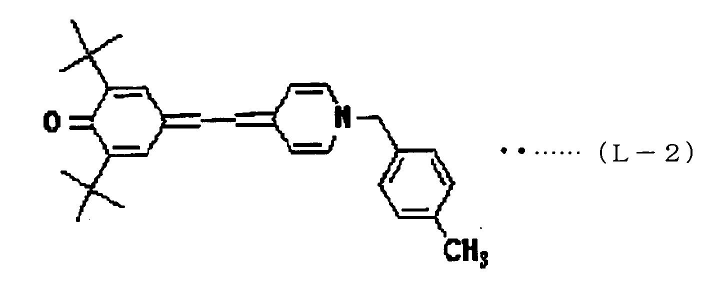

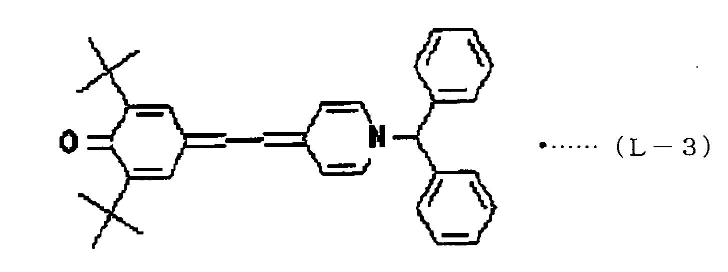

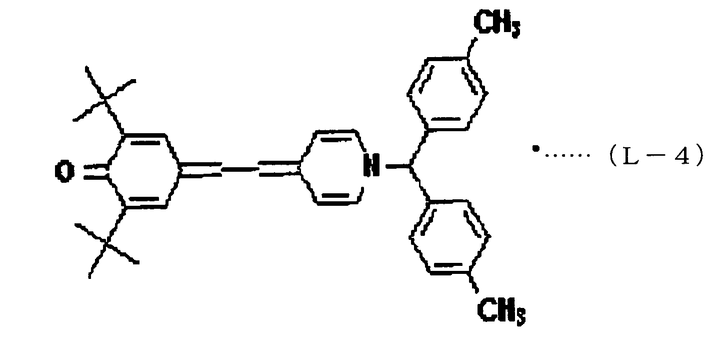

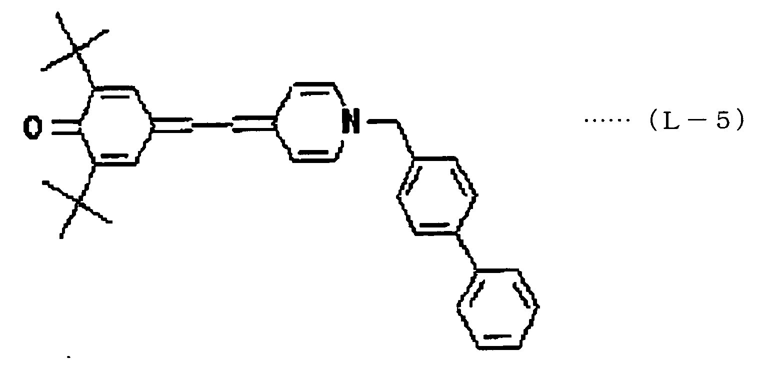

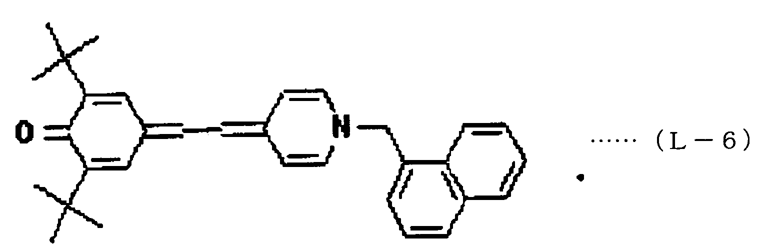

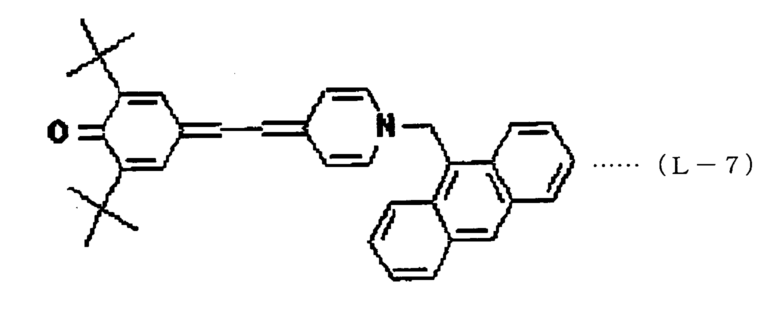

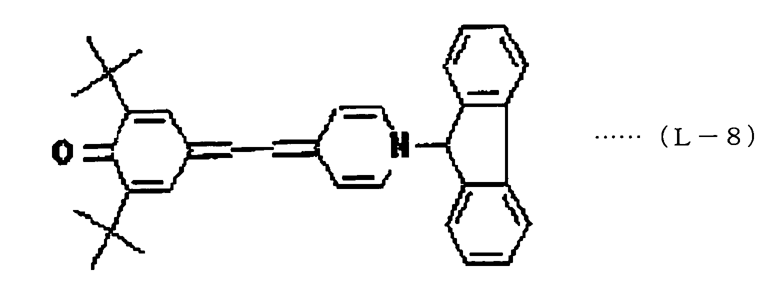

Further, it is also preferred to use a quinoneimine type compound of the following formula (M): 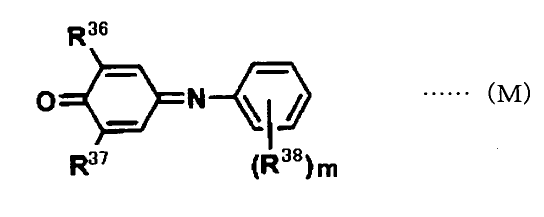 wherein each of R³⁶ and R³⁷ is a hydrogen atom, a C₁₋₆ alkyl group which may have a substituent, or an aryl group which may have a substituent, R³⁸ is a C₁₋₆ alkyl group which may have a substituent, an aryl group which may have a substituent, or a residual group which is capable of forming a ring, and m is an integer of 1 to 5.

Further, it is also preferred to use a quinoneimine type compound of the following formula (N): 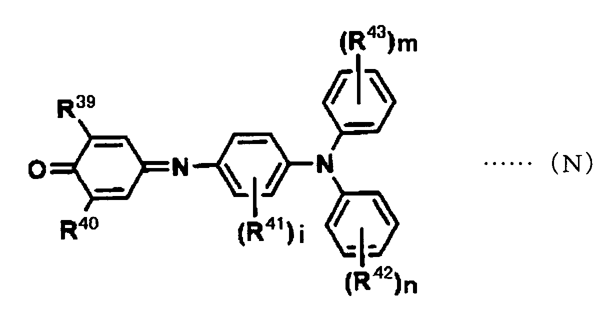 wherein each of R³⁹ and R⁴⁰ is a hydrogen atom or a C₁₋₆ alkyl group which may have a substituent; each of R⁴¹, R⁴² and R⁴³ is a hydrogen atom, a C₁₋₆ alkyl group which may have a substituent, an aryl group, or a residual group which is capable of forming a ring; i is an integer of 1 to 4; and each of m and n is an integer of 1 to 5.

In the quinoneimine type compounds, the C=O group acts as the electron-accepting functional group and the =N-, triphenylamine group or the like acts as the electron-donating functional group, thereby providing the characteristic of bistablity.

As such quinoneimine type compounds, specifically, compounds of the following formulas (M-1) to (M-9) and (N-1) to (N-9) may, for example, be mentioned.

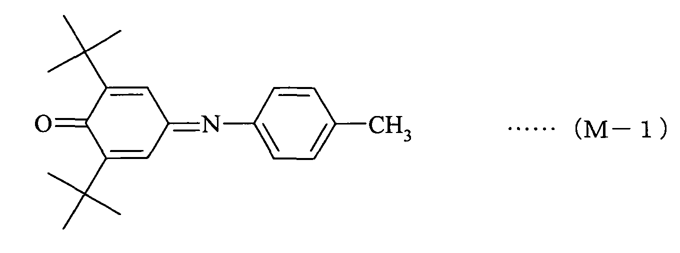

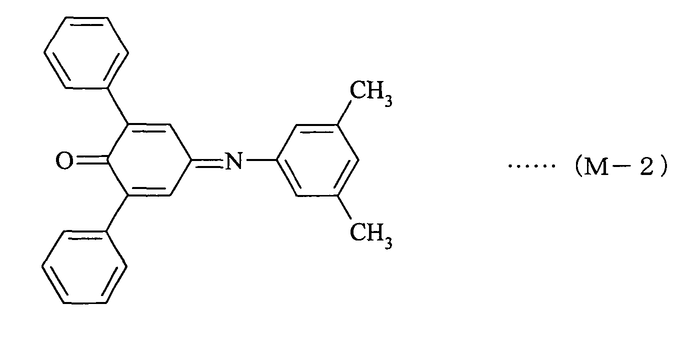

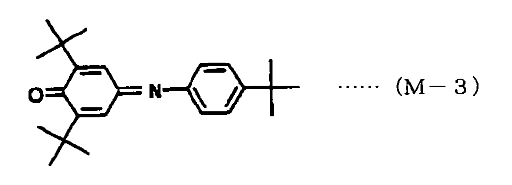

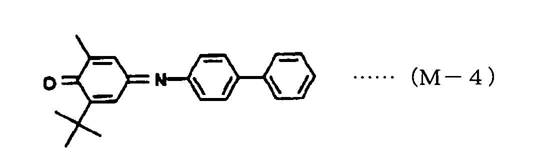

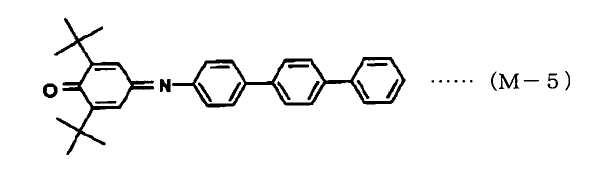

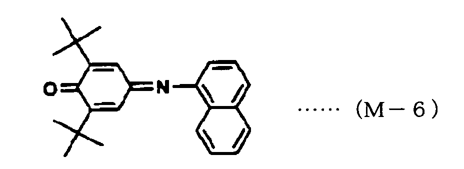

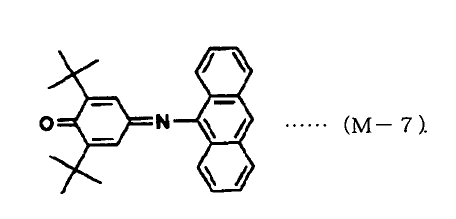

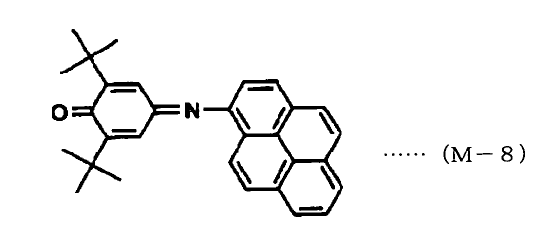

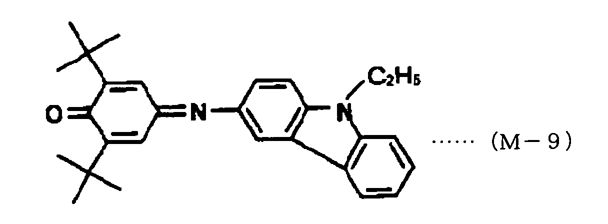

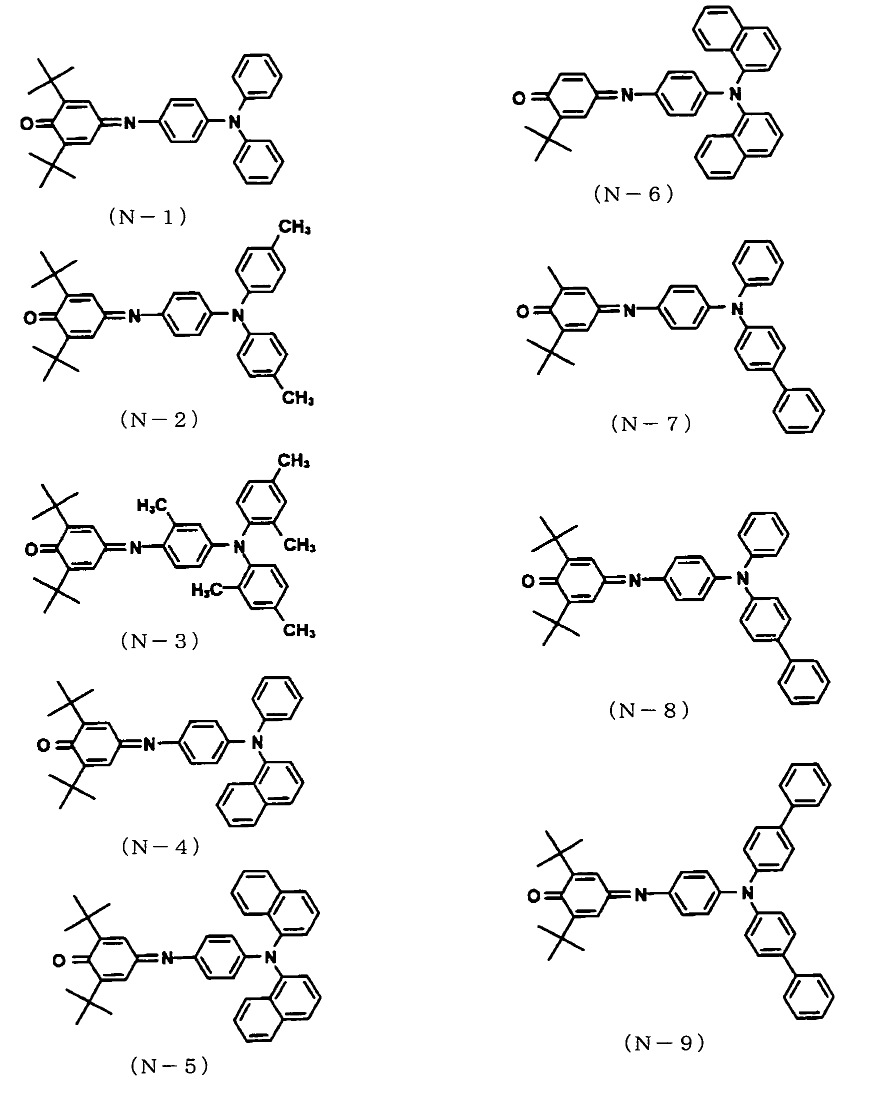

Further, it is preferred to use a stilbene type compound of the following formula (O): 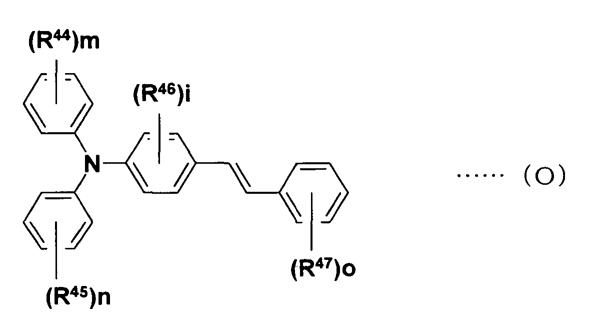 wherein each of R⁴⁴, R⁴⁵ and R⁴⁶ is a hydrogen atom, a C₁₋₆ alkyl group which may have a substituent, a C₁₋₆ alkoxyl group which may have a substituent, an amino group which may have a substituent, or an aryl group which may have a substituent; R⁴⁷ is a hydrogen atom, a halogen atom, a nitro group, a cyano group or an aryl group which may have a substituent; each of m, n and o is an integer of 1 to 5; and i is an integer of 1 to 4.

In the stilbene type compound, the triphenylamine group or the like acts as the electron-donating functional group and the -Cl, -Br, -CN or -NO₂ acts as the electron-accepting functional group, thereby providing the characteristic of bistablity.

As such stilbene type compound, specifically, compounds of the following formulas (O-1) to (O-11) may, for example, be mentioned.

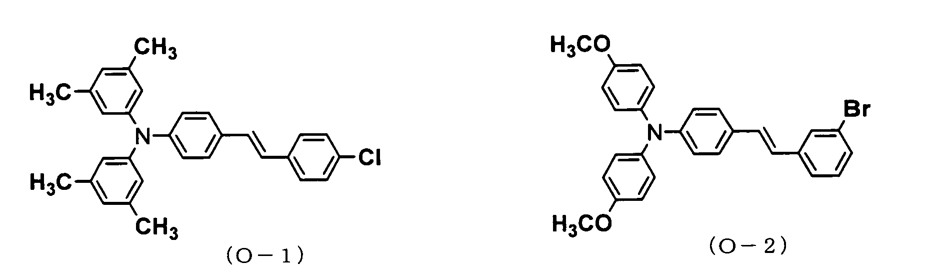

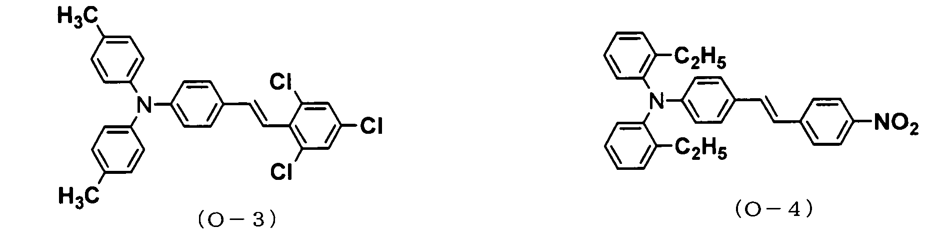

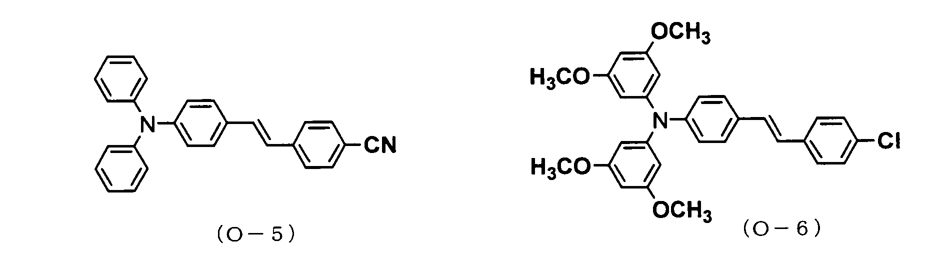

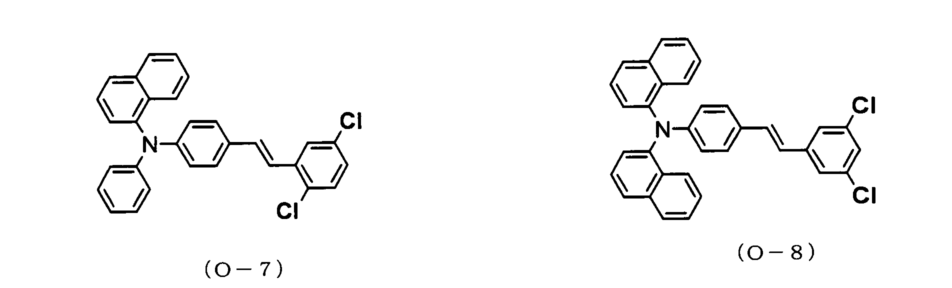

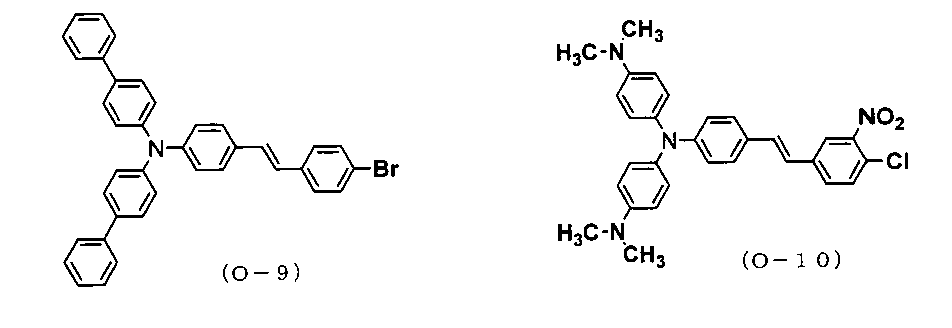

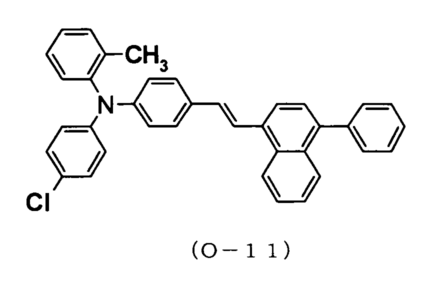

Further, it is also preferred to use a butadiene type compound of the following formula (P): 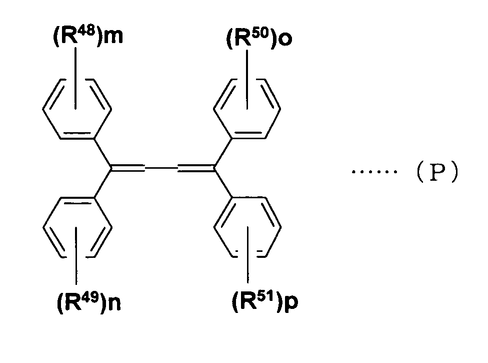 wherein each of R⁴⁸ and R⁴⁹ is a hydrogen atom, a halogen atom, a nitro group, a cyano group or an aryl group which may have a substituent; each of R⁵⁰ and R⁵¹ is a hydrogen atom, a C₁₋₆ alkyl group which may have a substituent, a C₁₋₆ alkoxyl group which may have a substituent, an amino group which may have a substituent, or an aryl group which may have a substituent; and each of m, n, o and p is an integer of 1 to 5.

In the butadiene type compound, -CN, -NO₂, -Br or -Cl acts as the electron-accepting functional group and the -CH₃, -OCH₃, -N(CH₃)₂ group or the like acts as the electron-donating functional group, thereby providing the characteristic of bistablity. As such butadiene type compounds, specifically, compounds of the following formulas (P-1) to (P-10) may, for example, be mentioned. 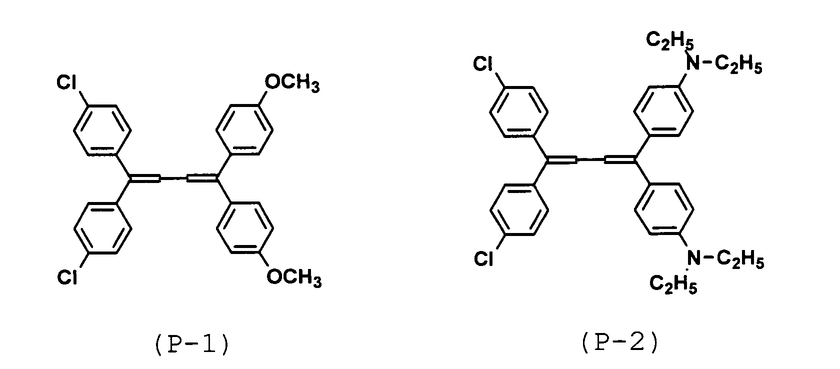 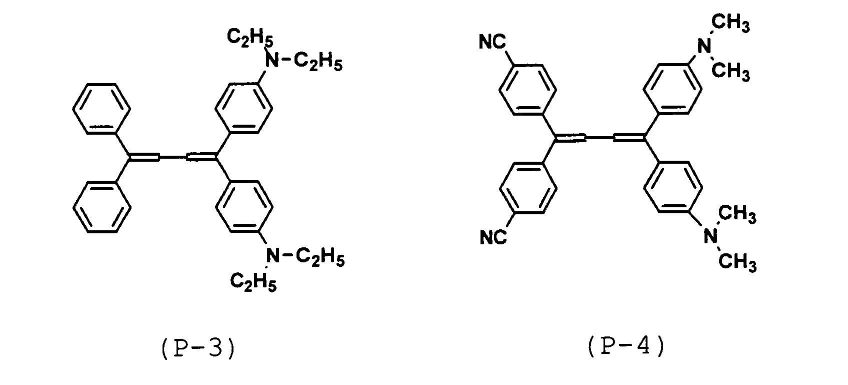 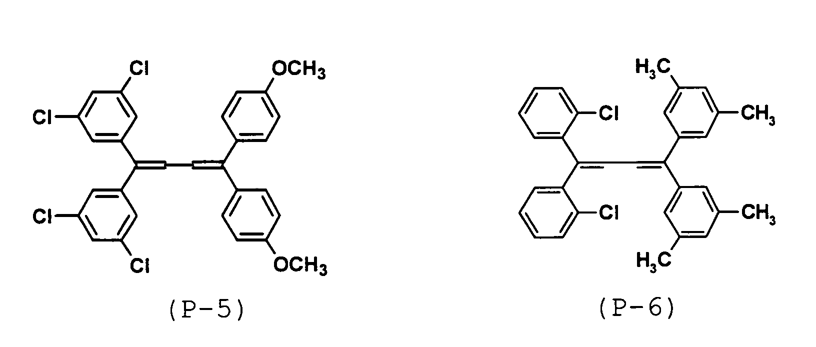 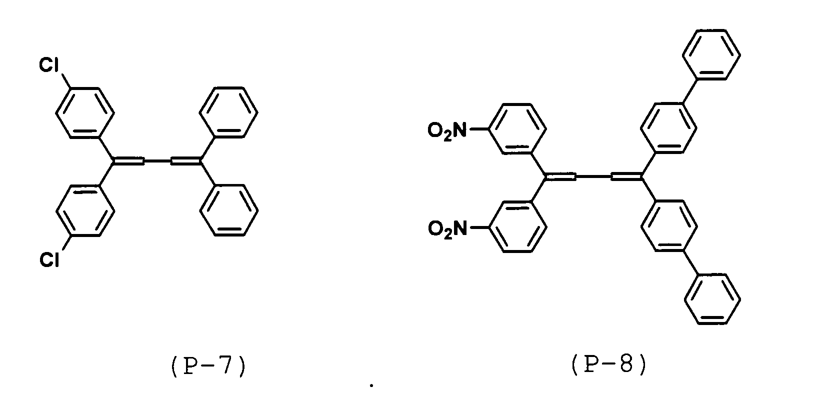 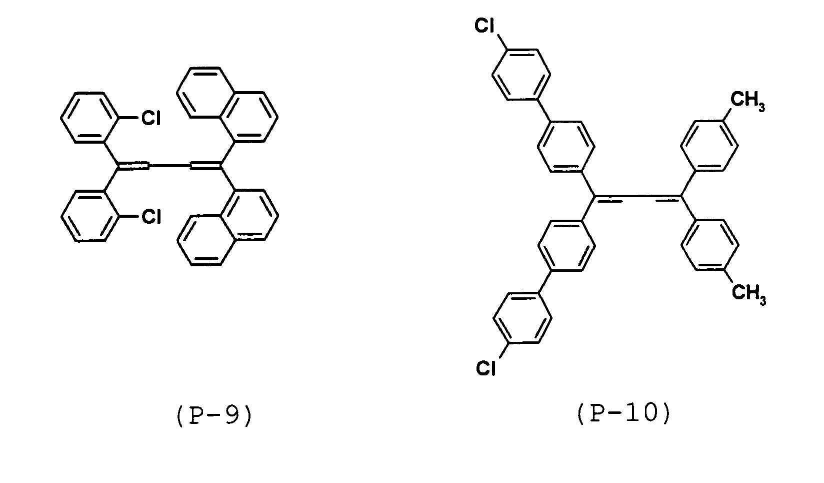 Further, it is also preferred to use a stilbene type compound of the following formula (Q): 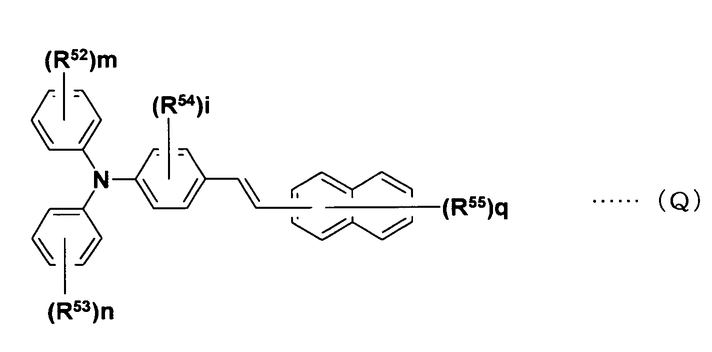 wherein each of R⁵², R⁵³, R⁵⁴ and R⁵⁵ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group forming a ring which may have a substituent; each of m and n is an integer of 1 to 5; i is an integer of 1 to 4; and q is an integer of 1 to 9.

In the stilbene type compound, the triphenylamine group or the like acts as the electron-donating functional group and -Cl, -Br, -CN or -NO₂ group acts as the electron-accepting functional group, thereby providing the characteristic of bistablity.

As such stilbene type compounds, specifically, compounds of the following formulas (Q-1) to (Q-14) may, for example, be mentioned.

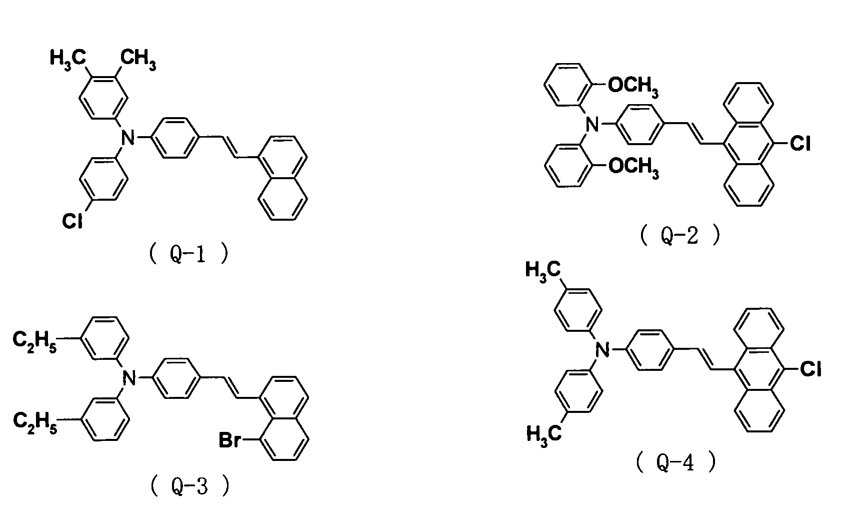

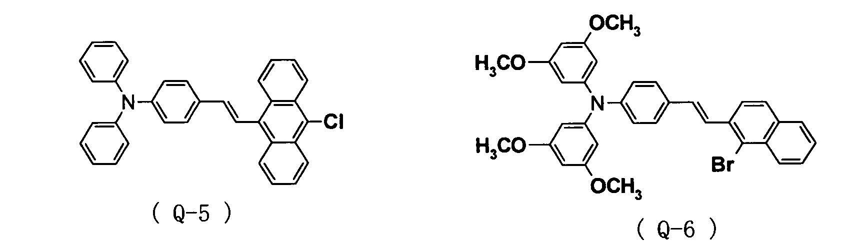

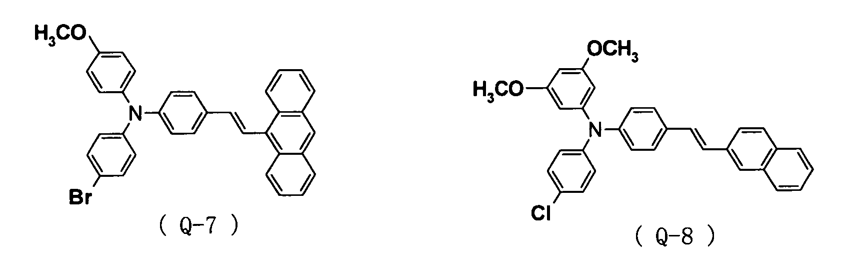

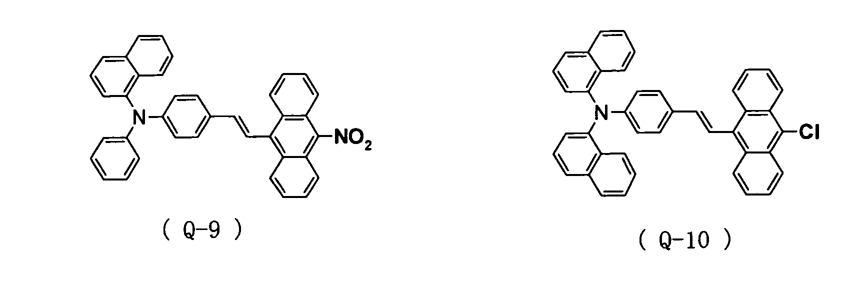

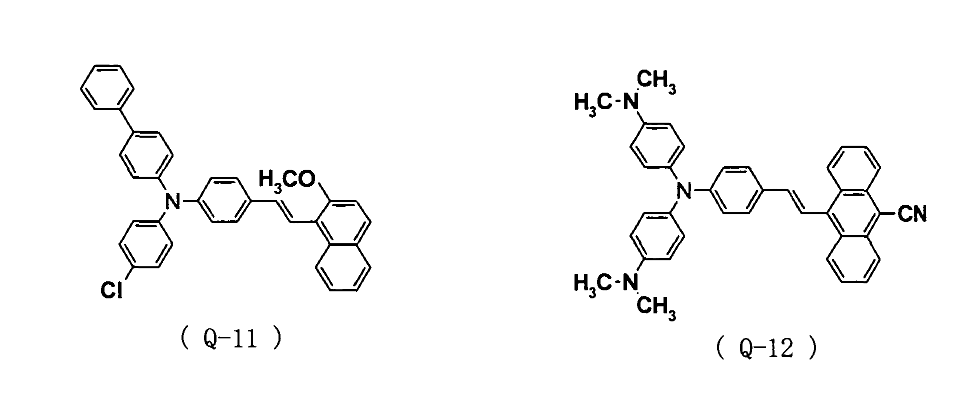

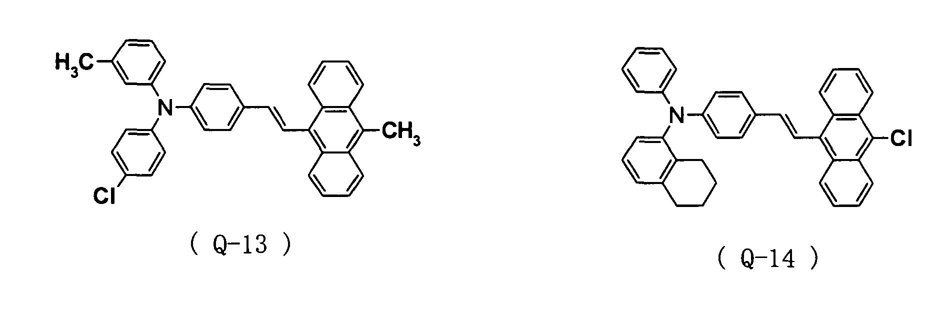

Further, it is also preferred to use a triphenylamine type compound of the following formula (R): 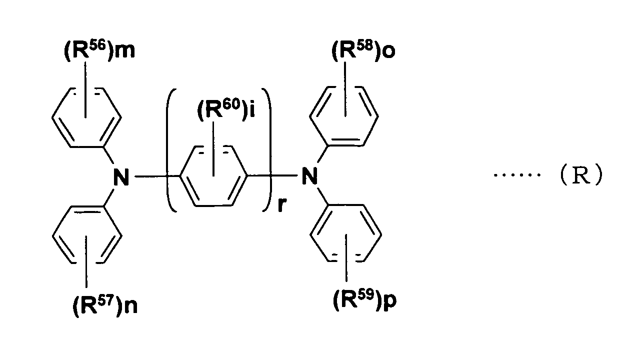 wherein each of R⁵⁶, R⁵⁷, R⁵⁸, R⁵⁹ and R⁶⁰ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group which is capable of forming a ring; each of m, n, o and p is an integer of 1 to 5; i is an integer of 1 to 4; and r is an integer of 1 to 2.

In the triphenylamine type compound, -CN, -NO₂, -Br or -Cl acts as the electron-accepting functional group, and the -CH₃, -OCH₃, -N(CH₃)₂ group or the like acts as the electron-donating functional group, thereby providing the characteristic of bistablity.

As such triphenylamine type compound, specifically, compounds of the following formulas (R-1) to (R-27) may, for example, be mentioned.

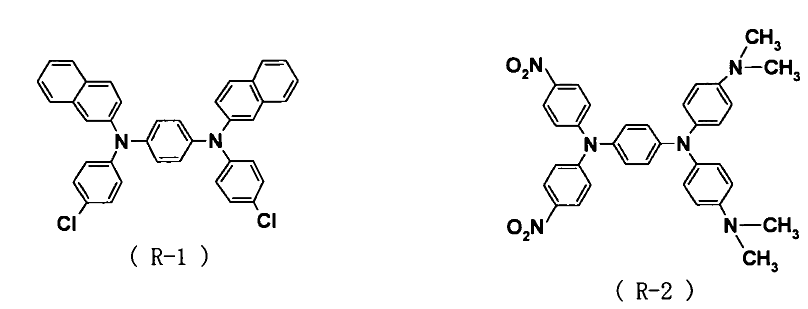

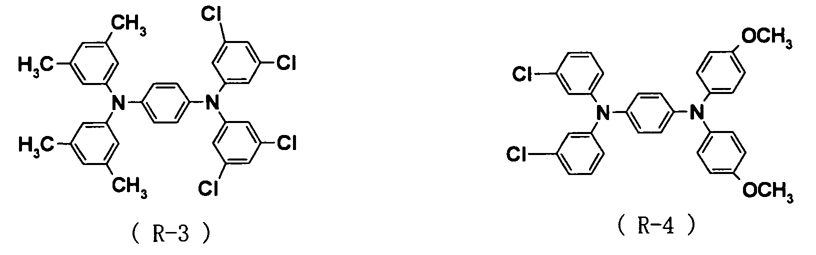

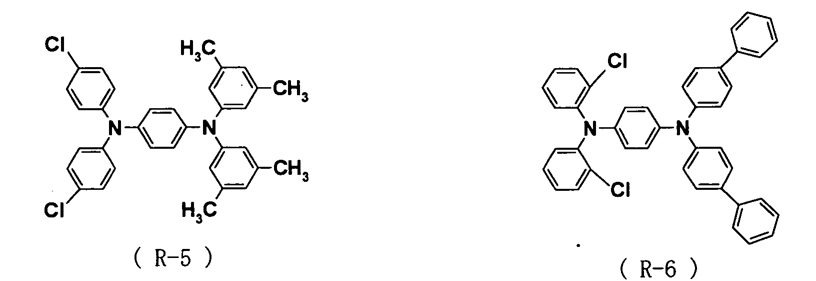

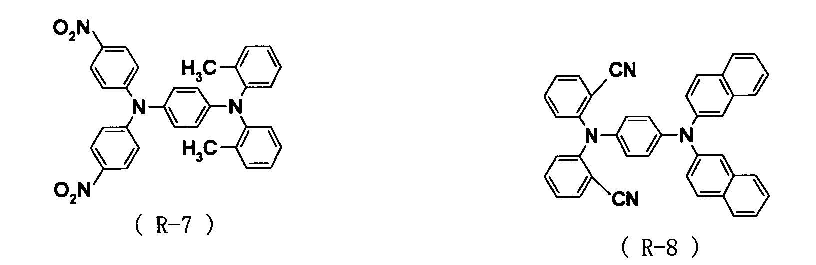

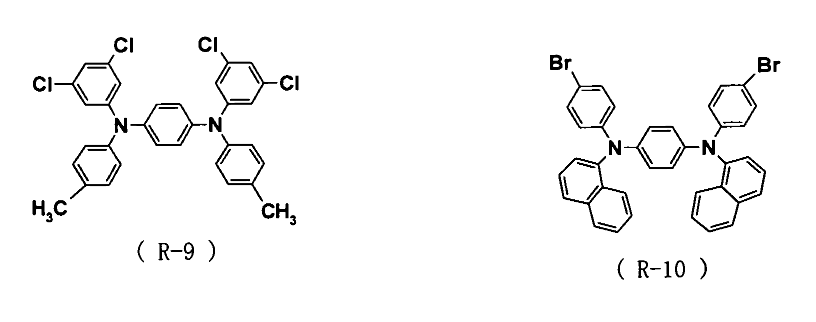

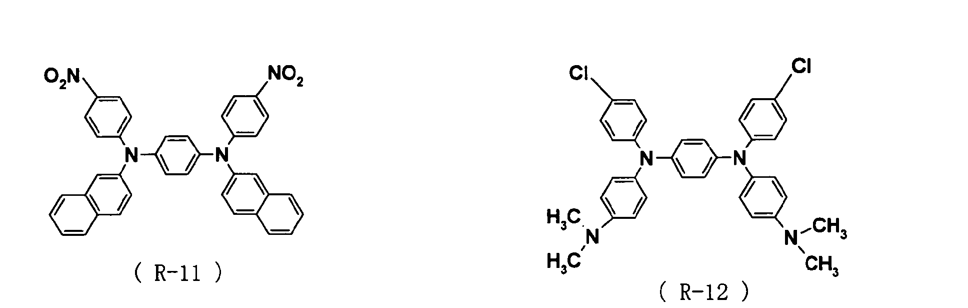

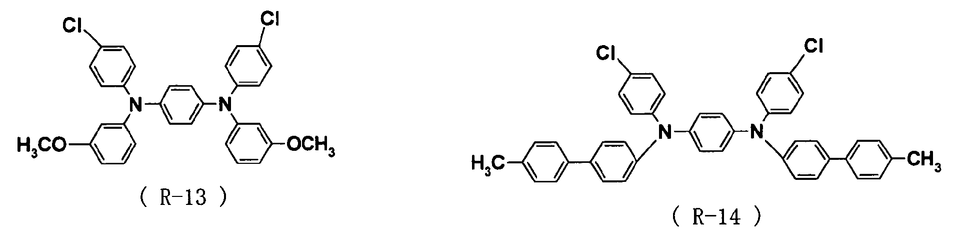

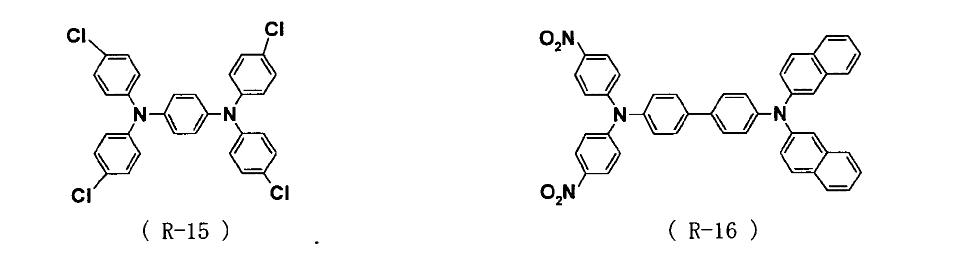

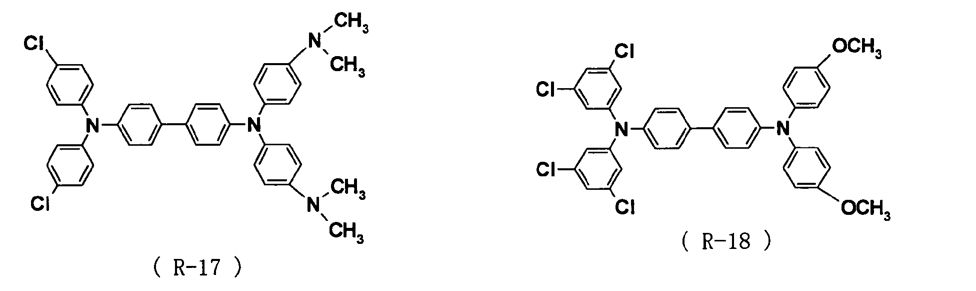

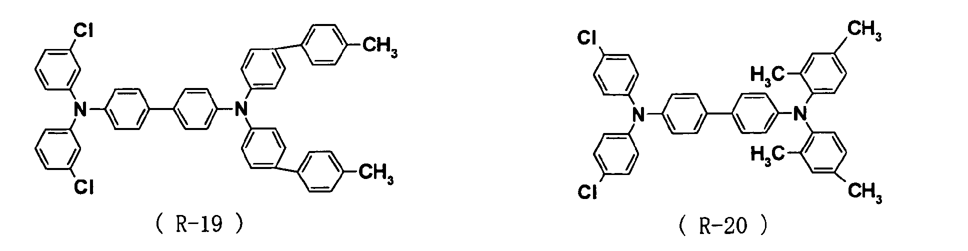

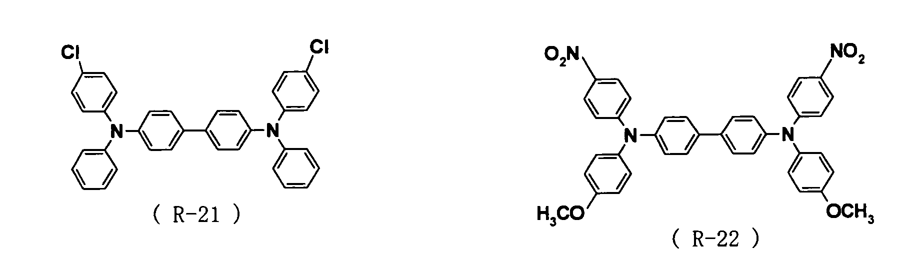

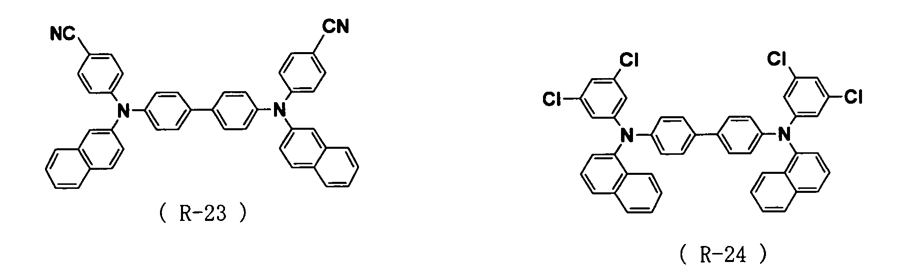

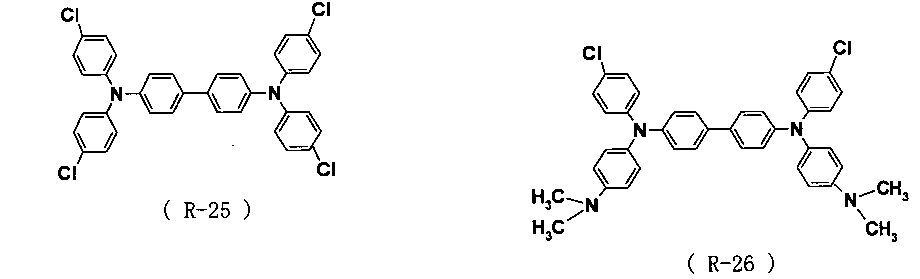

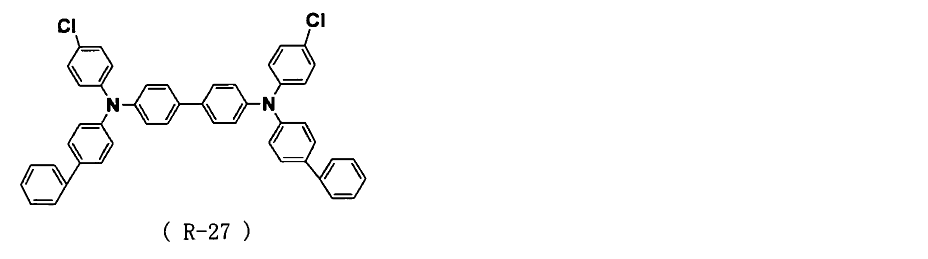

The above organic bistable material is preferably incorporated in a form of thin film, a bistable material layer 30, such that an electrode layer 21a, the bistable material layer 30 and an electrode layer 21b are formed in order on a substrate 10. As the method for forming thin films, for the electrode layers 21a and 21b, conventional known methods such as a vapor deposition method are preferably used, and the forming method is not limited thereto.

Further, as the method for forming the bistable material layer 30, methods for preparing an organic film such as a spin coating method, an electrolytic polymerization method, a chemical vapor deposition (CVD) method and a Langmuir-Blodgett method, which is well known as a method to form mono-layer molecular films (LB method), may be mentioned. Although the formation method is not limited thereto, it is preferred to use the vapor deposition method where the same forming method as for the above electrode layers can be used.

The temperature of the substrate at the time of deposition can appropriately be selected depending upon the electrode material and the bistable material to be used. However, for the formation of the electrode layers 21a and 21b, 0 to 150°C is preferred, and for the formation of the bistable material layer 30, 0 to 100°C is preferred.

Further, the film of each layer is preferably 50 to 200 nm in thickness for the electrode layers 21a and 21b, and 20 to 150 nm in thickness for the bistable material layer 30.

The mechanism by which the switching element of the present invention obtainable by the above preparation method exhibits the characteristic of bistablity is unknown. However, from the mechanism in conventional two-component system material, the following is presumed. Namely, a mechanism is presumed wherein an electron-donating functional group of one molecule and an electron-accepting functional group of another molecule, both of the molecules being adjacent to each other, play together an equivalent roll of two-component system seen in conventional materials, so as to form a columnar structure and convert the material to a conductor.

It is explainable, by such mechanism where a single molecular is capable of functioning both as a donor and as an acceptor, intrinsically without any discrepancy in the compositional ratio of functional groups, that the characteristic of bistablity can be stably attained.

Fig.2 shows another embodiment of the switching element of the present invention. This embodiment is different from the above embodiment of Fig.1 in that another third electrode 22 is provided in the bistable material layer 30 to form a three-terminal element. By this embodiment, while the electrode layers 21a and 21b are used as electrodes through which a current is flown such that the bias Vb explained in Fig. 41 is applied thereto, the third electrode 22 is used as an electrode for controlling the state of electric resistance of the bistable material layer 30, where either low threshold voltage Vth1 or high threshold voltage Vth2 explained in Fig. 41 can be applied thereto.

Further, Fig.3 shows still another embodiment of the switching element of the present invention. In this embodiment, four-terminal element is formed wherein an insulating layer 41 is formed on a second electrode layer 23; and on the insulating layer 41, a bistable material layer 31 is formed and electrode layers 24a and 24b are formed at both sides to hold the bistable material layer 31 therebetween; and further on the bistable material layer 31, an insulating layer 42 and a fourth electrode 25 are successively formed.

In this switching element, specifically saying, for example, it can be provided that the third electrode 23 is made of a silicon substrate, the insulating layers 41 and 42 are made of metallic oxide in a form of vapor deposition film, and the electrode layers 24a and 24b and the fourth electrode 25 are made of aluminum in a form of vapor deposition film.

Then, while the bias Vb explained in Fig.41 is applied with a current flowing through the electrode layers 24a and 24b, electric field can be applied to the bistable material layer 31 with use of the third electrode 23 and the fourth electrode 25, such that the state of electric resistance of the bistable material layer 31 can be controlled.

Hereinbelow, the switching element of the present invention will be explained in more detail with reference to examples.

### EXAMPLE 1

A switching element having the structure as shown in Fig. 1 was prepared by the following manner.

On a glass substrate as a substrate 10, by a vapor deposition method, thin films were successively formed in order with aluminum as an electrode layer 21a, an aminoimidazole type compound as a bistable material layer 30 and aluminum as an electrode layer 21b, to prepare a switching element of Example 1. As the aminoimidazole type compound, a compound of the following formula (A-1) was used.

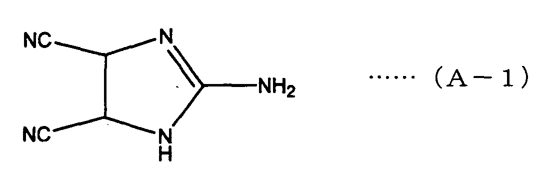

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the aminoimidazole type compound was conducted by an electrical resistance heater system at a film forming rate of 2 Å/sec. The deposition of each layer was continuously conducted by the same deposition apparatus under such condition that the sample did not contact air during the deposition.

### EXAMPLE 2

A switching element of Example 2 was obtained under the same conditions as in Example 1, provided that films of the electrode layer 21a, bistable material layer 30 and electrode layer 21b were formed in a thickness of 100 nm, 60 nm and 100 nm, respectively.

### EXAMPLE 3

A switching element of Example 3 was obtained under the same conditions as in Example 1, provided that a compound of the following formula (A-2) was used as the aminoimidazole type compound, and films of the electrode layer 21a, bistable material layer 30 and electrode layer 21b were formed in a thickness of 100 nm, 60 nm and 100 nm, respectively.

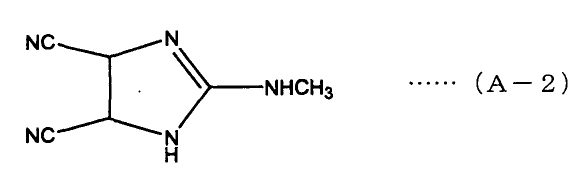

### EXAMPLE 4

A switching element of Example 4 was obtained under the same conditions as in Example 1, provided that a compound of the following formula (A-3) was used as the aminoimidazole type compound, and films of the electrode layer 21a, bistable material layer 30 and electrode layer 21b were formed in a thickness of 100 nm, 100 nm and 100 nm, respectively.

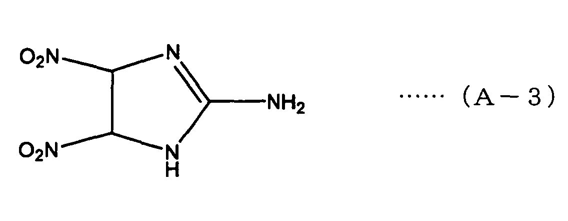

### EXAMPLE 5

A switching element of Example 5 was obtained under the same conditions as in Example 1, provided that a compound of the following formula (A-4) was used as the aminoimidazole type compound, and films of the electrode layer 21a, bistable material layer 30 and electrode layer 21b were formed in a thickness of 100 nm, 60 nm and 100 nm, respectively.

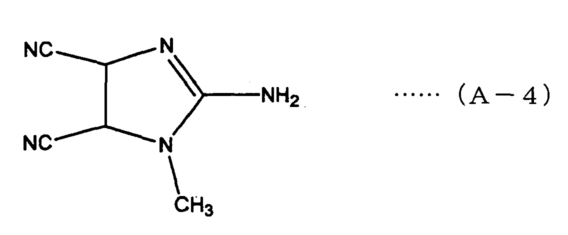

### EXPERIMENTAL EXAMPLE 1

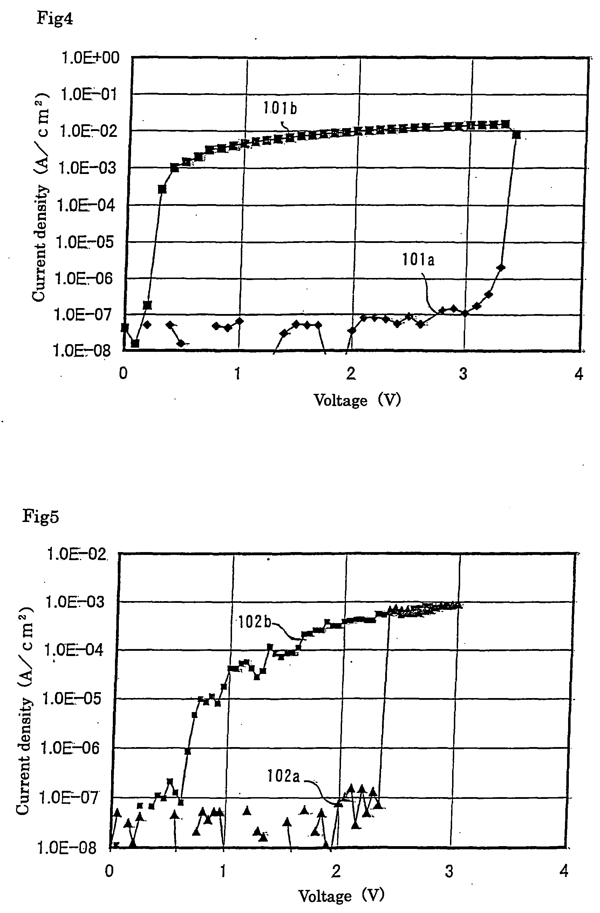

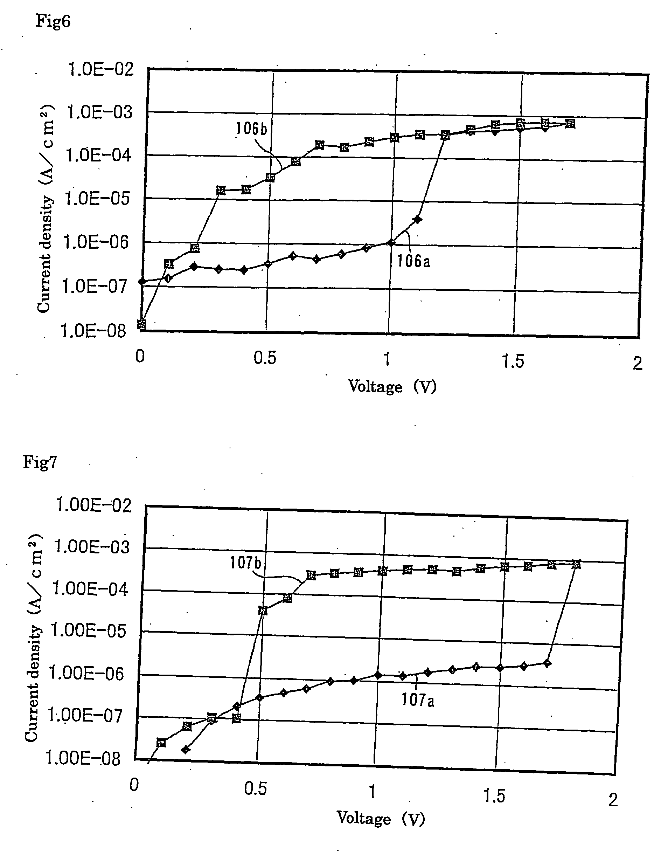

The current-voltage characteristics of the switching elements of Examples 1 to 5 were measured under a room temperature environment, and the values of threshold voltages thereof explained in Fig.41 i.e. a low threshold voltage Vth1 and a high threshold voltage Vth2, are shown in Table 1. Further, Figs.4 and 5 show the current-voltage characteristics of the switching elements of Examples 1 and 2, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 1**

| | Vth1 (V) | Vth2 (V) |
|---|---|---|
| Example 1 | 0.3 | 3.3 |
| Example 2 | 0.6 | 2.3 |
| Example 3 | 0.5 | 2.7 |
| Example 4 | 0.8 | 5.7 |
| Example 5 | 0.4 | 2.5 |

As shown in Figs.4 and 5, the switching elements of Examples 1 and 2 exhibit bistability obtained in which it was at high resistance state as represented by 101a, 102a and at low resistance state as represented by 101b, 102b, respectively.

Namely, as shown in Fig.4 and described in the current-voltage characteristics of the switching element of Example 1, when the low threshold voltage Vth1 was 0.3 V or lower, transition from a low resistance state 101b to a high resistance state 101a (from on-state to off-state) was observed, and accordingly the change of resistance value was given. When the high threshold voltage Vth2 was 3. 3 V or higher, transition from a high resistance state 101a to a low resistance state 101b (from off-state to on-state) was observed, and accordingly the change of resistance value was given. In this case, the switching element of Example 1 attained ratio of the low resistance state/high resistance state by about 10⁵.

Further, as shown in Fig.5 and described in the current-voltage characteristics of the switching element of Example 2, when the low threshold voltage Vth1 was 0.6 V or lower, transition from a low resistance state 102b to a high resistance state 102a (from on-state to off-state) was observed and the change of resistance value was given. When the high threshold voltage Vth2 was 2.3 V or higher, transition from a high resistance state 102a to a low resistance state 102b (from off-state to on-state) was observed, and accordingly the change of resistance value was given. In this case, the switching element of Example 2 attained ratio of the low resistance state/high resistance state by about 10⁴.

Further, the bistability was observed in all the switching elements of Examples 1 to 5, and the bistability state was attained such that the low threshold voltage Vth1 was 0.3 to 0.8 V and the high threshold voltage Vth2 was 2.3 to 5.7 V as shown in Table 1.

### EXAMPLE 6

A switching element having the structure as shown in Fig. 1 was prepared by the following manner.

On a glass substrate as a substrate 10, by a vapor deposition method, thin films were successively formed in order with aluminum as an electrode layer 21a, a γ-pyridone type compound as a bistable material layer 30 and aluminum as an electrode layer 21b, to prepare a switching element of Example 6. As the γ-pyridone type compound, a compound of the following formula (B-1) was used. 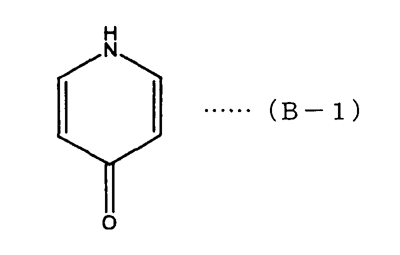 Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the γ -pyridone type compound was conducted by an electrical resistance heater system at a film forming rate of 2 Å/sec. The deposition of each layer was continuously conducted by the same deposition apparatus under such condition that the sample did not contact air during the deposition.

### EXAMPLE 7

A switching element of Example 7 was obtained under the same conditions as in Example 6, provided that a compound of the following formula (B-2) was used as the γ-pyridone type compound.

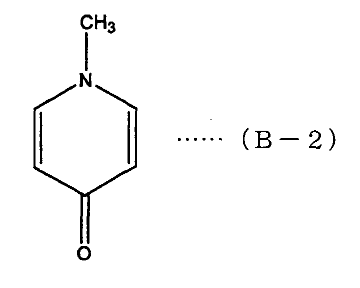

### EXPERIMENTAL EXAMPLE 2

The current-voltage characteristics of the switching elements of Examples 6 and 7, measured under a room temperature environment, are shown in Figs.6 and 7, respectively. Further, the values of threshold voltages thereof explained in Fig.41 i.e. a low threshold voltage Vth1 and a high threshold voltage Vth2, are summarized in Table 2.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 2**

| | Vth1 (V) | Vth2 (V) |
|---|---|---|
| Example 6 | 0.2 | 1.1 |
| Example 7 | 0.4 | 1.7 |

As shown in Figs. 6 and 7 or Table 2, the switching elements of Examples 6 and 7 exhibit bistability obtained in which it was at high resistance state as represented by 106a, 107a and at low resistance state as represented by 106b, 107b, respectively.

Namely, as shown in Fig.6 and described in the current-voltage characteristics of the switching element of Example 6, when the low threshold voltage Vth1 was 0.2 V or lower, transition from a low resistance state 106b to a high resistance state 106a (from on-state to off-state) was observed, and accordingly the change of resistance value was given. When the high threshold voltage Vth2 was 1. 1 V or higher, transition from a high resistance state 106a to a low resistance state 106b (from off-state to on-state) was observed, and accordingly the change of resistance value was given. In this case, the switching element of Example 6 attained ratio of the low resistance state/high resistance state by about 3x10².

Further, as shown in Fig.7 and described in the current-voltage characteristics of the switching element of Example 7, when the low threshold voltage Vth1 was 0.4 V or lower, transition from a low resistance state 107b to a high resistance state 107a (from on-state to off-state) was observed and the change of resistance value was given. When the high threshold voltage Vth2 was 1.7 V or higher, transition from a high resistance state 107a to a low resistance state 107b (from off-state to on-state) was observed, and accordingly the change of resistance value was given. In this case, the switching element of Example 7 attained ratio of the low resistance state/high resistance state by about 3x10².

### EXAMPLE 8

A switching element having the structure as shown in Fig. 1 was prepared by the following manner.

On a glass substrate as a substrate 10, by a vapor deposition method, thin films were successively formed in order with aluminum as an electrode layer 21a, an imine type compound as a bistable material layer 30 and aluminum as an electrode layer 21b, to prepare a switching element of Example 8. As the imine type compound, a compound of the following formula (C-1) was used.

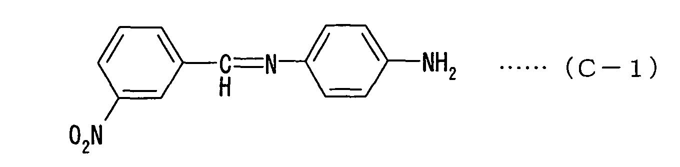

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the imine type compound was conducted by an electrical resistance heater system at a film forming rate of 2 Å/sec. The deposition of each layer was continuously conducted by the same deposition apparatus under such condition that the sample did not contact air during the deposition.

### EXAMPLE 9

A switching element of Example 9 was obtained under the same conditions as in Example 8, provided that a compound of the following formula (C-2) was used as the imine type compound.

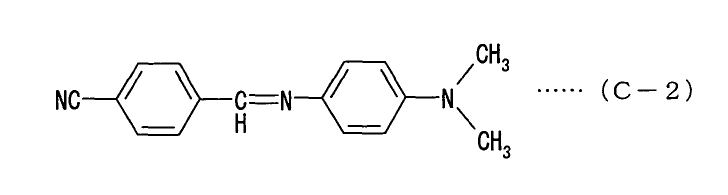

### EXAMPLE 10

A switching element of Example 10 was obtained under the same conditions as in Example 8, provided that a compound of the following formula (C-3) was used as the imine type compound.

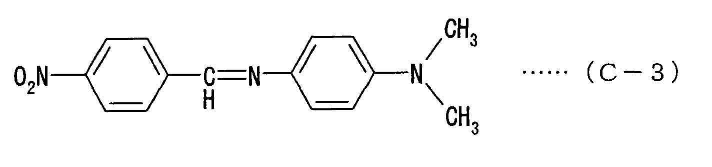

EXAMPLE 11

A switching element of Example 11 was obtained under the same conditions as in Example 8, provided that a compound of the following formula (D-1) was used as the imine type compound.

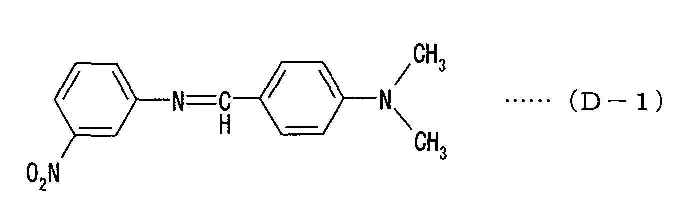

### EXAMPLE 12

A switching element of Example 12 was obtained under the same conditions as in Example 8, provided that a compound of the following formula (D-2) was used as the imine type compound.

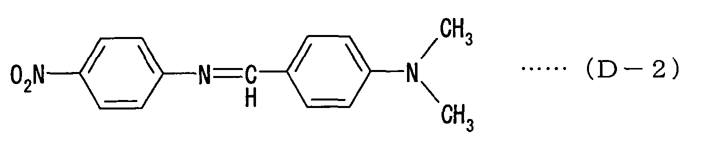

### EXAMPLE 13

A switching element of Example 13 was obtained under the same conditions as in Example 8, provided that a compound of the following formula (D-3) was used as the imine type compound.

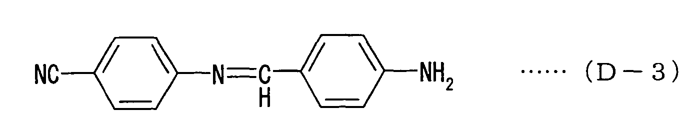

### EXPERIMENTAL EXAMPLE 3

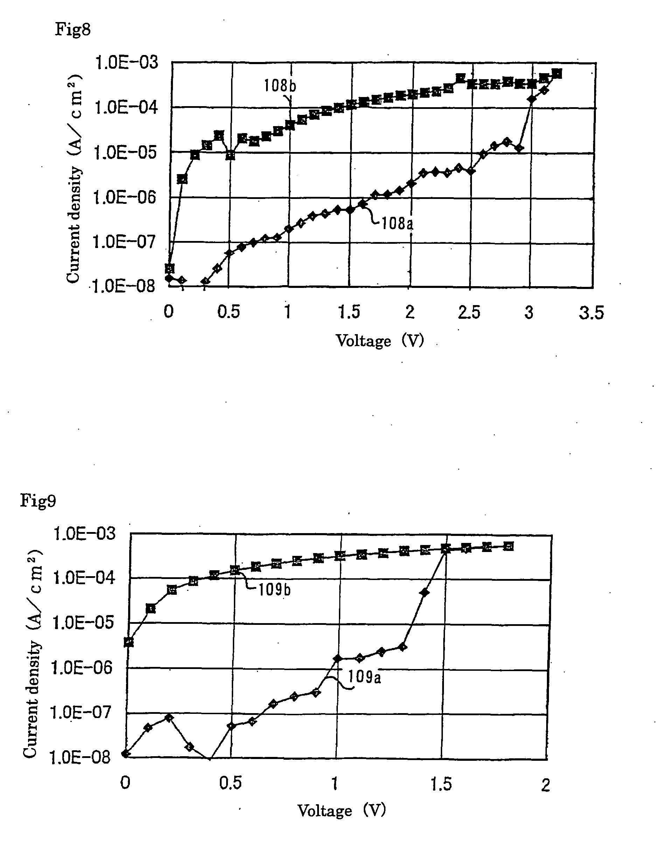

The current-voltage characteristics of the switching elements of Examples 8 to 13, measured under a room temperature environment, are shown in Figs.8 to 13, respectively. Further, the values of threshold voltages thereof explained in Fig.41 i.e. a low threshold voltage Vth1 and a high threshold voltage Vth2, are summarized in Table 3.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 3**

| | Vth1 (V) | Vth2 (V) |
|---|---|---|
| Example 8 | 0.0 | 2.9 |
| Example 9 | 0.0 | 1.3 |
| Example 10 | 0.9 | 3.1 |
| Example 11 | 0.0 | 1.6 |
| Example 12 | 0.0 | 2.4 |
| Example 13 | 1.0 | 1.9 |

As shown in Figs.8 to 13 and Table 3, the switching elements of Examples 8 to 13 exhibit bistability obtained in which it was at high resistance state as represented by 108a, 109a, 110a, 111a, 112a, 113a and at low resistance state as represented by 108b, 109b, 110b, 111b, 112b, 113b, respectively.

Namely, as shown in Fig.8 and described in the current-voltage characteristics of the switching element of Example 8, when the low threshold voltage Vth1 was 0 V or lower, transition from a low resistance state 108b to a high resistance state 108a (from on-state to off-state) was observed, and accordingly the change of resistance value was given. When the high threshold voltage Vth2 was 2. 9 V or higher, transition from a high resistance state 108a to a low resistance state 108b (from off-state to on-state) was observed, and accordingly the change of resistance value was given. In this case, the switching element of Example 8 attained ratio of the low resistance state/high resistance state by about 30.

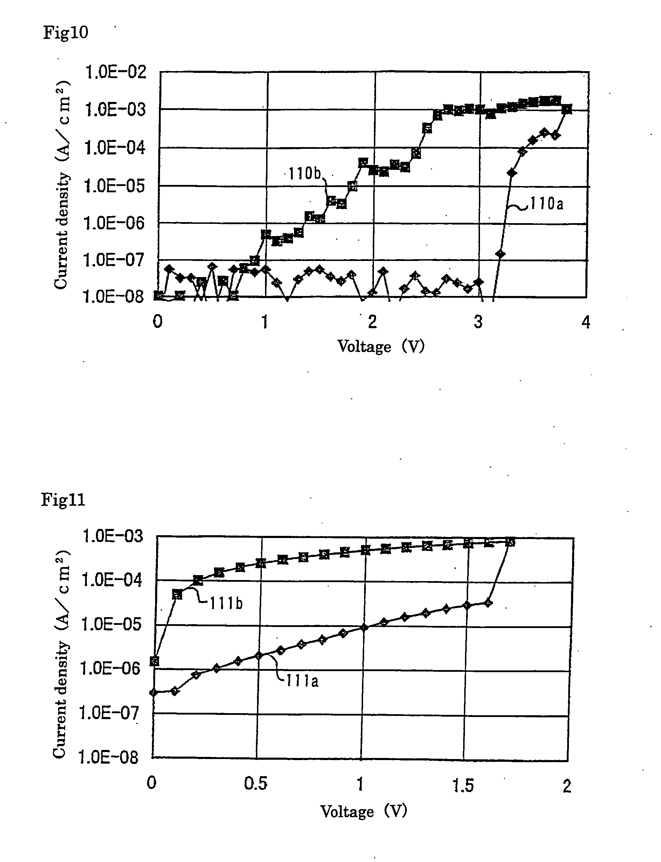

Further, as shown in Fig.9 and described in the current-voltage characteristics of the switching element of Example 9, when the low threshold voltage Vth1 was 0 V or lower, transition from a low resistance state 109b to a high resistance state 109a (from on-state to off-state) was observed and the change of resistance value was given. When the high threshold voltage Vth2 was 1.3 V or higher, transition from a high resistance state 109a to a low resistance state 109b (from off-state to on-state) was observed, and accordingly the change of resistance value was given. In this case, the switching element of Example 9 attained ratio of the low resistance state/high resistance state by about 120.

Further, as shown in Fig.10 and described in the current-voltage characteristics of the switching element of Example 10, when the low threshold voltage Vth1 was 0.9 V or lower, transition from a low resistance state 110b to a high resistance state 110a (from on-state to off-state) was observed and the change of resistance value was given. When the high threshold voltage Vth2 was 3.1 V or higher, transition from a high resistance state 110a to a low resistance state 110b (from off-state to on-state) was observed, and accordingly the change of resistance value was given. In this case, the switching element of Example 10 attained ratio of the low resistance state/high resistance state by about 10⁴.

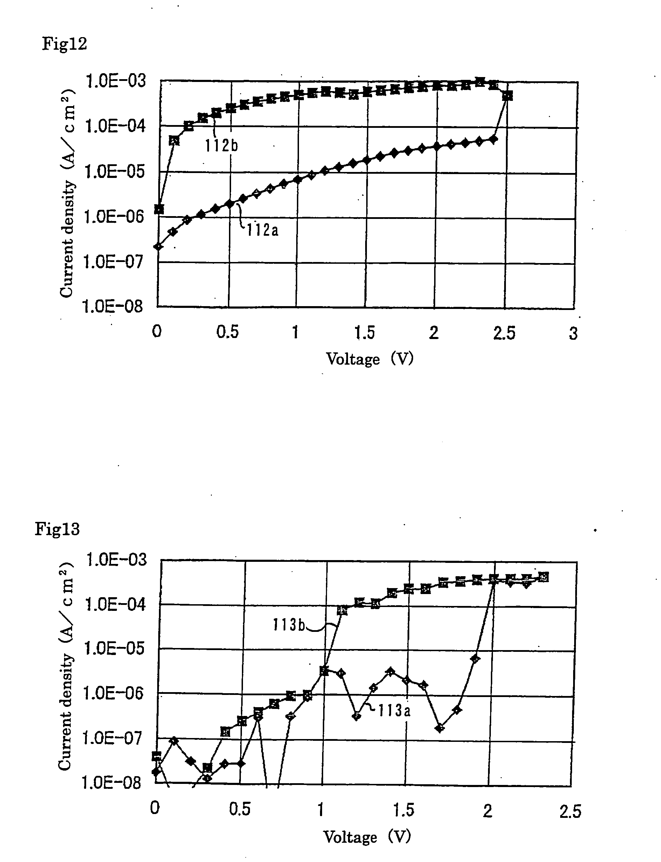

Further, as shown in Fig.11 and described in the current-voltage characteristics of the switching element of Example 11, when the low threshold voltage Vth1 was 0 V or lower, transition from a low resistance state 111b to a high resistance state 111a (from on-state to off-state) was observed and the change of resistance value was given. When the high threshold voltage Vth2 was 1.6 V or higher, transition from a high resistance state 111a to a low resistance state 111b (from off-state to on-state) was observed, and accordingly the change of resistance value was given. In this case, the switching element of Example 11 attained ratio of the low resistance state/high resistance state by about 30.

Further, as shown in Fig.12 and described in the current-voltage characteristics of the switching element of Example 12, when the low threshold voltage Vth1 was 0 V or lower, transition from a low resistance state 112b to a high resistance state 112a (from on-state to off-state) was observed and the change of resistance value was given. When the high threshold voltage Vth2 was 2.4 V or higher, transition from a high resistance state 112a to a low resistance state 112b (from off-state to on-state) was observed, and accordingly the change of resistance value was given. In this case, the switching element of Example 12 attained ratio of the low resistance state/high resistance state by about 20.

Further, as shown in Fig.13 and described in the current-voltage characteristics of the switching element of Example 13, when the low threshold voltage Vth1 was 1.0 V or lower, transition from a low resistance state 113b to a high resistance state 113a (from on-state to off-state) was observed and the change of resistance value was given. When the high threshold voltage Vth2 was 1.9 V or higher, transition from a high resistance state 113a to a low resistance state 113b (from off-state to on-state) was observed, and accordingly the change of resistance value was given. In this case, the switching element of Example 13 attained ratio of the low resistance state/high resistance state by about 300.

### EXAMPLE 14

A switching element having the structure as shown in Fig. 1 was prepared by the following manner.

On a glass substrate as a substrate 10, by a vapor deposition method, thin films were successively formed in order with aluminum as an electrode layer 21a, a compound of the following formula (E-1) as a bistable material layer 30 and aluminum as an electrode layer 21b, to prepare a switching element of Example 14.

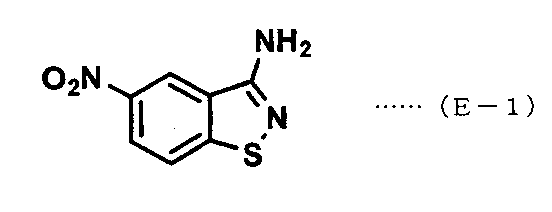

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the compound of the formula (E-1) was conducted by an electrical resistance heater system at a film forming rate of 2 Å/sec. The deposition of each layer was continuously conducted by the same deposition apparatus under such condition that the sample did not contact air during the deposition.

### EXAMPLE 15

A switching element of Example 15 was obtained under the same conditions as in Example 14, provided that a compound of the following formula (E-2) was used for the bistable material layer 30.

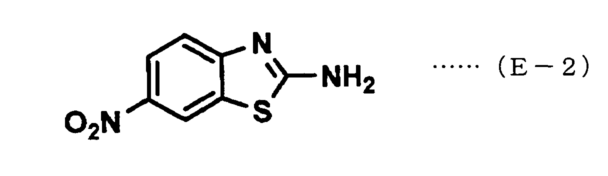

### EXPERIMENTAL EXAMPLE 4

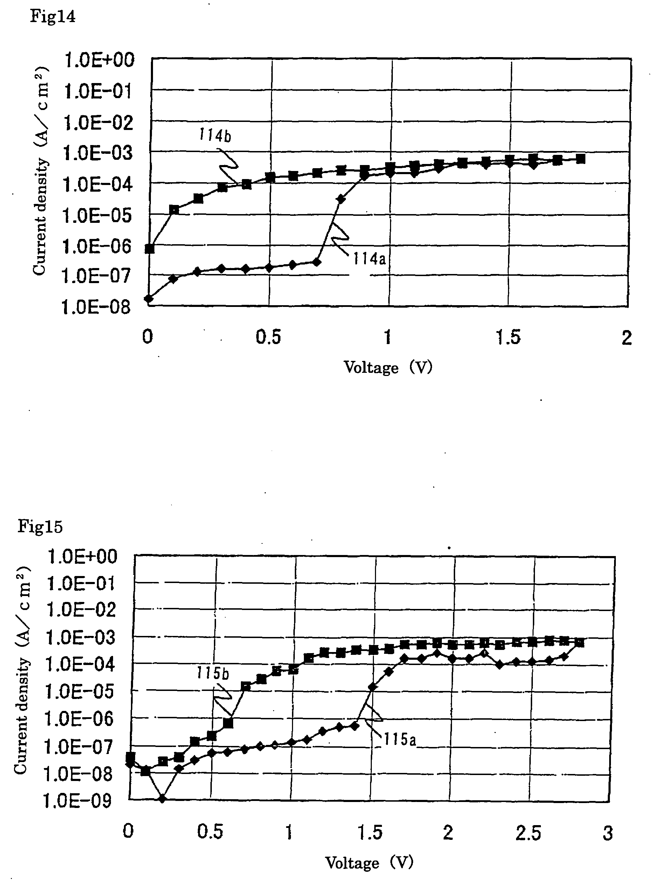

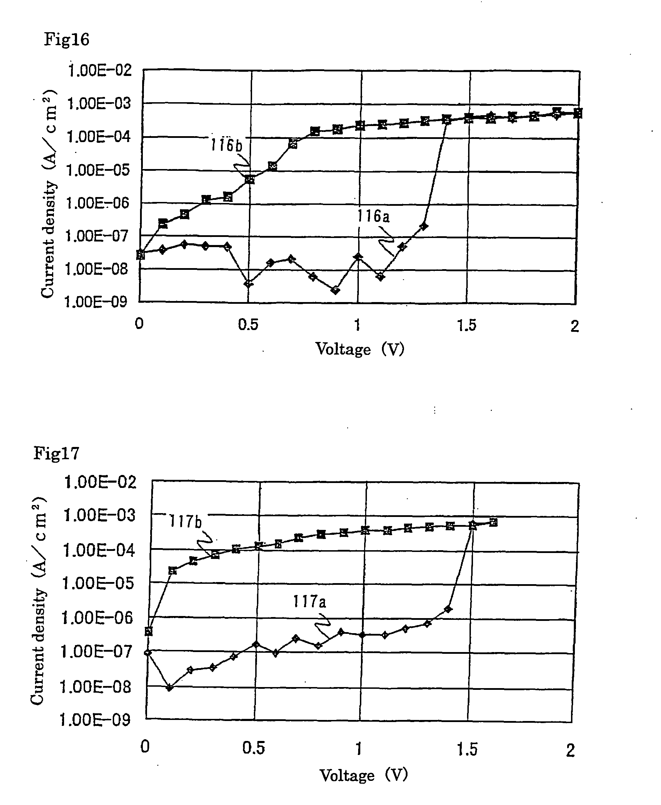

The current-voltage characteristics of the switching elements of Examples 14 and 15, measured under a room temperature environment, are shown in Figs.14 and 15, respectively. Further, the values of threshold voltages thereof explained in Fig.41 i.e. a low threshold voltage Vth1 and a high threshold voltage Vth2, are summarized in Table 4.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 4**

| | Vth1 (V) | Vth2 (V) |
|---|---|---|
| Example 14 | 0.0 | 0.7 |
| Example 15 | 0.6 | 1.4 |

As shown in Figs.14 and 15 or Table 4, the switching elements of Examples 14 and 15 exhibit bistability obtained in which it was at high resistance state as represented by 114a, 115a and at low resistance state as represented by 114b, 115b, respectively.

Namely, as shown in Fig.14 and described in the current-voltage characteristics of the switching element of Example 14, when the low threshold voltage Vth1 was 0 V or lower, transition from a low resistance state 114b to a high resistance state 114a (from on-state to off-state) was observed, and accordingly the change of resistance value was given. When the high threshold voltage Vth2 was 0.7 V or higher, transition from a high resistance state 114a to a low resistance state 114b (from off-state to on-state) was observed, and accordingly the change of resistance value was given. In this case, the switching element of Example 14 attained ratio of the low resistance state/high resistance state by about 10³.

Further, as shown in Fig.15 and described in the current-voltage characteristics of the switching element of Example 15, when the low threshold voltage Vth1 was 0.6 V or lower, transition from a low resistance state 115b to a high resistance state 115a (from on-state to off-state) was observed, and accordingly the change of resistance value was given. When the high threshold voltage Vth2 was 1.4 V or higher, transition from a high resistance state 115a to a low resistance state 115b (from off-state to on-state) was observed, and accordingly the change of resistance value was given. In this case, the switching element of Example 15 attained ratio of the low resistance state/high resistance state by about 10³.

### EXAMPLE 16

A switching element having the structure as shown in Fig.1 was prepared by the following manner.

On a glass substrate as a substrate 10, by a vapor deposition method, thin films were successively formed in order with aluminum as an electrode layer 21a, a compound of the following formula (F-1) (manufactured by Sigma Aldrich Japan Co.,Ltd.; Product No. 34679-9) as a bistable material layer 30 and aluminum as an electrode layer 21b, to prepare a switching element of Example 16.

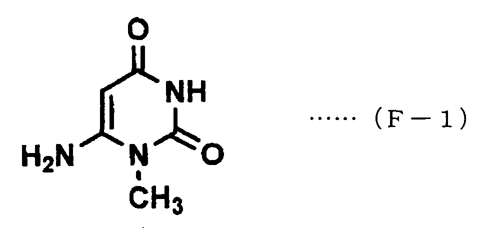

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the compound of the formula (F-1) was conducted by an electrical resistance heater system at a film forming rate of 2 Å/sec. The deposition of each layer was continuously conducted by the same deposition apparatus under such condition that the sample did not contact air during the deposition.

### EXAMPLE 17

A switching element of Example 17 was obtained under the same conditions as in Example 16, provided that a compound of the following formula (F-2) (manufactured by Sigma Aldrich Japan Co.,Ltd.; Product No. A5215-3) was used for the bistable material layer 30.

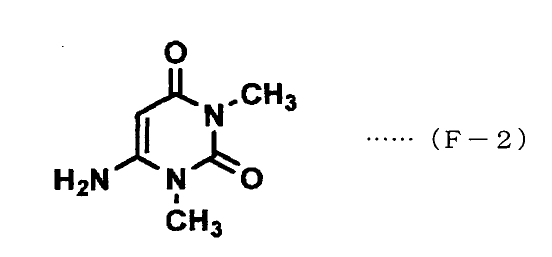

### EXAMPLE 18

A switching element of Example 18 was obtained under the same conditions as in Example 16, provided that a compound of the following formula (F-3) (manufactured by Sigma Aldrich Japan Co.,Ltd.; Product No. 85528-6) was used for the bistable material layer 30.

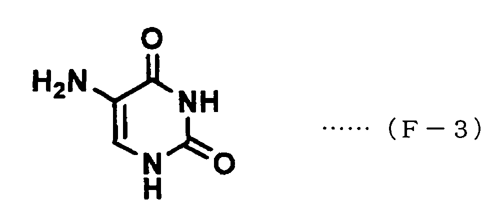

### EXPERIMENTAL EXAMPLE 5

The current-voltage characteristics of the switching elements of Examples 16 to 18, measured under a room temperature environment, are shown in Figs.16 to 18, respectively. Further, the values of threshold voltages thereof explained in Fig.41 i.e. a low threshold voltage Vth1 and a high threshold voltage Vth2, are summarized in Table 5.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 5**

| | Vth1 (V) | Vth2 (V) |
|---|---|---|
| Example 16 | 0.0 | 1.3 |
| Example 17 | 0.0 | 1.4 |
| Example 18 | 0.0 | 1.3 |

As shown in Figs.16 to 18 and Table 5, the switching elements of Examples 16 to 18 exhibit bistability obtained in which it was at high resistance state as represented by 116a, 117a, 118a and at low resistance state as represented by 116b, 117b, 118b, respectively.

Namely, as shown in Fig.16 and described in the current-voltage characteristics of the switching element of Example 16, when the low threshold voltage Vth1 was 0 V or lower, transition from a low resistance state 116b to a high resistance state 116a (from on-state to off-state) was observed, and accordingly the change of resistance value was given. When the high threshold voltage Vth2 was 1.3 V or higher, transition from a high resistance state 116a to a low resistance state 116b (from off-state to on-state) was observed, and accordingly the change of resistance value was given. In this case, the switching element of Example 16 attained ratio of the low resistance state/high resistance state by about 3x10⁴.

Further, as shown in Fig.17 and described in the current-voltage characteristics of the switching element of Example 17, when the low threshold voltage Vth1 was 0 V or lower, transition from a low resistance state 117b to a high resistance state 117a (from on-state to off-state) was observed, and accordingly the change of resistance value was given. When the high threshold voltage Vth2 was 1.4 V or higher, transition from a high resistance state 117a to a low resistance state 117b (from off-state to on-state) was observed, and accordingly the change of resistance value was given. In this case, the switching element of Example 17 attained ratio of the low resistance state/high resistance state by about 3x10².

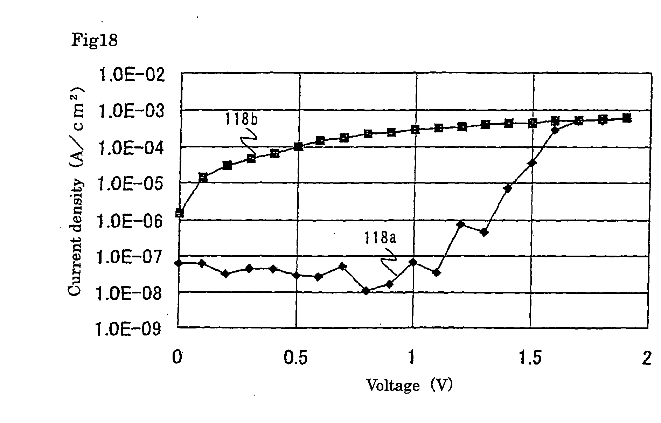

Further, as shown in Fig.18 and described in the current-voltage characteristics of the switching element of Example 18, when the low threshold voltage Vth1 was 0 V or lower, transition from a low resistance state 118b to a high resistance state 118a (from on-state to off-state) was observed, and accordingly the change of resistance value was given. When the high threshold voltage Vth2 was 1. 3 V or higher, transition from a high resistance state 118a to a low resistance state 118b (from off-state to on-state) was observed, and accordingly the change of resistance value was given. In this case, the switching element of Example 18 attained ratio of the low resistance state/high resistance state by about 10³.

### EXAMPLE 19

A switching element having the structure as shown in Fig.1 was prepared by the following manner.

On a glass substrate as a substrate 10, by a vapor deposition method, thin films were successively formed in order with aluminum as an electrode layer 21a, a compound of the following formula (G-1) (manufactured by Sigma Aldrich Japan Co.,Ltd.; Product No. 24,772-3) as a bistable material layer 30 and aluminum as an electrode layer 21b, to prepare a switching element of Example 19.

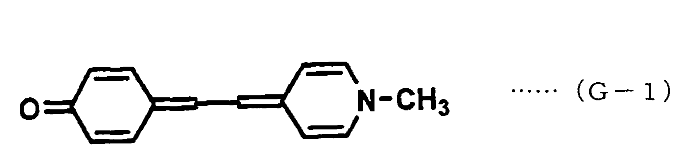

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of compound of the formula (G-1) was conducted by an electrical resistance heater system at a film forming rate of 2 Å/sec. The deposition of each layer was continuously conducted by the same deposition apparatus under such condition that the sample did not contact air during the deposition.

EXAMPLE 20

A switching element of Example 20 was obtained under the same conditions as in Example 19, provided that a compound of the following formula (G-2) was used for the bistable material layer, and films of the electrode layer 21a, bistable material layer 30 and electrode layer 21b were formed in a thickness of 100 nm, 80 nm and 100 nm, respectively.

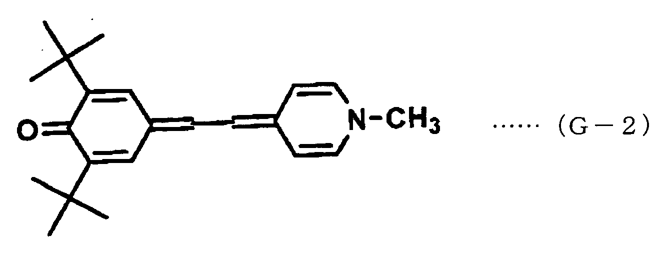

The compound of the formula (G-2) was synthesized by the following procedure.

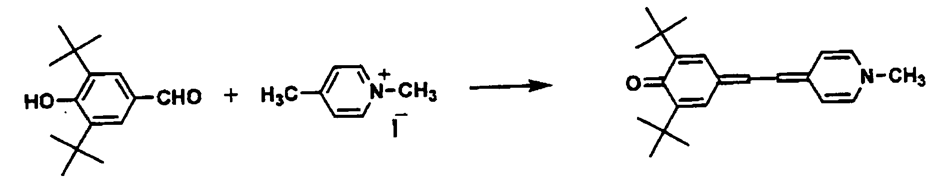

Namely, 9.7g of 1,4-dimethylpyridinium iodide, 9.3g of 3,5-di-t-butyl-4-hydroxybenzaldehyde and 3.7g of piperidine were dissolved in 100 ml of ethanol, and then reflux was carried out at the boiling point of the solvent for 20 hours. After cooling to room temperature, precipitates were collected by filtration and suspended in 250 ml of a 0.2M KOH aqueous solution, followed by stirring under heating at 70°C. The precipitates were collected by filtration and washed with pure water and ethanol. Recrystallization was carried out with butanol to obtain 8.4g (65%) of greenish plate-like crystals.

### EXPERIMENTAL EXAMPLE 6

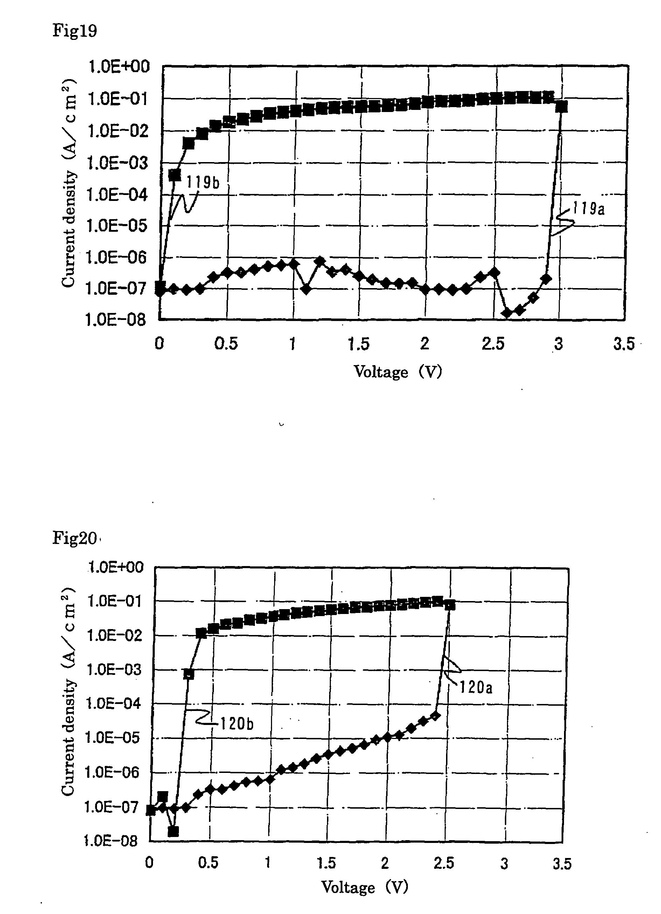

The current-voltage characteristics of the switching elements of Examples 19 and 20, measured under a room temperature environment, are shown in Figs.19 and 20, respectively. Further, the values of threshold voltages thereof explained in Fig.41 i.e. a low threshold voltage Vth1 and a high threshold voltage Vth2, are summarized in Table 6.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 6**

| | Vth1 (V) | Vth2 (V) |
|---|---|---|
| Example 19 | 0.0 | 2.9 |
| Example 20 | 0.2 | 2.4 |

As shown in Figs.19 and 20 or Table 6, the switching elements of Examples 19 and 20 exhibit bistability obtained in which it was at high resistance state as represented by 119a, 120a and at low resistance state as represented by 119b, 120b, respectively.

Namely, as shown in Fig.19 and described in the current-voltage characteristics of the switching element of Example 19, when the low threshold voltage Vth1 was 0 V or lower, transition from a low resistance state 119b to a high resistance state 119a (from on-state to off-state) was observed, and accordingly the change of resistance value was given. When the high threshold voltage Vth2 was 2. 9 V or higher, transition from a high resistance state 119a to a low resistance state 119b (from off-state to on-state) was observed, and accordingly the change of resistance value was given. In this case, the switching element of Example 19 attained ratio of the low resistance state/high resistance state by about 10⁶.

Further, as shown in Fig.20 and described in the current-voltage characteristics of the switching element of Example 20, when the low threshold voltage Vth1 was 0.2 V or lower, transition from a low resistance state 120b to a high resistance state 120a (from on-state to off-state) was observed, and accordingly the change of resistance value was given. When the high threshold voltage Vth2 was 2.4 V or higher, transition from a high resistance state 120a to a low resistance state 120b (from off-state to on-state) was observed, and accordingly the change of resistance value was given. In this case, the switching element of Example 20 attained ratio of the low resistance state/high resistance state by about 2x10³.

### EXAMPLE 21

A switching element having the structure as shown in Fig. 1 was prepared by the following manner.

On a glass substrate as a substrate 10, by a vapor deposition method, thin films were successively formed in order with aluminum as an electrode layer 21a, an iminequinone type compound as a bistable material layer 30 and aluminum as an electrode layer 21b, to prepare a switching element of Example 21. As the iminequinone type compound, a compound of the following formula (H-1) was used.

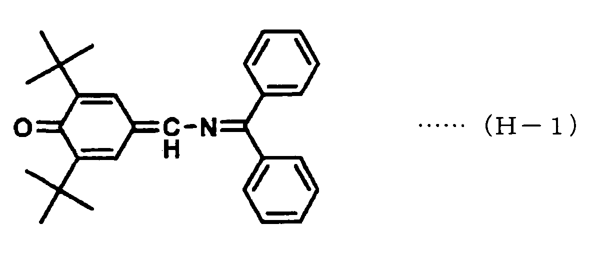

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the iminequinone type compound was conducted by an electrical resistance heater system at a film forming rate of 2 Å/sec. The deposition of each layer was continuously conducted by the same deposition apparatus under such condition that the sample did not contact air during the deposition.

### EXAMPLE 22

A switching element of Example 22 was obtained under the same conditions as in Example 21, provided that films of the electrode layer 21a, bistable material layer 30 and electrode layer 21b were formed in a thickness of 100 nm, 60 nm and 100 nm, respectively.

### EXAMPLE 23

A switching element of Example 23 was obtained under the same conditions as in Example 21, provided that a compound of the following formula (H-2) was used as the iminequinone type compound, and films of the electrode layer 21a, bistable material layer 30 and electrode layer 21b were formed in a thickness of 100 nm, 60 nm and 100 nm, respectively.

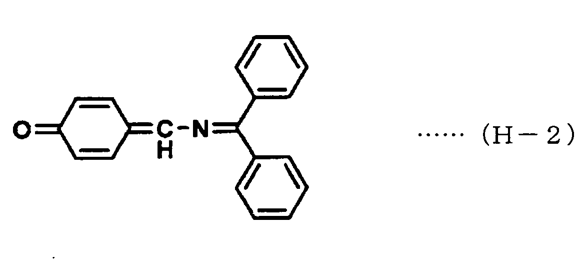

### EXAMPLE 24

A switching element of Example 24 was obtained under the same conditions as in Example 21, provided that a compound of the following formula (H-3) was used as the iminequinone type compound, and films of the electrode layer 21a, bistable material layer 30 and electrode layer 21b were formed in a thickness of 100 nm, 100 nm and 100 nm, respectively.

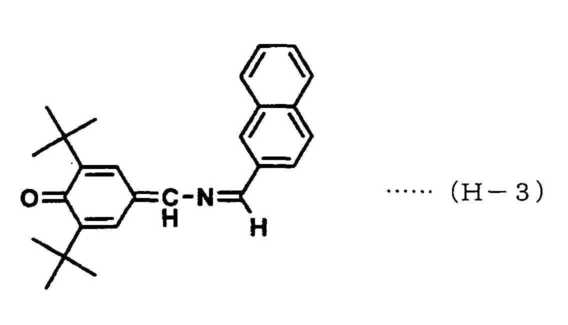

### EXAMPLE 25

A switching element of Example 25 was obtained under the same conditions as in Example 21, provided that a compound of the following formula (H-4) was used as the iminequinone type compound, and films of the electrode layer 21a, bistable material layer 30 and electrode layer 21b were formed in a thickness of 100 nm, 60 nm and 100 nm, respectively.

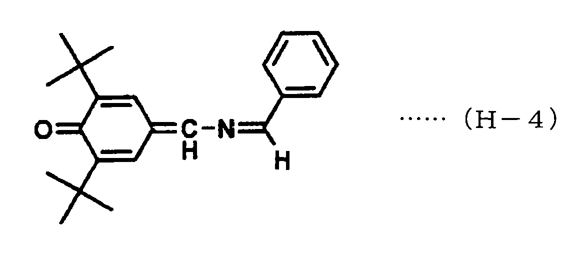

### EXPERIMENTAL EXAMPLE 7

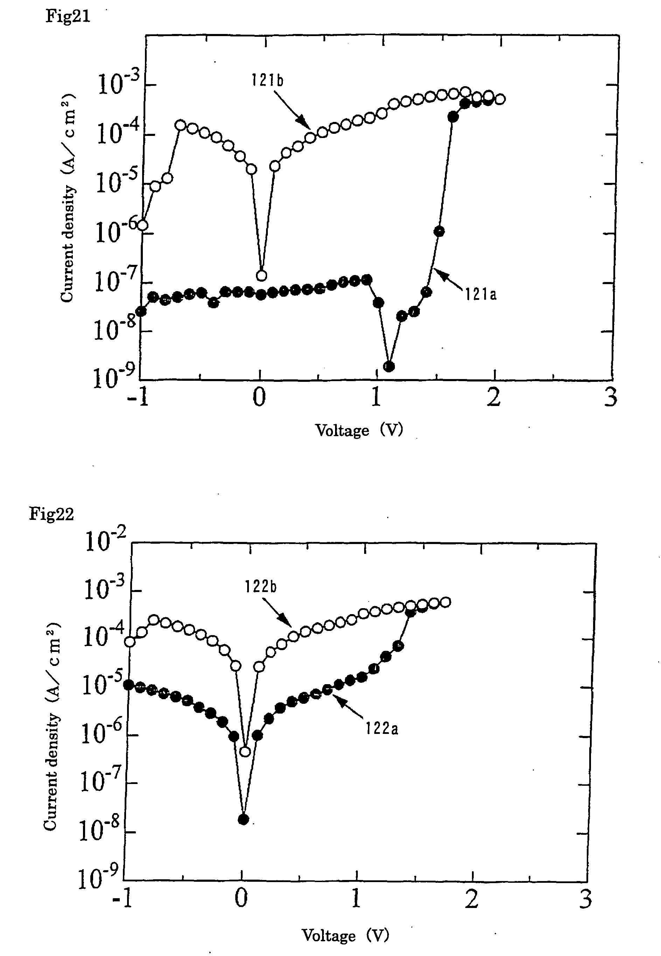

The current-voltage characteristics of the switching elements of Examples 21 to 25 were measured under a room temperature environment, and the values of threshold voltages thereof explained in Fig.41 i.e. a low threshold voltage Vth1 and a high threshold voltage Vth2, are shown in Table 7. Further, Figs.21 and 22 show the current-voltage characteristics of the switching elements of Examples 21 and 22, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 7**

| | Vth1 (V) | Vth2 (V) |
|---|---|---|
| Example 21 | -0.8 | 1.6 |
| Example 22 | -0.9 | 1.3 |
| Example 23 | -0.3 | 1.3 |
| Example 24 | -1.1 | 2.5 |
| Example 25 | -0.9 | 1.8 |

As shown in Figs.21 and 22, the switching elements of Examples 21 and 22 exhibit bistability obtained in which it was at high resistance state as represented by 121a, 122a and at low resistance state as represented by 121b, 122b, respectively.

Namely, as shown in Fig.21 and described in the current-voltage characteristics of the switching element of Example 21, when the low threshold voltage Vth1 was -0.8 V or lower, transition from a low resistance state 121b to a high resistance state 121a (from on-state to off-state) was observed, and accordingly the change of resistance value was given. When the high threshold voltage Vth2 was 1. 6 V or higher, transition from a high resistance state 121a to a low resistance state 121b (from off-state to on-state) was observed, and accordingly the change of resistance value was given. In this case, the switching element of Example 21 attained ratio of the low resistance state/high resistance state by about 10³.

Further, as shown in Fig.22 and described in the current-voltage characteristics of the switching element of Example 22, when the low threshold voltage Vth1 was -0.9 V or lower, transition from a low resistance state 122b to a high resistance state 122a (from on-state to off-state) was observed and the change of resistance value was given. When the high threshold voltage Vth2 was 1.3 V or higher, transition from a high resistance state 122a to a low resistance state 122b (from off-state to on-state) was observed, and accordingly the change of resistance value was given. In this case, the switching element of Example 22 attained ratio of the low resistance state/high resistance state by about 30.

Further, the bistability was observed in all the switching elements of Examples 21 to 25, and the bistability state was attained such that the low threshold voltage Vth1 was -0.3 to -1.1 V and the high threshold voltage Vth2 was 1.3 to 2.5 V as shown in Table 7.

### EXAMPLE 26

A switching element having the structure as shown in Fig.1 was prepared by the following manner.

On a glass substrate as a substrate 10, by a vapor deposition method, thin films were successively formed in order with aluminum as an electrode layer 21a, an iminequinone type compound as a bistable material layer 30 and aluminum as an electrode layer 21b, to prepare a switching element of Example 26. As the iminequinone type compound, a compound of the following formula (H'-3) was used.

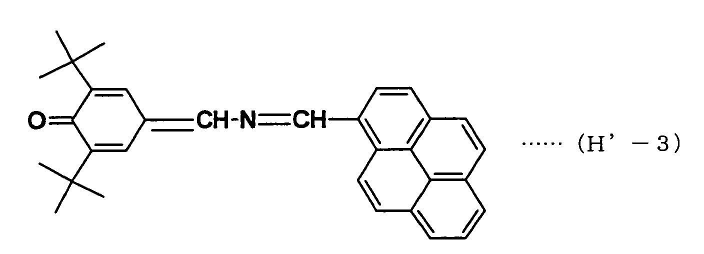

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the iminequinone type compound was conducted by an electrical resistance heater system at a film forming rate of 2 Å/sec. The deposition of each layer was continuously conducted by the same deposition apparatus under such condition that the sample did not contact air during the deposition.

### EXAMPLE 27

A switching element of Example 27 was obtained under the same conditions as in Example 26, provided that a compound of the following formula (H'-4) was used as the iminequinone type compound, and films of the electrode layer 21a, bistable material layer 30 and electrode layer 21b were formed in a thickness of 100 nm, 80 nm and 100 nm, respectively.

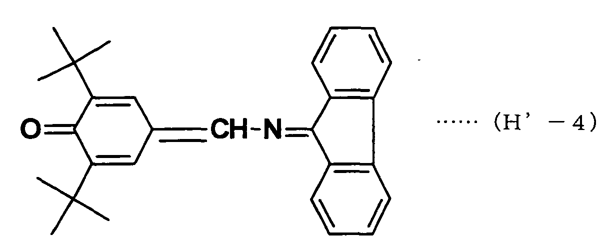

### EXAMPLE 28

A switching element of Example 28 was obtained under the same conditions as in Example 26, provided that a compound of the following formula (H'-6) was used as the iminequinone type compound, and films of the electrode layer 21a, bistable material layer 30 and electrode layer 21b were formed in a thickness of 100 nm, 80 nm and 100 nm, respectively.

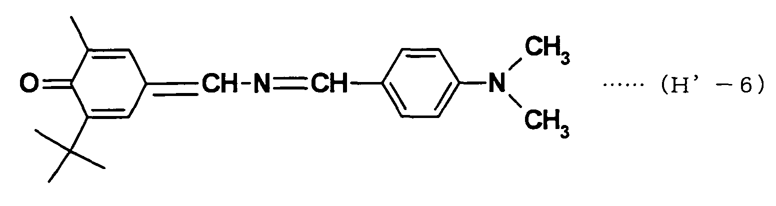

### EXPERIMENTAL EXAMPLE 8

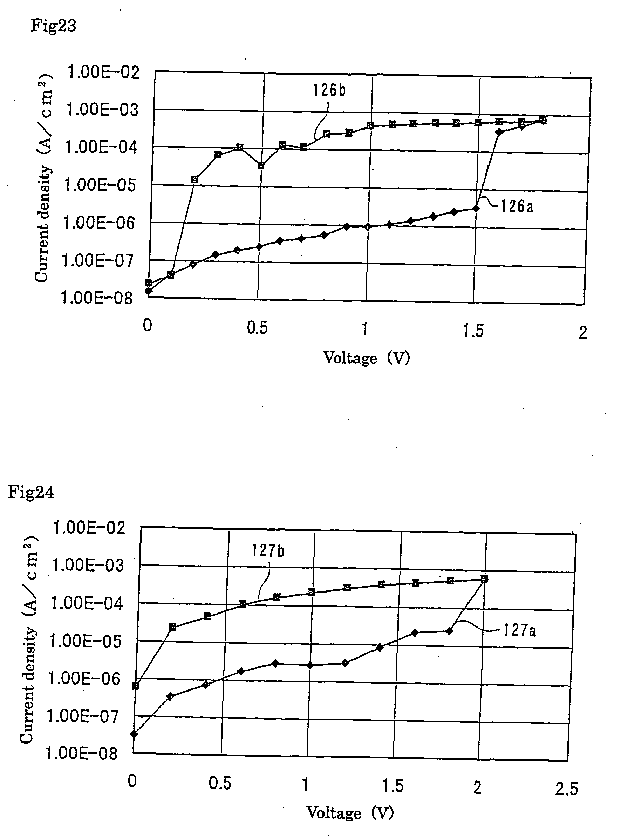

The current-voltage characteristics of the switching elements of Examples 26 to 28 were measured under a room temperature environment, and the values of threshold voltages thereof explained in Fig.41 i.e. a low threshold voltage Vth1 and a high threshold voltage Vth2, are shown in Table 8. Further, Figs.23 and 24 show the current-voltage characteristics of the switching elements of Examples 26 and 27, respectively.

**Table 8**

| | Vth1 (V) | Vth2 (V) |
|---|---|---|
| Example 26 | 0.1 | 1.5 |
| Example 27 | -0.6 | 2.0 |
| Example 28 | -0.5 | 1.8 |

As shown in Figs.23 and 24, the switching elements of Examples 26 and 27 exhibit bistability obtained in which it was at high resistance state as represented by 126a, 127a and at low resistance state as represented by 126b, 127b, respectively.

Namely, as shown in Fig.23 and described in the current-voltage characteristics of the switching element of Example 26, when the low threshold voltage Vth1 was 0.1 V or lower, transition from a low resistance state 126b to a high resistance state 126a (from on-state to off-state) was observed, and accordingly the change of resistance value was given. When the high threshold voltage Vth2 was 1.5 V or higher, transition from a high resistance state 126a to a low resistance state 126b (from off-state to on-state) was observed, and accordingly the change of resistance value was given. In this case, the switching element of Example 26 attained ratio of the low resistance state/high resistance state by about 3x10².

Further, as shown in Fig.24 and described in the current-voltage characteristics of the switching element of Example 27, when the low threshold voltage Vth1 was -0.6 V or lower, transition from a low resistance state 127b to a high resistance state 127a (from on-state to off-state) was observed, and accordingly the change of resistance value was given. When the high threshold voltage Vth2 was 2.0 V or higher, transition from a high resistance state 127a to a low resistance state 127b (from off-state to on-state) was observed, and accordingly the change of resistance value was given. In this case, the switching element of Example 27 attained ratio of the low resistance state/high resistance state by about 10².

Further, the bistability was observed in all the switching elements of Examples 26 to 28, and the bistability state was attained such that the low threshold voltage Vth1 was 0.1 to -0.6 V and the high threshold voltage Vth2 was 1.5 to 2.0 V as shown in Table 8.

### EXAMPLE 29

A switching element having the structure as shown in Fig. 1 was prepared by the following manner.

On a glass substrate as a substrate 10, by a vapor deposition method, thin films were successively formed in order with aluminum as an electrode layer 21a, a quinoneimine type compound as a bistable material layer 30 and aluminum as an electrode layer 21b, to prepare a switching element of Example 29. As the quinoneimine type compound, a compound of the following formula (I-1) was used.

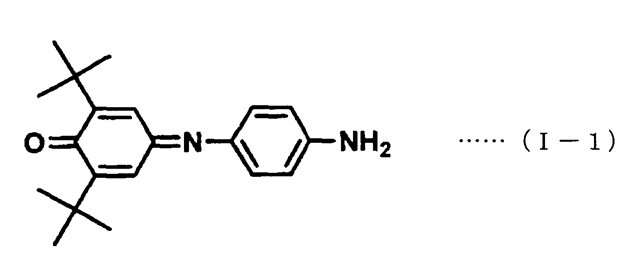

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the quinoneimine type compound was conducted by an electrical resistance heater system at a film forming rate of 2 Å/sec. The deposition of each layer was continuously conducted by the same deposition apparatus under such condition that the sample did not contact air during the deposition.

### EXAMPLE 30

A switching element of Example 30 was obtained under the same conditions as in Example 29, provided that films of the electrode layer 21a, bistable material layer 30 and electrode layer 21b were formed in a thickness of 100 nm, 60 nm and 100 nm, respectively.

### EXAMPLE 31

A switching element of Example 31 was obtained under the same conditions as in Example 29, provided that a compound of the following formula (I-2) was used as the quinoneimine type compound, and films of the electrode layer 21a, bistable material layer 30 and electrode layer 21b were formed in a thickness of 100 nm, 60 nm and 100 nm, respectively.

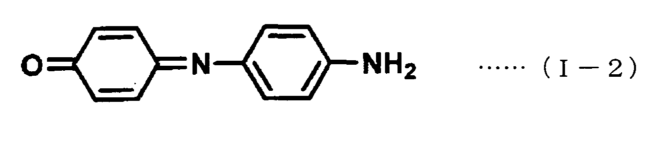

### EXAMPLE 32

A switching element of Example 32 was obtained under the same conditions as in Example 29, provided that a compound of the following formula (I-3) was used as the quinoneimine type compound, and films of the electrode layer 21a, bistable material layer 30 and electrode layer 21b were formed in a thickness of 100 nm, 100 nm and 100 nm, respectively.

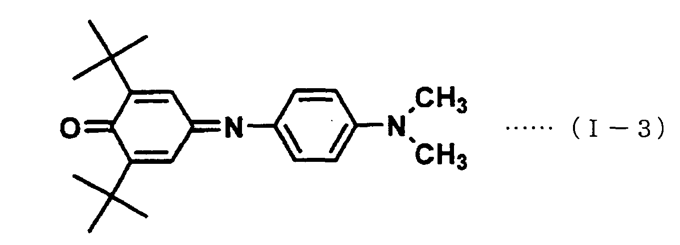

### EXPERIMENTAL EXAMPLE 9

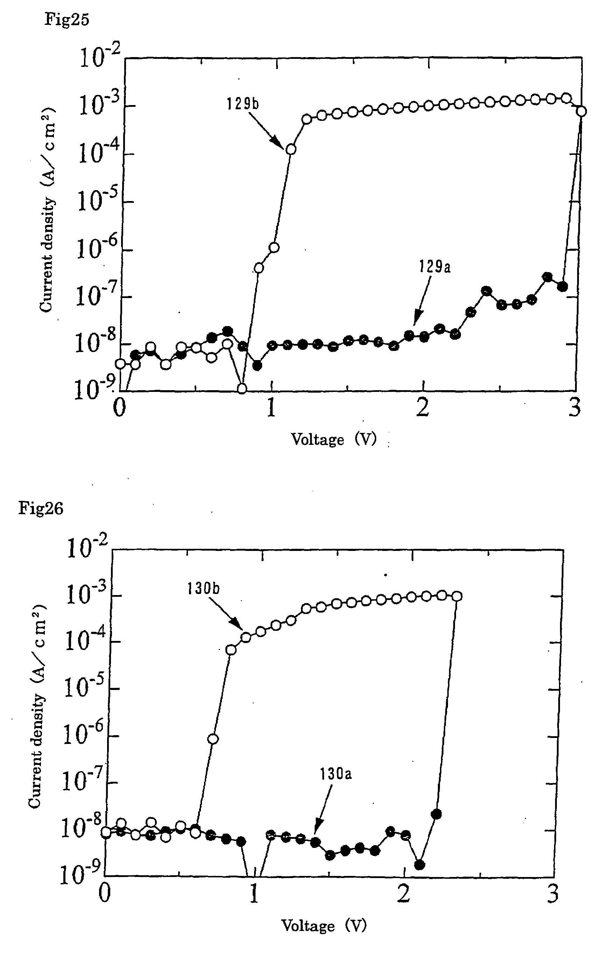

The current-voltage characteristics of the switching elements of Examples 29 to 32 were measured under a room temperature environment, and the values of threshold voltages thereof explained in Fig.41 i.e. a low threshold voltage Vth1 and a high threshold voltage Vth2, are shown in Table 9. Further, Figs.25 and 26 show the current-voltage characteristics of the switching elements of Examples 29 and 30, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 9**

| | Vth1 (V) | Vth2 (V) |
|---|---|---|
| Example 29 | 1.0 | 2.9 |
| Example 30 | 0.7 | 2.3 |
| Example 31 | 0.5 | 2.1 |
| Example 32 | 0.9 | 3.5 |

As shown in Figs.25 and 26, the switching elements of Examples 29 and 30 exhibit bistability obtained in which it was at high resistance state as represented by 129a, 130a and at low resistance state as represented by 129b, 130b, respectively.

Namely, as shown in Fig.25 and described in the current-voltage characteristics of the switching element of Example 29, when the low threshold voltage Vth1 was 1.0 V or lower, transition from a low resistance state 129b to a high resistance state 129a (from on-state to off-state) was observed, and accordingly the change of resistance value was given. When the high threshold voltage Vth2 was 2.9 V or higher, transition from a high resistance state 129a to a low resistance state 129b (from off-state to on-state) was observed, and accordingly the change of resistance value was given. In this case, the switching element of Example 29 attained ratio of the low resistance state/high resistance state by about 10⁵.

Further, as shown in Fig.26 and described in the current-voltage characteristics of the switching element of Example 30, when the low threshold voltage Vth1 was 0.7 V or lower, transition from a low resistance state 130b to a high resistance state 130a (from on-state to off-state) was observed and the change of resistance value was given. When the high threshold voltage Vth2 was 2.3 V or higher, transition from a high resistance state 130a to a low resistance state 130b (from off-state to on-state) was observed, and accordingly the change of resistance value was given. In this case, the switching element of Example 30 attained ratio of the low resistance state/high resistance state by about 10⁵.

Further, the bistability was observed in all the switching elements of Examples 29 to 32, and the bistability state was attained such that the low threshold voltage Vth1 was 0.5 to 1.0 V and the high threshold voltage Vth2 was 2. 1 to 3.5 V as shown in Table 9.

### EXAMPLE 33

A switching element having the structure as shown in Fig. 1 was prepared by the following manner.

On a glass substrate as a substrate 10, by a vapor deposition method, thin films were successively formed in order with aluminum as an electrode layer 21a, a dicyano type compound as a bistable material layer 30 and aluminum as an electrode layer 21b, to prepare a switching element of Example 33. As the dicyano type compound, a compound of the following formula (J-1) was used.

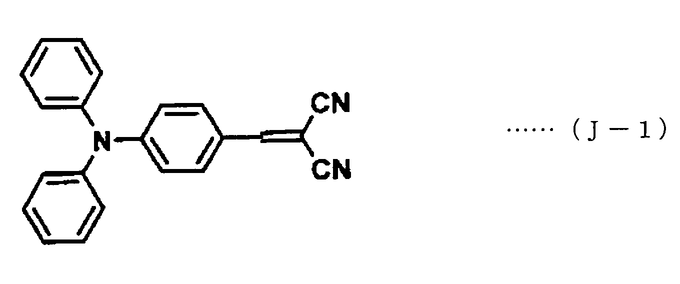

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the dicyano type compound was conducted by an electrical resistance heater system at a film forming rate of 2 Å/sec. The deposition of each layer was continuously conducted by the same deposition apparatus under such condition that the sample did not contact air during the deposition.

### EXAMPLE 34

A switching element of Example 34 was obtained under the same conditions as in Example 33, provided that films of the electrode layer 21a, bistable material layer 30 and electrode layer 21b were formed in a thickness of 100 nm, 60 nm and 100 nm, respectively.

### EXAMPLE 35

A switching element of Example 35 was obtained under the same conditions as in Example 33, provided that a compound of the following formula (J-2) was used as the dicyano type compound, and films of the electrode layer 21a, bistable material layer 30 and electrode layer 21b were formed in a thickness of 100 nm, 80 nm and 100 nm, respectively.

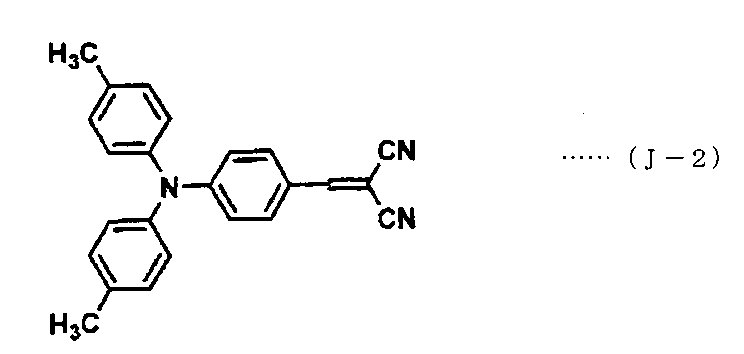

### EXAMPLE 36

A switching element of Example 36 was obtained under the same conditions as in Example 33, provided that a compound of the following formula (J-6) was used as the dicyano type compound, and films of the electrode layer 21a, bistable material layer 30 and electrode layer 21b were formed in a thickness of 100 nm, 80 nm and 100 nm, respectively.

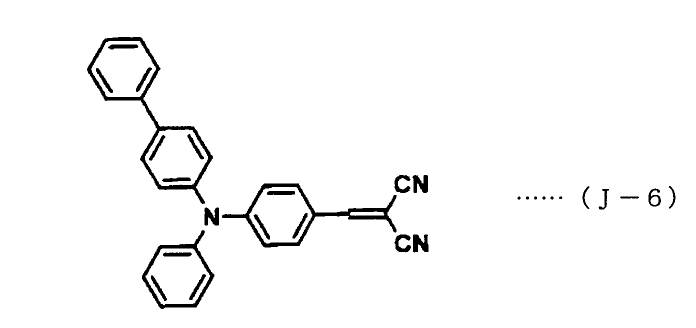

### EXAMPLE 37

A switching element of Example 37 was obtained under the same conditions as in Example 33, provided that a compound of the following formula (J-9) was used as the dicyano type compound, and films of the electrode layer 21a, bistable material layer 30 and electrode layer 21b were formed in a thickness of 100 nm, 80 nm and 100 nm, respectively.

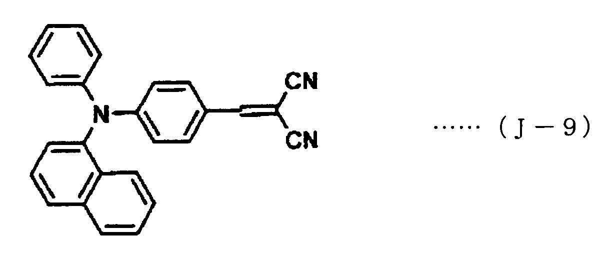

### EXPERIMENTAL EXAMPLE 10

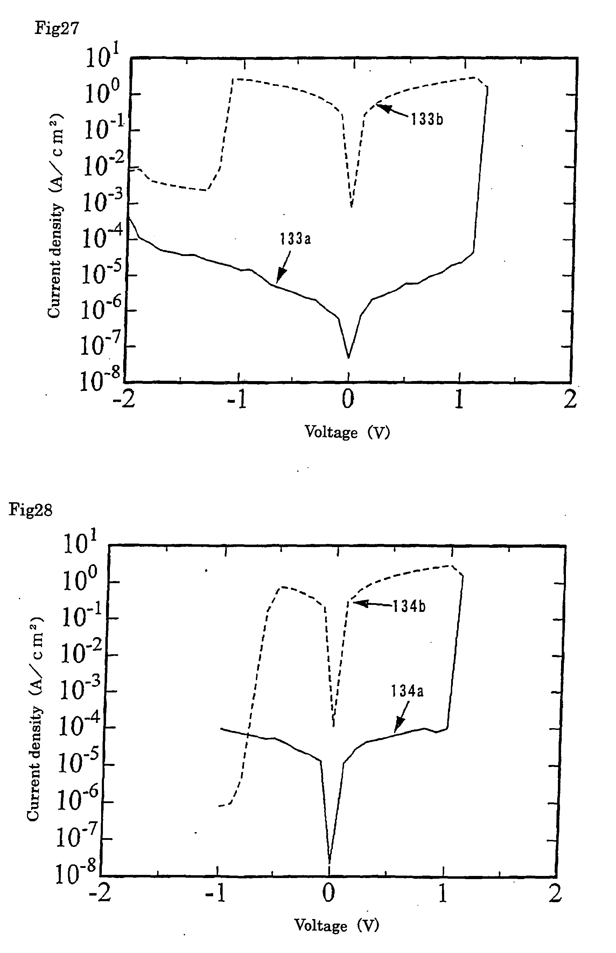

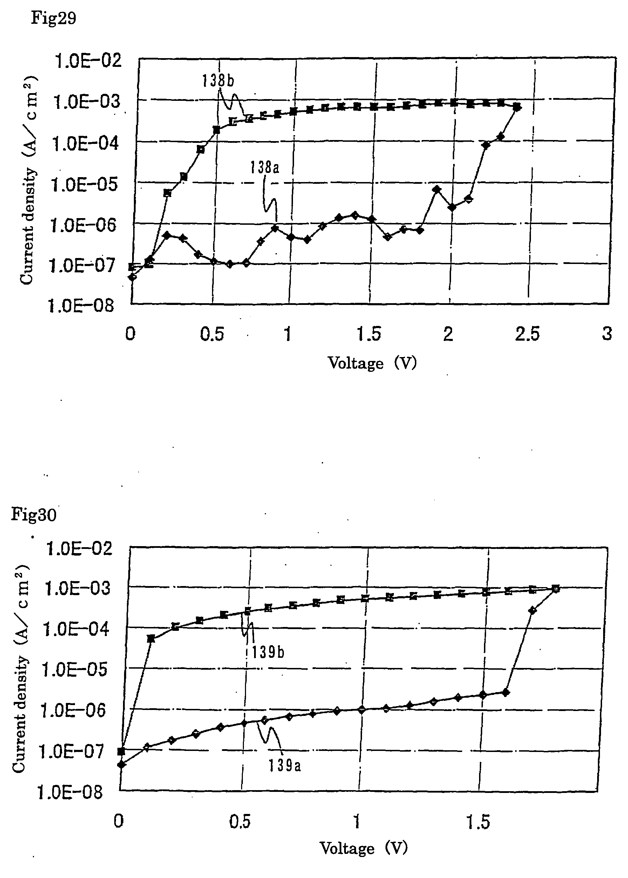

The current-voltage characteristics of the switching elements of Examples 33 to 37 were measured under a room temperature environment, and the values of threshold voltages thereof explained in Fig.41 i.e. a low threshold voltage Vth1 and a high threshold voltage Vth2, are shown in Table 10. Further, Figs.27 and 28 show the current-voltage characteristics of the switching elements of Examples 33 and 34, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 10**

| | Vth1 (V) | Vth2 (V) |
|---|---|---|
| Example 33 | -1.1 | 1.2 |
| Example 34 | -0.6 | 1.1 |
| Example 35 | -0.7 | 1.3 |
| Example 36 | -1.3 | 1.7 |
| Example 37 | -1.4 | 2.1 |

As shown in Figs.27 and 28, the switching elements of Examples 33 and 34 exhibit bistability obtained in which it was at high resistance state as represented by 133a, 134a and at low resistance state as represented by 133b, 134b, respectively.

Namely, as shown in Fig.27 and described in the current-voltage characteristics of the switching element of Example 33, when the low threshold voltage Vth1 was -1.1 V or lower, transition from a low resistance state 133b to a high resistance state 133a (from on-state to off-state) was observed, and accordingly the change of resistance value was given. When the high threshold voltage Vth2 was 1.2 V or higher, transition from a high resistance state 133a to a low resistance state 133b (from off-state to on-state) was observed, and accordingly the change of resistance value was given. In this case, the switching element of Example 33 attained ratio of the low resistance state/high resistance state by about 10⁵.

Further, as shown in Fig.28 and described in the current-voltage characteristics of the switching element of Example 34, when the low threshold voltage Vth1 was -0.6 V or lower, transition from a low resistance state 134b to a high resistance state 134a (from on-state to off-state) was observed and the change of resistance value was given. When the high threshold voltage Vth2 was 1.1 V or higher, transition from a high resistance state 134a to a low resistance state 134b (from off-state to on-state) was observed, and accordingly the change of resistance value was given. In this case, the switching element of Example 34 attained ratio of the low resistance state/high resistance state by about 10⁴.

Further, the bistability was observed in all the switching elements of Examples 33 to 37, and the bistability state was attained such that the low threshold voltage Vth1 was -0. 6 to -1.4 V and the high threshold voltage Vth2 was 1.1 to 2.1 V as shown in Table 10.

### EXAMPLE 38

A switching element having the structure as shown in Fig. 1 was prepared by the following manner.

On a glass substrate as a substrate 10, by a vapor deposition method, thin films were successively formed in order with aluminum as an electrode layer 21a, a pyridone type compound as a bistable material layer 30 and aluminum as an electrode layer 21b, to prepare a switching element of Example 38. As the pyridone type compound, a compound of the following formula (K-1) was used.

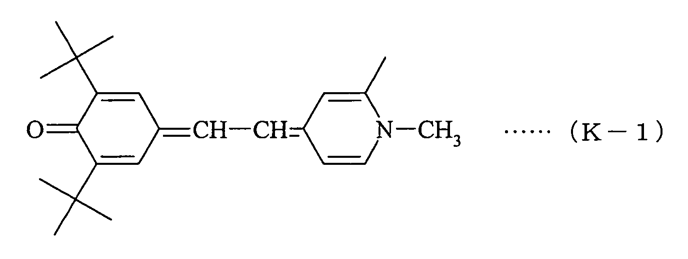

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the pyridone type compound was conducted by an electrical resistance heater system at a film forming rate of 2 Å/sec. The deposition of each layer was continuously conducted by the same deposition apparatus under such condition that the sample did not contact air during the deposition.

### EXAMPLE 39

A switching element of Example 39 was obtained under the same conditions as in Example 38, provided that films of the electrode layer 21a, bistable material layer 30 and electrode layer 21b were formed in a thickness of 100 nm, 60 nm and 100 nm, respectively.

### EXAMPLE 40

A switching element of Example 40 was obtained under the same conditions as in Example 38, provided that a compound of the following formula (K-2) was used as the pyridone type compound, and films of the electrode layer 21a, bistable material layer 30 and electrode layer 21b were formed in a thickness of 100 nm, 80 nm and 100 nm, respectively.

### EXAMPLE 41

A switching element of Example 41 was obtained under the same conditions as in Example 38, provided that a compound of the following formula (K-9) was used as the pyridone type compound, and films of the electrode layer 21a, bistable material layer 30 and electrode layer 21b were formed in a thickness of 100 nm, 80 nm and 100 nm, respectively.

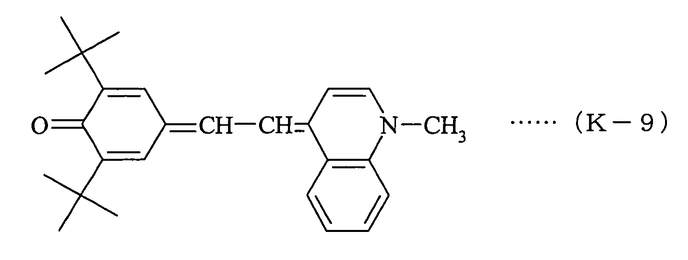

### EXAMPLE 42

A switching element of Example 42 was obtained under the same conditions as in Example 38, provided that a compound of the following formula (L-7) was used as the pyridone type compound, and films of the electrode layer 21a, bistable material layer 30 and electrode layer 21b were formed in a thickness of 100 nm, 80 nm and 100 nm, respectively.

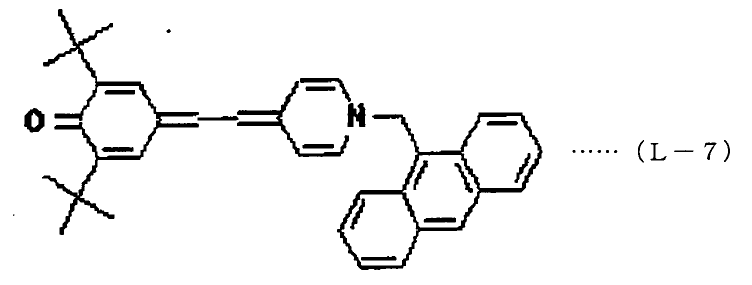

### EXPERIMENTAL EXAMPLE 11

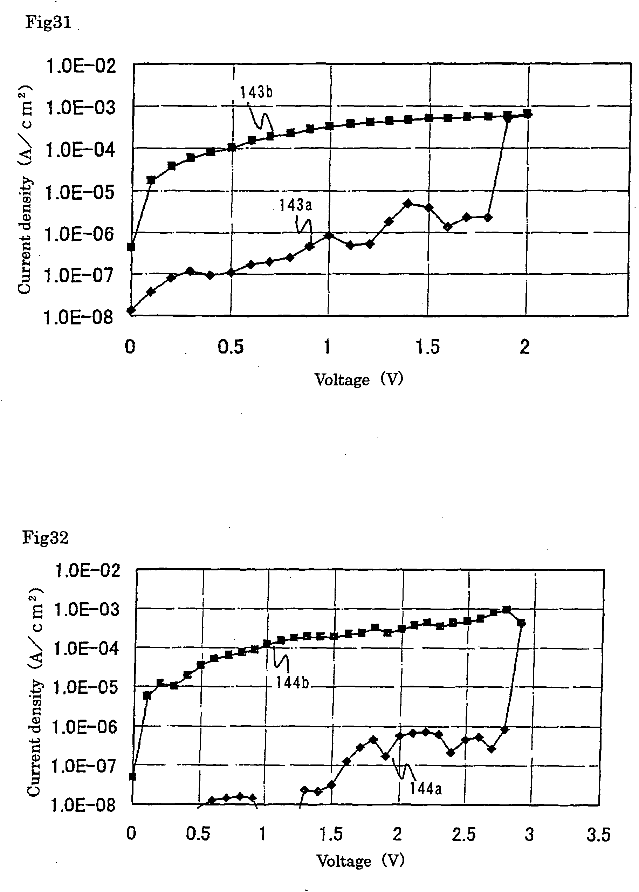

The current-voltage characteristics of the switching elements of Examples 38 to 42 were measured under a room temperature environment, and the values of threshold voltages thereof explained in Fig.41 i.e. a low threshold voltage Vth1 and a high threshold voltage Vth2, are shown in Table 11. Further, Figs.29 and 30 show the current-voltage characteristics of the switching elements of Examples 38 and 39, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 11**

| | Vth1 (V) | Vth2 (V) |
|---|---|---|
| Example 38 | 0.1 | 2.4 |
| Example 39 | 0.0 | 1.8 |
| Example 40 | -0.5 | 1.9 |
| Example 41 | 0.0 | 2.1 |
| Example 42 | -1.2 | 2.7 |

As shown in Figs.29 and 30, the switching elements of Examples 38 and 39 exhibit bistability obtained in which it was at high resistance state as represented by 138a, 139a and at low resistance state as represented by 138b, 139b, respectively.

Namely, as shown in Fig.29 and described in the current-voltage characteristics of the switching element of Example 38, when the low threshold voltage Vth1 was 0.1 V or lower, transition from a low resistance state 138b to a high resistance state 138a (from on-state to off-state) was observed, and accordingly the change of resistance value was given. When the high threshold voltage Vth2 was 2.4 V or higher, transition from a high resistance state 138a to a low resistance state 138b (from off-state to on-state) was observed, and accordingly the change of resistance value was given. In this case, the switching element of Example 38 attained ratio of the low resistance state/high resistance state by about 10³.

Further, as shown in Fig.30 and described in the current-voltage characteristics of the switching element of Example 39, when the low threshold voltage Vth1 was -0.0 V or lower, transition from a low resistance state 139b to a high resistance state 139a (from on-state to off-state) was observed and the change of resistance value was given. When the high threshold voltage Vth2 was 1.8 V or higher, transition from a high resistance state 139a to a low resistance state 139b (from off-state to on-state) was observed, and accordingly the change of resistance value was given. In this case, the switching element of Example 39 attained ratio of the low resistance state/high resistance state by about 3x10².

Further, the bistability was observed in all the switching elements of Examples 38 to 42, and the bistability state was attained such that the low threshold voltage Vth1 was 0.1 to -1.2 V and the high threshold voltage Vth2 was 1.8 to 2.7 V as shown in Table 11.

### EXAMPLE 43

A switching element having the structure as shown in Fig.1 was prepared by the following manner.

On a glass substrate as a substrate 10, by a vapor deposition method, thin films were successively formed in order with aluminum as an electrode layer 21a, a quinoneimine type compound as a bistable material layer 30 and aluminum as an electrode layer 21b, to prepare a switching element of Example 43. As the quinoneimine type compound, a compound of the following formula (M-4) was used.

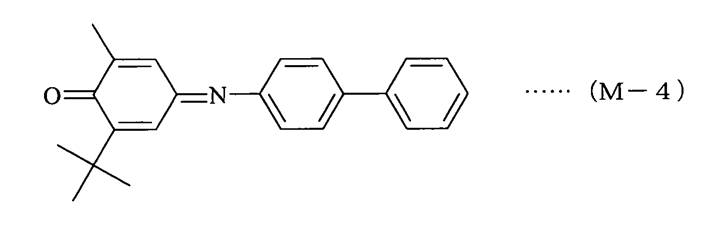

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the quinoneimine type compound was conducted by an electrical resistance heater system at a film forming rate of 2 Å/sec. The deposition of each layer was continuously conducted by the same deposition apparatus under such condition that the sample did not contact air during the deposition.

### EXAMPLE 44

A switching element of Example 44 was obtained under the same conditions as in Example 43, provided that a compound of the following formula (M-8) was used as the quinoneimine type compound, and films of the electrode layer 21a, bistable material layer 30 and electrode layer 21b were formed in a thickness of 100 nm, 80 nm and 100 nm, respectively.

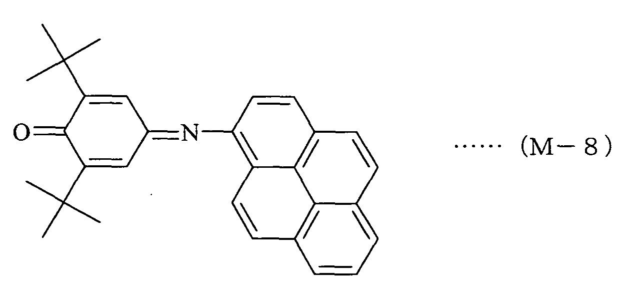

### EXAMPLE 45

A switching element of Example 45 was obtained under the same conditions as in Example 43, provided that a compound of the following formula (M-9) was used as the quinoneimine type compound, and films of the electrode layer 21a, bistable material layer 30 and electrode layer 21b were formed in a thickness of 100 nm, 80 nm and 100 nm, respectively.

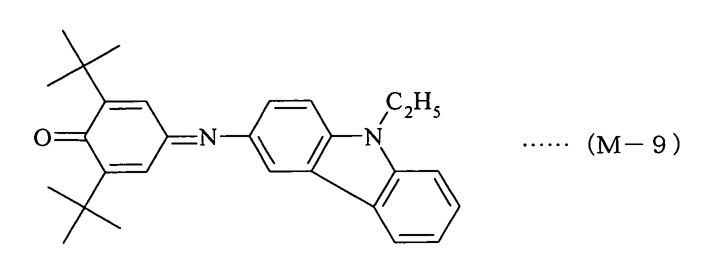

### EXAMPLE 46

A switching element of Example 46 was obtained under the same conditions as in Example 43, provided that a compound of the following formula (N-4) was used as the quinoneamine type compound, and films of the electrode layer 21a, bistable material layer 30 and electrode layer 21b were formed in a thickness of 100 nm, 80 nm and 100 nm, respectively.

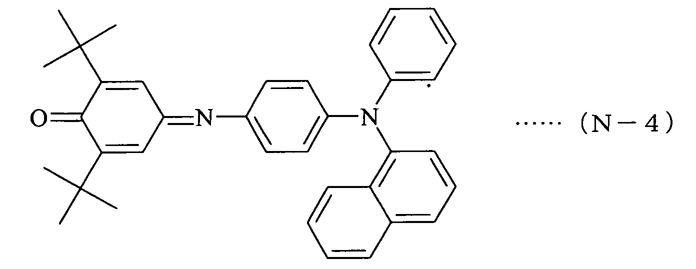

### EXPERIMENTAL EXAMPLE 12

The current-voltage characteristics of the switching elements of Examples 43 to 46 were measured under a room temperature environment, and the values of threshold voltages thereof explained in Fig.41 i.e. a low threshold voltage Vth1 and a high threshold voltage Vth2, are shown in Table 12. Further, Figs.31 and 32 show the current-voltage characteristics of the switching elements of Examples 43 and 44, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 12**

| | Vth1 (V) | Vth2 (V) |
|---|---|---|
| Example 43 | -0.2 | 1.8 |
| Example 44 | -0.7 | 2.8 |
| Example 45 | -0.5 | 1.4 |
| Example 46 | 0.0 | 2.1 |

As shown in Figs.31 and 32, the switching elements of Examples 43 and 44 exhibit bistability obtained in which it was at high resistance state as represented by 143a, 144a and at low resistance state as represented by 143b, 144b, respectively.

Namely, as shown in Fig.31 and described in the current-voltage characteristics of the switching element of Example 43, when the low threshold voltage Vth1 was -0.2 V or lower, transition from a low resistance state 143b to a high resistance state 143a (from on-state to off-state) was observed, and accordingly the change of resistance value was given. When the high threshold voltage Vth2 was 1.8 V or higher, transition from a high resistance state 143a to a low resistance state 143b (from off-state to on-state) was observed, and accordingly the change of resistance value was given. In this case, the switching element of Example 43 attained ratio of the low resistance state/high resistance state by about 3x10².

Further, as shown in Fig.32 and described in the current-voltage characteristics of the switching element of Example 44, when the low threshold voltage Vth1 was -0.7 V or lower, transition from a low resistance state 144b to a high resistance state 144a (from on-state to off-state) was observed and the change of resistance value was given. When the high threshold voltage Vth2 was 2.8 V or higher, transition from a high resistance state 144a to a low resistance state 144b (from off-state to on-state) was observed, and accordingly the change of resistance value was given. In this case, the switching element of Example 44 attained ratio of the low resistance state/high resistance state by about 10³.

Further, the bistability was observed in all the switching elements of Examples 43 to 46, and the bistability state was attained such that the low threshold voltage Vth1 was 0.0 to -0.7 V and the high threshold voltage Vth2 was 1.4 to 2.8 V as shown in Table 12.

### EXAMPLE 47

A switching element having the structure as shown in Fig. 1 was prepared by the following manner.

On a glass substrate as a substrate 10, by a vapor deposition method, thin films were successively formed in order with aluminum as an electrode layer 21a, a stilbene type compound as a bistable material layer 30 and aluminum as an electrode layer 21b, to prepare a switching element of Example 47. As the stilbene type compound, a compound of the following formula (O-3) was used.

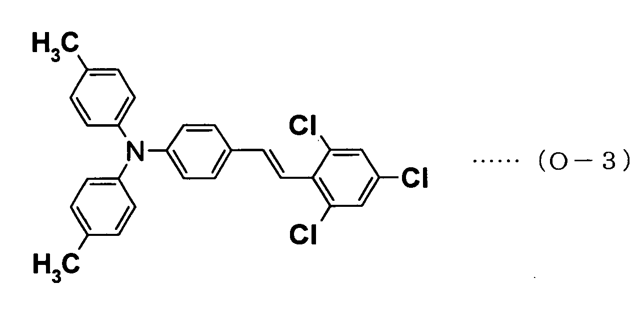

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the stilbene type compound was conducted by an electrical resistance heater system at a film forming rate of 2 Å/sec. The deposition of each layer was continuously conducted by the same deposition apparatus under such condition that the sample did not contact air during the deposition.

### EXAMPLE 48

A switching element was prepared under the same conditions as in Example 47, provided that the bistable material of the formula (0-3) used in Example 47 was replaced to a bistable material of the following formula (O-6).

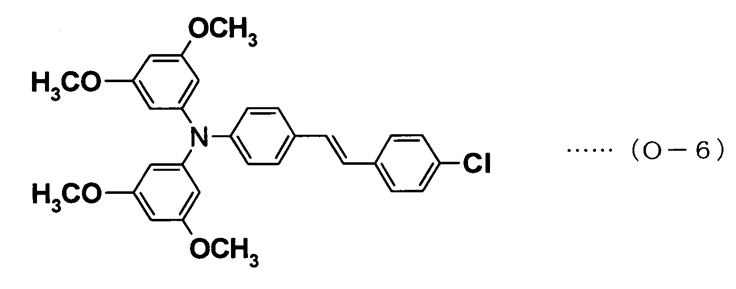

### EXAMPLE 49

A switching element was prepared under the same conditions as in Example 47, provided that the bistable material of the formula (O-3) used in Example 47 was replaced to a bistable material of the following formula (O-7).

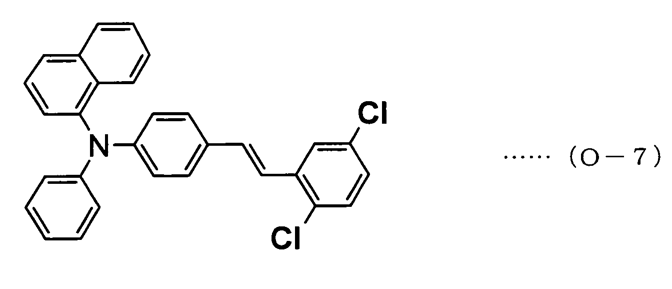

### EXAMPLE 50

A switching element was prepared under the same conditions as in Example 47, provided that the bistable material of the formula (O-3) used in Example 47 was replaced to a bistable material of the following formula (O-9).

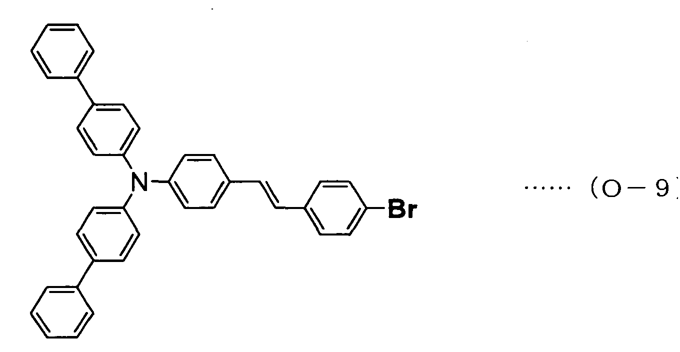

### EXPERIMENTAL EXAMPLE 13

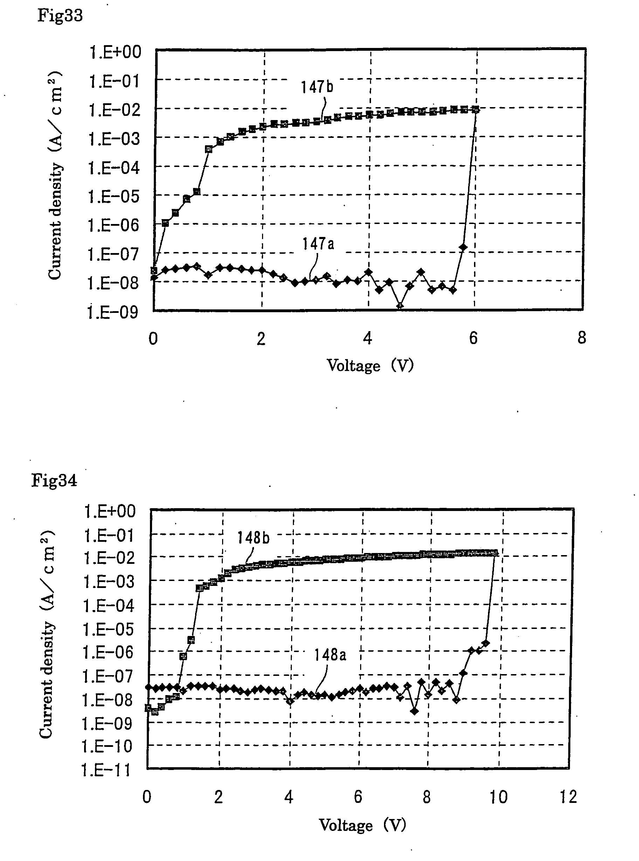

The current-voltage characteristics of the switching elements of Examples 47 to 50 were measured under a room temperature environment, and the values of threshold voltages thereof explained in Fig.41 i.e. a low threshold voltage Vth1 and a high threshold voltage Vth2, are shown in Table 13. Further, Figs.33 and 34 show the current-voltage characteristics of the switching elements of Examples 47 and 48, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 13**

| | Vth1 (V) | Vth2 (V) |
|---|---|---|
| Example 47 | 0.0 | 6.0 |
| Example 48 | 0.8 | 9.8 |
| Example 49 | -0.3 | 7.2 |
| Example 50 | -0.5 | 5.8 |

As shown in Figs.33 and 34, the switching elements of Examples 47 and 48 exhibit bistability obtained in which it was at high resistance state as represented by 147a, 148a and at low resistance state as represented by 147b, 148b, respectively.

Namely, as shown in Fig.33 and described in the current-voltage characteristics of the switching element of Example 47, when the low threshold voltage Vth1 was 0 V or lower, transition from a low resistance state 147b to a high resistance state 147a (from on-state to off-state) was observed, and accordingly the change of resistance value was given. When the high threshold voltage Vth2 was 6. 0 V or higher, transition from a high resistance state 147a to a low resistance state 147b (from off-state to on-state) was observed, and accordingly the change of resistance value was given. In this case, the switching element of Example 47 attained ratio of the low resistance state/high resistance state by about 6x10⁵.

Further, as shown in Fig.34 and described in the current-voltage characteristics of the switching element of Example 48, when the low threshold voltage Vth1 was 0.8 V or lower, transition from a low resistance state 148b to a high resistance state 148a (from on-state to off-state) was observed and the change of resistance value was given. When the high threshold voltage Vth2 was 9.8 V or higher, transition from a high resistance state 148a to a low resistance state 148b (from off-state to on-state) was observed, and accordingly the change of resistance value was given. In this case, the switching element of Example 48 attained ratio of the low resistance state/high resistance state by about 2x10⁵.

Further, the bistability was observed in all the switching elements of Examples 47 to 50, and the bistability state was attained such that the low threshold voltage Vth1 was 0.8 to -0.5 V and the high threshold voltage Vth2 was 5.8 to 9.8 V as shown in Table 13.

### EXAMPLE 51

A switching element having the structure as shown in Fig. 1 was prepared by the following manner.

On a glass substrate as a substrate 10, by a vapor deposition method, thin films were successively formed in order with aluminum as an electrode layer 21a, a butadiene type compound as a bistable material layer 30 and aluminum as an electrode layer 21b, to prepare a switching element of Example 51. As the butadiene type compound, a compound of the following formula (P-1) was used.

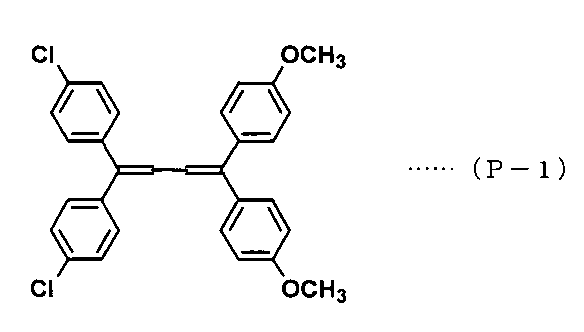

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the butadiene type compound was conducted by an electrical resistance heater system at a film forming rate of 2 Å/sec. The deposition of each layer was continuously conducted by the same deposition apparatus under such condition that the sample did not contact air during the deposition.

### EXAMPLE 52

A switching element of Example 52 was obtained under the same conditions as in Example 51, provided that a compound of the following formula (P-2) was used as the butadiene type compound, and films of the electrode layer 21a, bistable material layer 30 and electrode layer 21b were formed in a thickness of 100 nm, 80 nm and 100 nm, respectively.

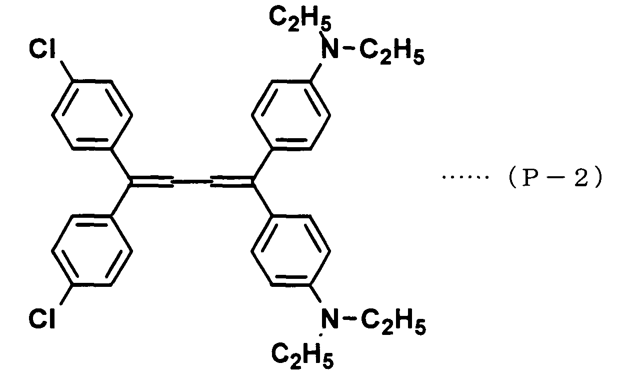

### EXAMPLE 53

A switching element of Example 53 was obtained under the same conditions as in Example 51, provided that a compound of the following formula (P-3) was used as the butadiene type compound, and films of the electrode layer 21a, bistable material layer 30 and electrode layer 21b were formed in a thickness of 100 nm, 80 nm and 100 nm, respectively.

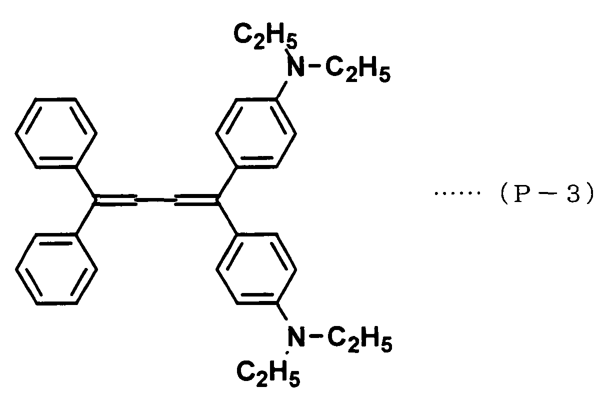

### EXPERIMENTAL EXAMPLE 14

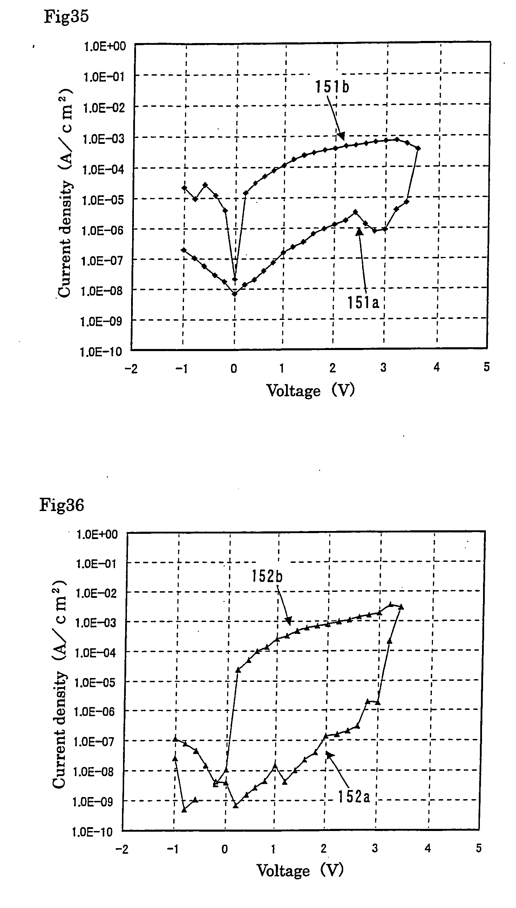

The current-voltage characteristics of the switching elements of Examples 51 to 53 were measured under a room temperature environment, and the values of threshold voltages thereof explained in Fig.41 i.e. a low threshold voltage Vth1 and a high threshold voltage Vth2, are shown in Table 14. Further, Figs.35 and 36 show the current-voltage characteristics of the switching elements of Examples 51 and 52, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 14**

| | Vth1 (V) | Vth2 (V) |
|---|---|---|
| Example 51 | 0.0 | 3.4 |
| Example 52 | -0.2 | 3.0 |
| Example 53 | 0.0 | 2.6 |

As shown in Figs.35 and 36, the switching elements of Examples 51 and 52 exhibit bistability obtained in which it was at high resistance state as represented by 151a, 152a and at low resistance state as represented by 151b, 152b, respectively.

Namely, as shown in Fig.35 and described in the current-voltage characteristics of the switching element of Example 51, when the low threshold voltage Vth1 was -1.1 V or lower, transition from a low resistance state 151b to a high resistance state 151a (from on-state to off-state) was observed, and accordingly the change of resistance value was given. When the high threshold voltage Vth2 was 1.2 V or higher, transition from a high resistance state 151a to a low resistance state 151b (from off-state to on-state) was observed, and accordingly the change of resistance value was given. In this case, the switching element of Example 51 attained ratio of the low resistance state/high resistance state by about 10⁵.

Further, as shown in Fig.36 and described in the current-voltage characteristics of the switching element of Example 52, when the low threshold voltage Vth1 was -0.6 V or lower, transition from a low resistance state 152b to a high resistance state 152a (from on-state to off-state) was observed and the change of resistance value was given. When the high threshold voltage Vth2 was 1.1 V or higher, transition from a high resistance state 152a to a low resistance state 152b (from off-state to on-state) was observed, and accordingly the change of resistance value was given. In this case, the switching element of Example 52 attained ratio of the low resistance state/high resistance state by about 10⁴.

Further, the bistability was observed in all the switching elements of Examples 51 to 53, and the bistability state was attained such that the low threshold voltage Vth1 was -0.6 to -1.4 V and the high threshold voltage Vth2 was 1.1 to 2.1 V as shown in Table 14.

### EXAMPLE 54

A switching element having the structure as shown in Fig.1 was prepared by the following manner.

On a glass substrate as a substrate 10, by a vapor deposition method, thin films were successively formed in order with aluminum as an electrode layer 21a, a stilbene type compound as a bistable material layer 30 and aluminum as an electrode layer 21b, to prepare a switching element of Example 54. As the stilbene type compound, a compound of the following formula (Q-4) was used.

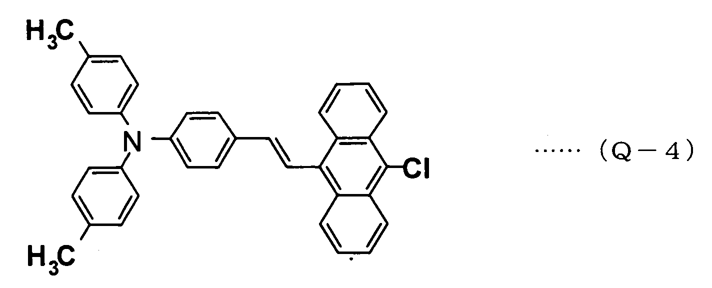

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the stilbene type compound was conducted by an electrical resistance heater system at a film forming rate of 2 Å/sec. The deposition of each layer was continuously conducted by the same deposition apparatus under such condition that the sample did not contact air during the deposition.

### EXAMPLE 55

A switching element was prepared under the same conditions as in Example 54, provided that the bistable material of the formula (Q-4) used in Example 54 was replaced to a bistable material of the following formula (Q-5).

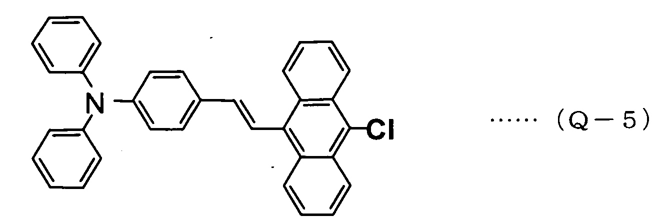

### EXAMPLE 56

A switching element was prepared under the same conditions as in Example 54, provided that the bistable material of the formula (Q-4) used in Example 54 was replaced to a bistable material of the following formula (Q-7).

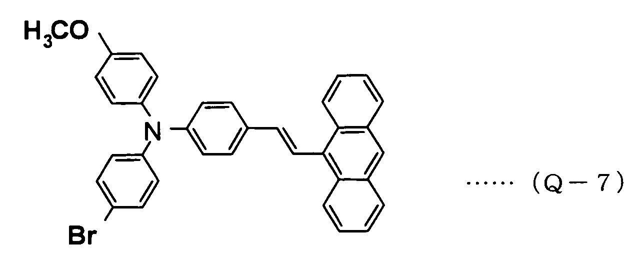

### EXAMPLE 57

A switching element was prepared under the same conditions as in Example 54, provided that the bistable material of the formula (Q-4) used in Example 54 was changed to a bistable material of the following formula (Q-10).

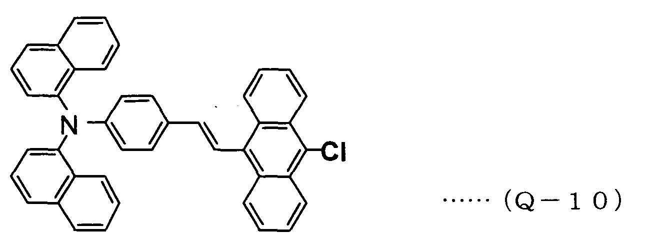

### EXPERIMENTAL EXAMPLE 15

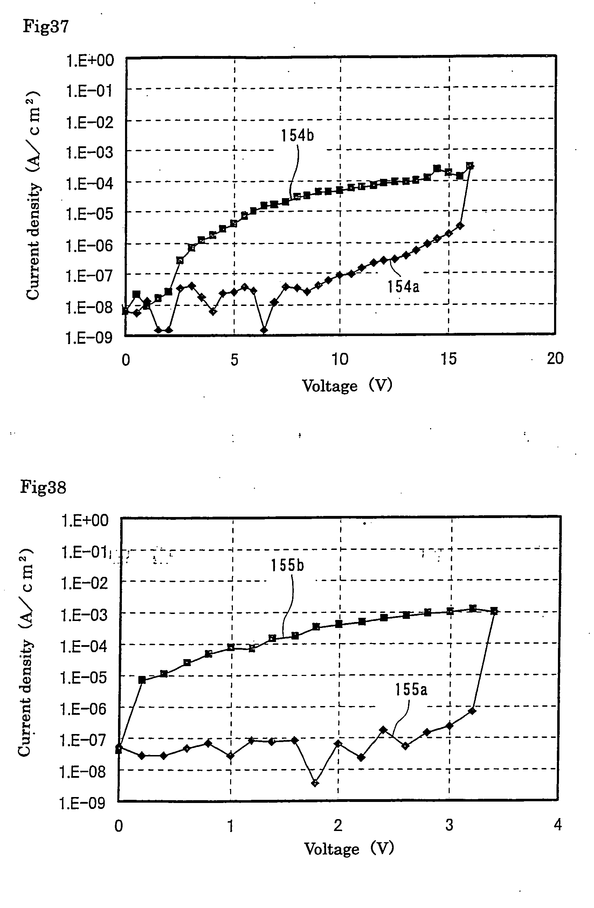

The current-voltage characteristics of the switching elements of Examples 54 to 57 were measured under a room temperature environment, and the values of threshold voltages thereof explained in Fig.41 i.e. a low threshold voltage Vth1 and a high threshold voltage Vth2, are shown in Table 15. Further, Figs.37 and 38 show the current-voltage characteristics of the switching elements of Examples 54 and 55, respectively.

Here, as the measurement conditions, electrical resistance ranging from 100 kΩ to 1 MΩ was connected to each switching element in series, and a limited amount of current was applied in an ON-state so as to suppress the damage of the element by an over-current.

**Table 15**

| | Vth1 (V) | Vth2 (V) |
|---|---|---|
| Example 54 | 2.0 | 15.5 |
| Example 55 | 0.0 | 3.2 |
| Example 56 | 0.2 | 5.5 |
| Example 57 | 0.1 | 7.1 |

As shown in Figs.37 and 38, the switching elements of Examples 54 and 55 exhibit bistability obtained in which it was at high resistance state as represented by 154a, 155a and at low resistance state as represented by 154b, 155b, respectively.

Namely, as shown in Fig.37 and described in the current-voltage characteristics of the switching element of Example 54, when the low threshold voltage Vth1 was 2 V or lower, transition from a low resistance state 154b to a high resistance state 154a (from on-state to off-state) was observed, and accordingly the change of resistance value was given. When the high threshold voltage Vth2 was 15.5 V or higher, transition from a high resistance state 154a to a low resistance state 154b (from off-state to on-state) was observed, and accordingly the change of resistance value was given. In this case, the switching element of Example 54 attained ratio of the low resistance state/high resistance state by about 1x10².

Further, as shown in Fig.38 and described in the current-voltage characteristics of the switching element of Example 55, when the low threshold voltage Vth1 was 0 V or lower, transition from a low resistance state 155b to a high resistance state 155a (from on-state to off-state) was observed and the change of resistance value was given. When the high threshold voltage Vth2 was 3.2 V or higher, transition from a high resistance state 155a to a low resistance state 155b (from off-state to on-state) was observed, and accordingly the change of resistance value was given. In this case, the switching element of Example 55 attained ratio of the low resistance state/high resistance state by about 1x10³.

Further, the bistability was observed in all the switching elements of Examples 54 to 57, and the bistability state was attained such that the low threshold voltage Vth1 was 0 to 2 V and the high threshold voltage Vth2 was 3.2 to 15.5 V as shown in Table 15.

### EXAMPLE 58

A switching element having the structure as shown in Fig. 1 was prepared by the following manner.

On a glass substrate as a substrate 10, by a vapor deposition method, thin films were successively formed in order with aluminum as an electrode layer 21a, a triphenylamine type compound as a bistable material layer 30 and aluminum as an electrode layer 21b, to prepare a switching element of Example 58. As the triphenylamine type compound, a compound of the following formula (R-1) was used.

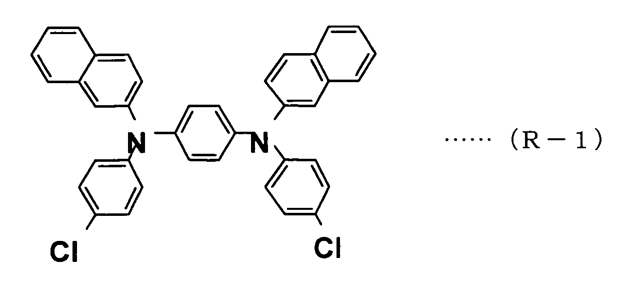

Films of the electrode layer 21a, bistable material layer 30 and electrode layer 21b were formed in a thickness of 100 nm, 80 nm and 100 nm, respectively. Further, the deposition apparatus was used at a degree of vacuum of 3x10⁻⁶ torr by evacuation with a diffusion pump. The deposition of aluminum was conducted by an electrical resistance heater system at a film forming rate of 3 Å/sec, and the deposition of the triphenylamine type compound was conducted by an electrical resistance heater system at a film forming rate of 2 Å/sec. The deposition of each layer was continuously conducted by the same deposition apparatus under such condition that the sample did not contact air during the deposition.

### EXAMPLE 59

On a glass substrate as a substrate 10, by a vapor deposition method, thin films were successively formed in order with gold as an electrode layer 21a, a triphenylamine type compound as a bistable material layer 30 and aluminum as an electrode layer 21b, to prepare a switching element of Example 59. As the triphenylamine type compound, a compound of the following formula (R-21) was used.

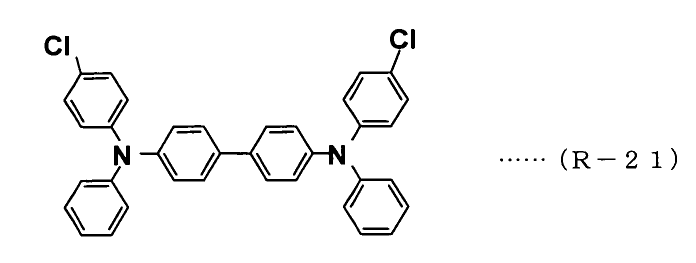

### EXAMPLE 60

On a glass substrate as a substrate 10, by a vapor deposition method, thin films were successively formed in order with aluminum as an electrode layer 21a, a triphenylamine type compound as a bistable material layer 30 and aluminum as an electrode layer 21b, to prepare a switching element of Example 60. As the triphenylamine type compound, a compound of the following formula (R-24) was used.

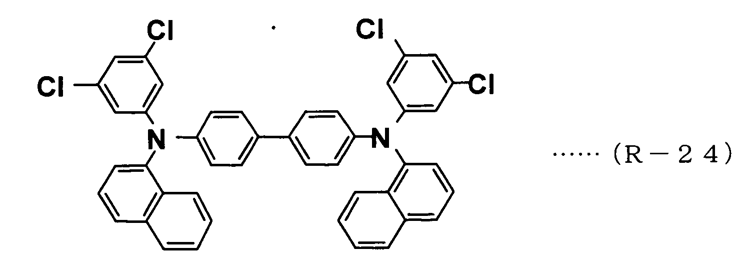

### EXAMPLE 61

On a glass substrate as a substrate 10, by a vapor deposition method, thin films were successively formed in order with aluminum as an electrode layer 21a, a triphenylamine type compound as a bistable material layer 30 and aluminum as an electrode layer 21b, to prepare a switching element of Example 61. As the triphenylamine type compound, a compound of the following formula (R-27) was used.

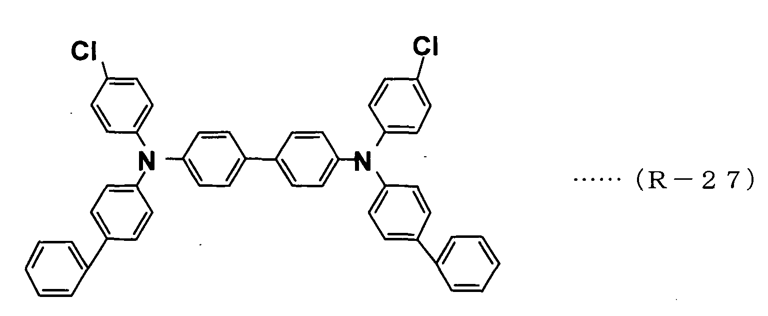

### EXPERIMENTAL EXAMPLE 16

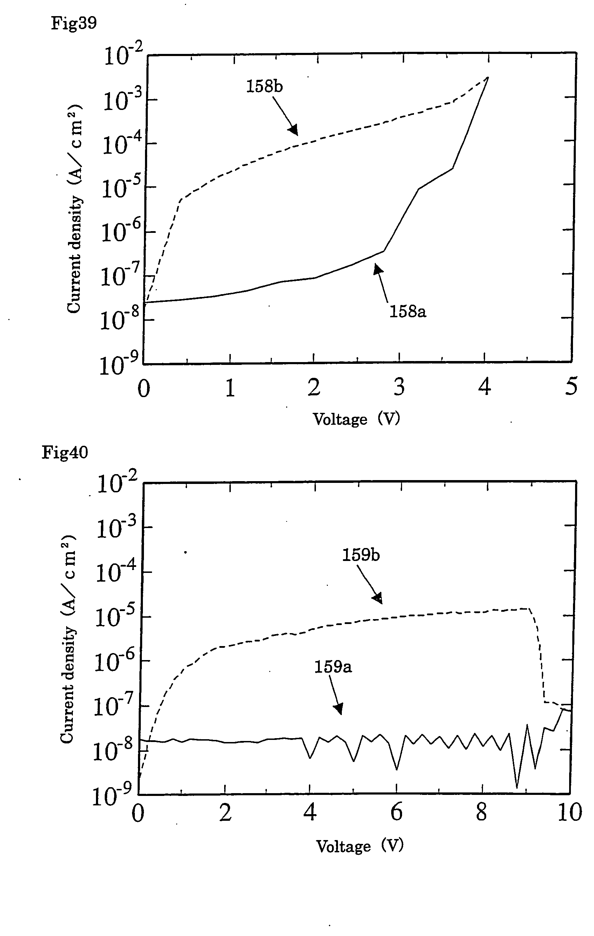

The current-voltage characteristics of the switching elements of Examples 58 to 61 were measured under a room temperature environment, and the values of threshold voltages thereof explained in Fig.41 i.e. a low threshold voltage Vth1 and a high threshold voltage Vth2, are shown in Table 16. Further, Figs.39 and 40 show the current-voltage characteristics of the switching elements of Examples 58 and 59, respectively.

**Table 16**

| | Vth1 (V) | Vth2 (V) |
|---|---|---|
| Example 58 | 0.0 | 2.8 |
| Example 59 | 0.0 | 9.2 |
| Example 60 | 0.0 | 5.6 |
| Example 61 | 0.0 | 1.6 |

As shown in Figs.39 and 40, the switching elements of Examples 58 and 59 exhibit bistability obtained in which it was at high resistance state as represented by 158a, 159a and at low resistance state as represented by 158b, 159b, respectively.

Namely, as shown in Fig.39 and described in the current-voltage characteristics of the switching element of Example 58, when the low threshold voltage Vth1 was 0.0 V or lower, transition from a low resistance state 158b to a high resistance state 158a (from on-state to off-state) was observed, and accordingly the change of resistance value was given. When the high threshold voltage Vth2 was 2.8 V or higher, transition from a high resistance state 158a to a low resistance state 158b (from off-state to on-state) was observed, and accordingly the change of resistance value was given. In this case, the switching element of Example 58 attained ratio of the low resistance state/high resistance state by about 10³.

Further, as shown in Fig.40 and described in the current-voltage characteristics of the switching element of Example 59, when the low threshold voltage Vth1 was 0.0 V or lower, transition from a low resistance state 159b to a high resistance state 159a (from on-state to off-state) was observed and the change of resistance value was given. When the high threshold voltage Vth2 was 9.2 V or higher, transition from a high resistance state 159a to a low resistance state 159b (from off-state to on-state) was observed, and accordingly the change of resistance value was given. In this case, the switching element of Example 59 attained ratio of the low resistance state/high resistance state by about 10³.

Further, the bistability was observed in all the switching elements of Examples 58 to 61, and the bistability state was attained such that the low threshold voltage Vth1 was 0.0 V and the high threshold voltage Vth2 was 1.6 to 9.2 V as shown in Table 16.

### INDUSTRIAL APPLICABILITY

As explained above, according to the present invention, suppressing the compositional deviation of material, it is possible to attain uniform characteristic in bistability and to provide a switching element suitable for mass production. Accordingly, this switching element can be utilized for a switching element driving of an organic EL display panel, a high-density memory, and the like.

## Claims

1. A switching element which comprises:
an organic bistable material, the organic bistable material having two stable states in resistance under applied voltage;
at least two electrodes, the electrodes being placed such that the organic bistable material is arranged between two of the electrodes,
the switching element being **characterized in that** the organic bistable material comprises at least a compound having an electron-donating functional group and an electron-accepting functional group in a molecule of said compound.

2. The switching element according to Claim 1, wherein the compound is an aminoimidazole type compound of the following formula (A): 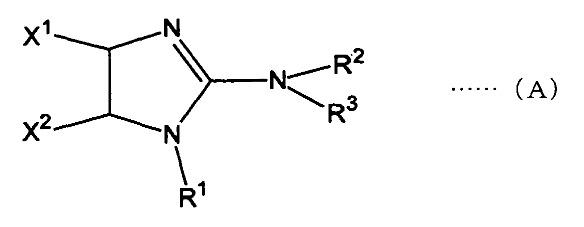 wherein each of X¹ and X² is CN or NO₂, and each of R¹, R² and R³ is a hydrogen atom or a C₁₋₆ alkyl group which may have a substituent.

3. The switching element according to Claim 1, wherein the compound is a γ-pyridone type compound of the following formula (B): 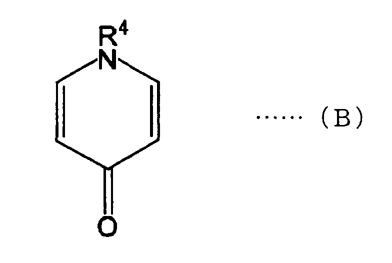 wherein R⁴ is a hydrogen atom or a C₁₋₆ alkyl group which may have a substituent.

4. The switching element according to Claim 1, wherein the compound is an imine type compound of the following formula (C): 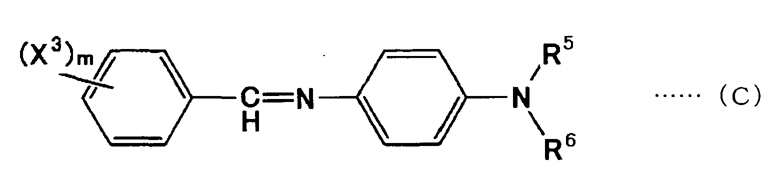 wherein X³ is CN or NO₂, each of R⁵ and R⁶ is a hydrogen atom or a C₁₋₆ alkyl group which may have a substituent, and m is an integer of 1 to 5.

5. The switching element according to Claim 1, wherein the compound is an imine type compound of the following formula (D): 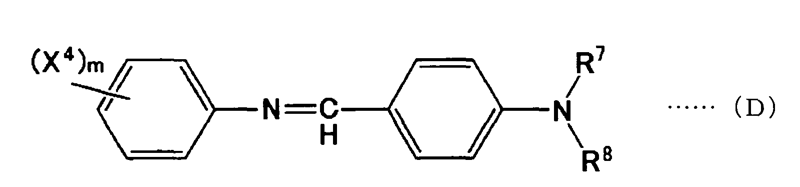 wherein X⁴ is CN or NO₂, each of R⁷ and R⁸ is a hydrogen atom or a C₁₋₆ alkyl group which may have a substituent, and m is an integer of 1 to 5.

6. The switching element according to Claim 1, wherein the compound is a compound of the following formula (E): 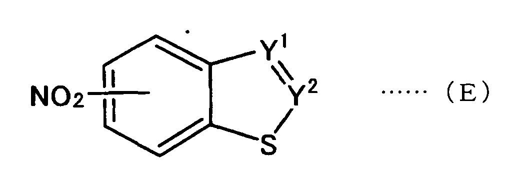 wherein either one of Y¹ and Y² is a nitrogen atom, and another one thereof is a carbon atom which has as a substituent an amino group or a C₁₋₆ alkylamino group.

7. The switching element according to Claim 1, wherein the compound is a compound of the following formula (F): 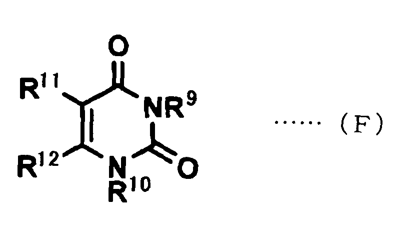 wherein each of R⁹ and R¹⁰ is a hydrogen atom or an alkyl group having at most 2 carbon atoms, and each of R¹¹ and R¹² is a hydrogen atom or an amino group.

8. The switching element according to Claim 1, wherein the compound is a compound of the following formula (G): 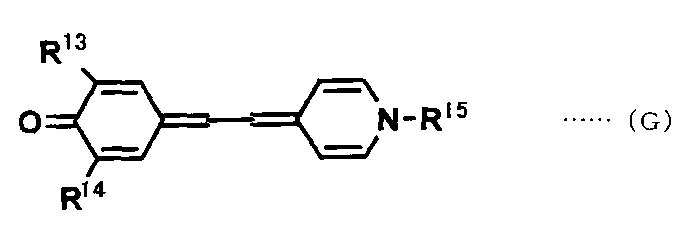 wherein each of R¹³, R¹⁴ and R¹⁵ is a hydrogen atom or a C₁₋₆ alkyl group which may have a substituent.

9. The switching element according to Claim 1, wherein the compound is an iminequinone type compound of the following formula (H): 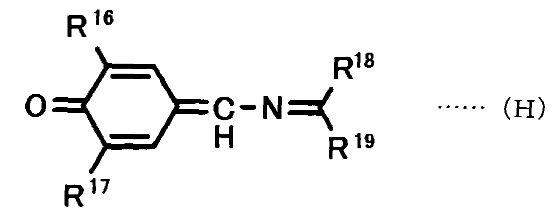 wherein each of R¹⁶ and R¹⁷ is a hydrogen atom or a C₁₋₆ alkyl group which may have a substituent, and each of R¹⁸ and R¹⁹ is an aryl group which may have a substituent, a C₁₋₆ alkyl group which may have a substituent, or a hydrogen atom, provided that at least one of R¹⁸ and R¹⁹ is an aryl group which may have a substituent.

10. The switching element according to Claim 1, wherein the compound is a quinoneimine compound of the following formula (I): 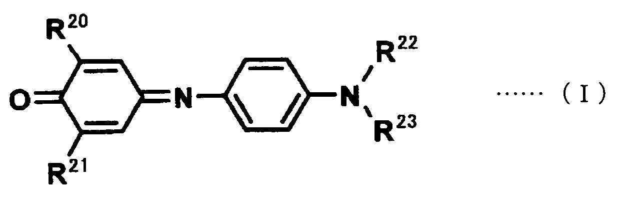 wherein each of R²⁰ to R²³ is a hydrogen atom or a C₁₋₆ alkyl group which may have a substituent.

11. The switching element according to Claim 1, wherein the compound is a dicyano type compound of the following formula (J): 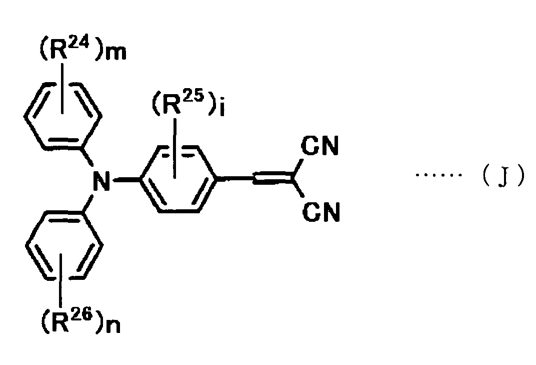 wherein each of R²⁴, R²⁵ and R²⁶ is a hydrogen atom, a C₁₋₆ alkyl group which may have a substituent, an aryl group which may have a substituent, a C₁₋₆ alkoxyl group which may have a substituent, each of m and n is an integer of 1 to 5, and i is an integer of 1 to 4.

12. The switching element according to Claim 1, wherein the compound is a pyridone type compound of the following formula (K): 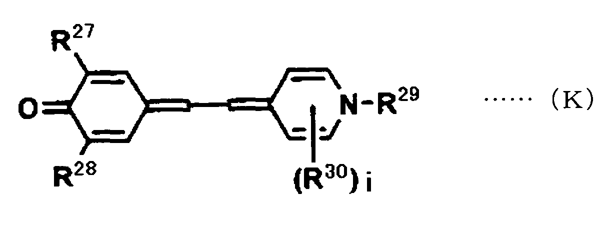 wherein each of R²⁷, R²⁸ and R²⁹ is a hydrogen atom, a C₁₋₆ alkyl group which may have a substituent, or an aryl group which may have a substituent, R³⁰ is a C₁₋₆ alkyl group which may have a substituent, or a residual group which is capable of forming a ring, and i is an integer of 1 to 4.

13. The switching element according to Claim 1, wherein the compound is a pyridone type compound of the following formula (L): 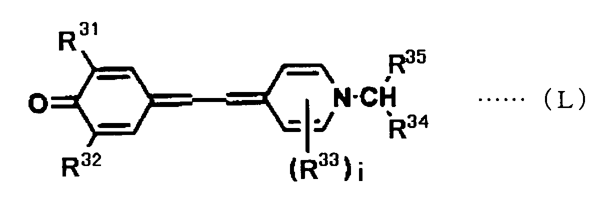 wherein each of R³¹ and R³² is a hydrogen atom or a C₁₋₆ alkyl group which may have a substituent, R³³ is a C₁₋₆ alkyl group which may have a substituent, or a residual group which is capable of forming a ring, each of R³⁴ and R³⁵ is an aryl group which may have a substituent, or a hydrogen atom, provided that at least one of R³⁴ and R³⁵ is an aryl group which may have a substituent, and i is an integer of 1 to 4.

14. The switching element according to Claim 1, wherein the compound is a quinoneimine type compound of the following formula (M): 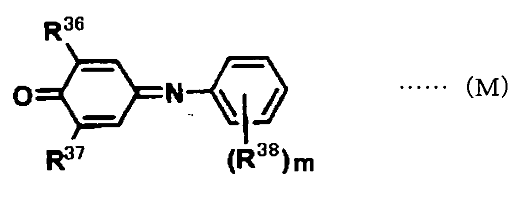 wherein each of R³⁶ and R³⁷ is a hydrogen atom, a C₁₋₆ alkyl group which may have a substituent, or an aryl group which may have a substituent, R³⁸ is a C₁₋₆ alkyl group which may have a substituent, an aryl group which may have a substituent, or a residual group which is capable of forming a ring, and m is an integer of 1 to 5.

15. The switching element according to Claim 1, wherein the compound is a quinoneimine type compound of the following formula (N): 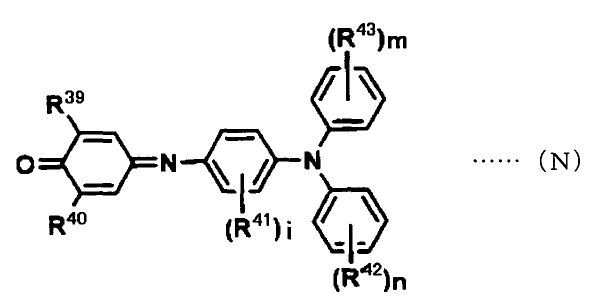 wherein each of R³⁹ and R⁴⁰ is a hydrogen atom or a C₁₋₆ alkyl group which may have a substituent; each of R⁴¹, R⁴² and R⁴³ is a hydrogen atom, a C₁₋₆ alkyl group which may have a substituent, an aryl group, or a residual group which is capable of forming a ring; i is an integer of 1 to 4; and each of m and n is an integer of 1 to 5.

16. The switching element according to Claim 1, wherein the compound is a stilbene type compound of the following formula (O): 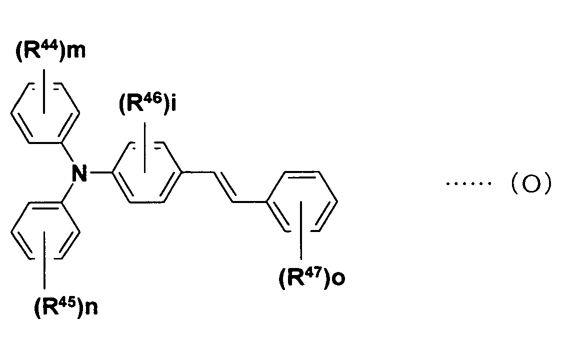 wherein each of R⁴⁴, R⁴⁵ and R⁴⁶ is a hydrogen atom, a C₁₋₆ alkyl group which may have a substituent, a C₁₋₆ alkoxyl group which may have a substituent, an amino group which may have a substituent, or an aryl group which may have a substituent; R⁴⁷ is a hydrogen atom, a halogen atom, a nitro group, a cyano group or an aryl group which may have a substituent; each of m, n and o is an integer of 1 to 5; and i is an integer of 1 to 4.

17. The switching element according to Claim 1, wherein the compound is a butadiene type compound of the following formula (P): 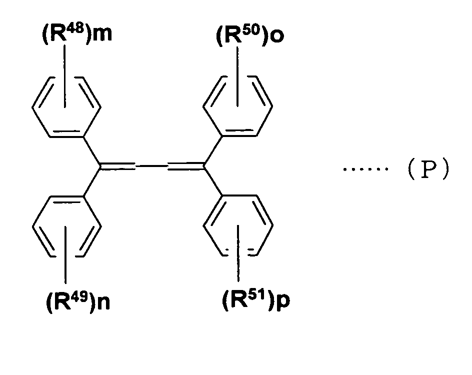 wherein each of R⁴⁸ and R⁴⁹ is a hydrogen atom, a halogen atom, a nitro group, a cyano group or an aryl group which may have a substituent; each of R⁵⁰ and R⁵¹ is a hydrogen atom, a C₁₋₆ alkyl group which may have a substituent, a C₁₋₆ alkoxyl group which may have a substituent, an amino group which may have a substituent, or an aryl group which may have a substituent; and each of m, n, o and p is an integer of 1 to 5.

18. The switching element according to Claim 1, wherein the compound is a stilbene type compound of the following formula (Q): 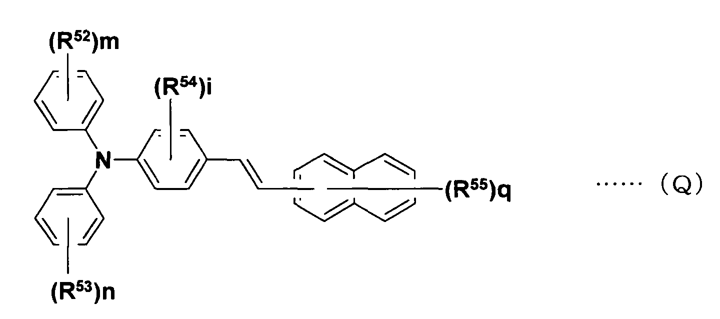 wherein each of R⁵², R⁵³, R⁵⁴ and R⁵⁵ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group forming a ring which may have a substituent; each of m and n is an integer of 1 to 5; i is an integer of 1 to 4; and q is an integer of 1 to 9.

19. The switching element according to Claim 1, wherein the compound is a triphenylamine type compound of the following formula (R): 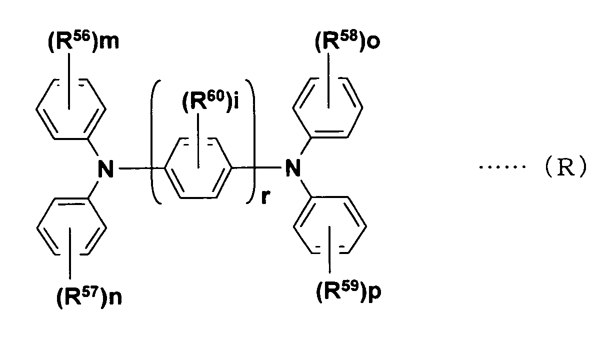 wherein each of R⁵⁶, R⁵⁷, R⁵⁸, R⁵⁹ and R⁶⁰ is a hydrogen atom, a halogen atom, a nitro group, a cyano group, a C₁₋₆ alkyl group which may have a substituent, a C₁₋₆ alkoxyl group which may have a substituent, an aryl group which may have a substituent, or a residual group which is capable of forming a ring; each of m, n, o and p is an integer of 1 to 5; i is an integer of 1 to 4; and r is an integer of 1 to 2.
